# EUROPEAN PATENT APPLICATION

(11) **EP 4 852 677 A1**
(43) Date of publication of application: **09.12.2026**
(21) Application number: 24959051.4
(22) Date of filing: 31.10.2024
(51) Int. Cl.: H10K 59/12, H10K 59/126, H10K 59/131, H10K 59/121

(54) **DISPLAY SUBSTRATE AND MANUFACTURING METHOD THEREFOR, AND DISPLAY DEVICE**

(71) Applicant: BOE Technology Group Co., Ltd., Beijing 100015 (CN); Yunnan Invensight Optoelectronics Technology Co., Ltd., Kunming, Yunnan 650211 (CN); Beijing BOE Technology Development Co., Ltd., Daxing District Beijing 100176 (CN)
(72) Inventor: ZHU, Zhijian, Beijing 100176 (CN); HUANG, Yinhu, Beijing 100176 (CN); YANG, Shengji, Beijing 100176 (CN); BAI, Xiao, Beijing 100176 (CN); HUANG, Yue, Beijing 100176 (CN); ZHANG, Dacheng, Beijing 100176 (CN)
(74) Representative: Durán-Corretjer, S.L.P.
(86) International application number: PCT/CN2024/129128
(87) International publication number: WO 2026/091042

(57) **Abstract**

A display substrate and a manufacturing method therefor, and a display device. The display substrate comprises a plurality of sub-pixels; at least one sub-pixel comprises a pixel driving circuit; the pixel driving circuit at least comprises a first transistor (T1), a second transistor (T2), a third transistor (T3), a fourth transistor (T4), and a shielding electrode (60); a first electrode of the second transistor (T2) is coupled to a first power line (81), and a second electrode of the second transistor (T2) is coupled to a first electrode of the third transistor (T3); a first electrode of the fourth transistor (T4) is coupled to a second power line (82), and a second electrode of the fourth transistor (T4) is coupled to a second electrode of the third transistor (T3); the shielding electrode (60) is connected to the first power line (81), and the orthographic projection of the shielding electrode (60) on a plane of the display substrate at least partially overlaps with the orthographic projection of a gate electrode of the third transistor (T3) on the plane of the display substrate.

## Description

### Technical Field

The present disclosure relates to, but is not limited to, the field of display technology, and particularly to a display substrate and a manufacturing method therefor, and a display device.

### Background

A Micro Organic Light Emitting Diode (Micro OLED) is a micro display developed in recent years, and an Organic Light Emitting Diode (OLED) on silicon is one of them. The OLED on silicon not only enables addressing of pixels, but also allows for manufacturing of structures such as pixel driving circuits on a silicon-based base substrate, which is conducive to reducing system volume and realizing lightweight. The OLED on silicon has advantages of small size, high resolution, and high refresh rate, and is widely used in the field of virtual reality or augmented reality near-eye display.

### Summary

The following is a summary of subject matters described herein in detail. This summary is not intended to limit the protection scope of claims.

In one aspect, the present disclosure provides a display substrate including a plurality of sub-pixels forming a plurality of pixel rows and a plurality of pixel columns, at least one sub-pixel including a pixel driving circuit and the pixel driving circuit including at least a first transistor, a second transistor, a third transistor, and a fourth transistor, wherein a first electrode of the first transistor is coupled to a data signal line, a second electrode of the first transistor is coupled to a gate electrode of the third transistor, a first electrode of the second transistor is coupled to a first power supply line, a second electrode of the second transistor is coupled to a first electrode of the third transistor, a first electrode of the fourth transistor is coupled to a second power supply line, a second electrode of the fourth transistor is coupled to a second electrode of the third transistor, the first power supply line is configured to provide a first power supply signal to the pixel driving circuit, and the second power supply line is configured to provide a second power supply signal to the pixel driving circuit; the at least one sub-pixel further includes a shielding electrode connected with the first power supply line, an orthographic projection of the shielding electrode on a plane of the display substrate is at least partially overlapped with an orthographic projection of the gate electrode of the third transistor on the plane of the display substrate.

In an exemplary implementation, an overlapping area between the orthographic projection of the shielding electrode on the plane of the display substrate and the orthographic projection of the gate electrode of the third transistor on the plane of the display substrate defines a first area, the orthographic projection of the gate electrode of the third transistor on the plane of the display substrate defines a second area, and a ratio of the first area to the second area is greater than or equal to 0.8.

In an exemplary implementation, in a pixel row direction, there is a shielding spacing between two adjacent shielding electrodes, and the shielding spacing is less than twice a width of the first power supply line, or the shielding spacing is less than twice a width of the second power supply line.

In an exemplary implementation, the first transistor includes at least a first source region and a first drain region, the second transistor includes at least a second source region and a second drain region, the third transistor includes at least a third source region and a third drain region, and the fourth transistor includes at least a fourth source region and a fourth drain region; the first drain region is connected with the gate electrode of the third transistor through a first node electrode, the second drain region is connected with the third source region and is connected with a second node electrode through a via, and the third drain region is connected with the fourth drain region through a third node electrode; in a direction perpendicular to the display substrate, the display substrate includes a plurality of conductive layers, and the first node electrode, the second node electrode, the third node electrode, and the shielding electrode are disposed in a same conductive layer.

In an exemplary implementation, the at least one sub-pixel further includes a first power supply connection electrode, and the shielding electrode is connected with the first power supply line through the first power supply connection electrode; and the first power supply connection electrode is disposed between a first node electrode and a second node electrode in the pixel row direction.

In an exemplary implementation, the first power supply connection electrode includes at least a lateral electrode extending in the pixel row direction, and a first vertical electrode and a second vertical electrode extending in a pixel column direction, respectively disposed on two sides of the lateral electrode in the pixel column direction, wherein one terminal of the first vertical electrode is connected with the first power supply line, another terminal of the first vertical electrode is connected with the lateral electrode, one terminal of the second vertical electrode is connected with the shielding electrode, and another terminal of the second vertical electrode is connected with the lateral electrode; and the second vertical electrode is disposed between the first node electrode and the second node electrode in the pixel row direction.

In an exemplary implementation, the at least one sub-pixel further includes a second power supply connection electrode disposed in a same layer as the data signal line, the first power supply line is connected with the second power supply connection electrode through a via, and the second power supply connection electrode is connected with the first power supply connection electrode through a via; in the pixel row direction, a spacing between a second power supply connection electrode in a current sub-pixel and a data signal line in an adjacent sub-pixel is greater than or equal to a width of the data signal line.

In an exemplary implementation, the at least one sub-pixel further includes a data connection strip, wherein a first terminal of the data connection strip is connected with the data signal line, a second terminal of the data connection strip extends in a direction toward the second power supply connection electrode and then is connected with the first electrode of the second transistor; in the pixel row direction, a spacing between a second power supply connection electrode in a current sub-pixel and a data connection strip in the current sub-pixel is greater than or equal to a width of the data signal line.

In an exemplary implementation, in a direction perpendicular to the display substrate, the display substrate includes at least a first metal layer disposed on a silicon substrate, a second metal layer disposed on a side of the first metal layer away from the silicon substrate, and a third metal layer disposed on a side of the second metal layer away from the silicon substrate; the first node electrode, the second node electrode, the third node electrode, and the shielding electrode are disposed in the first metal layer, the first power supply connection electrode is disposed in the second metal layer, and the data signal line and the second power supply connection electrode are disposed in the third metal layer.

In an exemplary implementation, the second power supply line is disposed in the first metal layer, the second metal layer further includes second connection lines, wherein the second power supply line is in a shape of a straight line or a polyline extending in the pixel row direction and continuously disposed in the pixel row direction, the second connection lines are in a shape of a straight line or a polyline extending in a pixel column direction and discontinuously disposed in the pixel column direction, and the second connection lines are connected with the second power supply line to form a mesh-like interconnect structure for transmitting a second power supply signal.

In an exemplary implementation, the gate electrode of the fourth transistor is coupled to a third scan signal line, and the third scan signal line is in a shape of a straight line or a polyline extending in the pixel row direction; in the pixel column direction, the second connection lines are spaced apart by the third scan signal line.

In an exemplary implementation, the at least one sub-pixel further includes a power supply connection portion disposed on a same layer as the second power supply line, the power supply connection portion is in a shape of a strip extending in the pixel row direction, a first terminal of the power supply connection portion is connected with the second power supply line, and a second terminal of the power supply connection portion extends in a direction away from the second power supply line and then is connected with the second connection line through a via.

In an exemplary implementation, the pixel driving circuit further includes a first capacitor, the first capacitor includes at least a first plate and a second plate, an orthographic projection of the second plate on the plane of the display substrate is at least partially overlapped with an orthographic projection of the first plate on the plane of the display substrate, the first plate is connected with the first node electrode, and the second plate is connected with the second node electrode.

In an exemplary implementation, the at least one sub-pixel further includes a compensation electrode, the second plate is connected with the second node electrode through the compensation electrode, an orthographic projection of the compensation electrode on the plane of the display substrate is at least partially overlapped with the orthographic projection of the first plate on the plane of the display substrate, the compensation electrode and the first plate form a parasitic capacitor, and the parasitic capacitor is connected in parallel with the first capacitor.

In an exemplary implementation, an overlapping area between the orthographic projection of the compensation electrode on the plane of the display substrate and the orthographic projection of the first plate on the plane of the display substrate defines a third area, the orthographic projection of the first plate on the display substrate plane defines a fourth area, and a ratio of the third area to the fourth area is greater than or equal to 0.5.

In an exemplary implementation, the at least one sub-pixel further includes a second connection line and a thirteenth connection electrode disposed in a same layer as the compensation electrode, the second connection line is connected with the second power supply line and disposed between two adjacent compensation electrodes in a pixel row direction, and the thirteenth connection electrode is connected with the first node electrode through a via; there is a first distance between the compensation electrode and the second connection line, there is a second distance between the compensation electrode and the thirteenth connection electrode, the first distance is less than the second distance, the first distance is a dimension in the pixel row direction, and the second distance is a dimension in a pixel column direction.

In an exemplary implementation, the at least one sub-pixel further includes a sixteenth connection electrode disposed in the same layer as the compensation electrode, and the sixteenth connection electrode is connected with the third node electrode through a via; there is a third distance between the compensation electrode and the sixteenth connection electrode, the first distance is less than the third distance, and the third distance is a dimension in the pixel column direction.

In an exemplary implementation, the at least one sub-pixel further includes a first power supply connection electrode and a thirteenth connection electrode disposed in the same layer as the compensation electrode, the shielding electrode is connected with the first power supply line through the first power supply connection electrode, and the thirteenth connection electrode is connected with the first node electrode through a via; there is a fourth distance between the first power supply connection electrode and the thirteenth connection electrode, the second distance is greater than the fourth distance, and the fourth distance is a dimension in the pixel row direction.

In an exemplary implementation, the at least one sub-pixel further includes a first power supply connection electrode and an eleventh connection electrode disposed in the same layer as the compensation electrode, the shielding electrode is connected with the first power supply line through the first power supply connection electrode, and the eleventh connection electrode is configured to be connected with the data signal line; there is a fifth distance between the first power supply connection electrode and the second connection line, there is a sixth distance between the first power supply connection electrode and the eleventh connection electrode, the fifth distance is less than the sixth distance, and the fifth distance and the sixth distance are dimensions in the pixel row direction.

In an exemplary implementation, in a direction perpendicular to the display substrate, the display substrate includes at least a first metal layer disposed on a silicon substrate, a second metal layer disposed on a side of the first metal layer away from the silicon substrate, and a third metal layer disposed on a side of the second metal layer away from the silicon substrate; the first node electrode and the second node electrode are disposed in the first metal layer, the compensation electrode is disposed in the second metal layer, and the first plate is disposed in the third metal layer.

In an exemplary implementation, the gate electrode of the first transistor is coupled to a first scan signal line, and the first scan signal line and the first power supply line are in a shape of a straight line or a polyline extending in a pixel row direction; the first power supply line is disposed between two adjacent first scan signal lines in a pixel column direction.

In another aspect, a display device is further provided in the present disclosure, and the display device includes the display substrate described above.

In yet another aspect, the present disclosure further provides a manufacturing method for a display substrate, wherein the display substrate includes a plurality of sub-pixels forming a plurality of pixel rows and a plurality of pixel columns; the manufacturing method includes: forming a pixel driving circuit in at least one sub-pixel, wherein the pixel driving circuit includes at least a first transistor, a second transistor, a third transistor, and a fourth transistor, a first electrode of the first transistor is coupled to a data signal line, a second electrode of the first transistor is coupled to a gate electrode of the third transistor, a first electrode of the second transistor is coupled to a first power supply line, a second electrode of the second transistor is coupled to a first electrode of the third transistor, a first electrode of the fourth transistor is coupled to a second power supply line, a second electrode of the fourth transistor is coupled to a second electrode of the third transistor, the first power supply line is configured to provide a first power supply signal to the pixel driving circuit, and the second power supply line is configured to provide a second power supply signal to the pixel driving circuit; the at least one sub-pixel further includes a shielding electrode connected with the first power supply line, an orthographic projection of the shielding electrode on a plane of the display substrate is at least partially overlapped with an orthographic projection of the gate electrode of the third transistor on the plane of the display substrate.

After drawings and detailed description are read and understood, other aspects may be understood.

### Brief Description of Drawings

Accompanying drawings are used for providing further understanding of technical solutions of the present disclosure, constitute a portion of the specification, and are used for explaining the technical solutions of the present disclosure together with embodiments of the present disclosure, but do not constitute limitations on the technical solutions of the present disclosure. Shapes and sizes of various components in the drawings do not reflect actual scale, but are only intended to schematically illustrate contents of the present disclosure.
FIG. 1 is a schematic diagram of a structure of an OLED on silicon display device.
FIG. 2 is a schematic diagram of a planar structure of a display area in an OLED on silicon display device.
FIG. 3 is a schematic diagram of a sectional structure of a display area in an OLED on silicon display device.
FIG. 4 is an equivalent circuit diagram of a pixel driving circuit.
FIG. 5 is a drive timing diagram of the pixel driving circuit shown in FIG. 4.
FIG. 6 is a schematic diagram of a planar structure of a display substrate according to an exemplary embodiment of the present disclosure.
FIG. 7 is a schematic diagram after patterns of an N-well area, a P-well area, and an active area are formed according to an embodiment of the present disclosure.
FIGs. 8A and 8B are schematic diagrams after a pattern of a gate conductive layer is formed according to an embodiment of the present disclosure.
FIGs. 9A and 9B are schematic diagrams after a pattern of an N-type doped region is formed according to an embodiment of the present disclosure.
FIGs. 10A and 10B are schematic diagrams after a pattern of a P-type doped region is formed according to an embodiment of the present disclosure.
FIG. 11 is a schematic diagram after a pattern of a second insulation layer is formed according to an embodiment of the present disclosure.
FIGs. 12A and 12B are schematic diagrams after a pattern of a first conductive layer is formed according to an embodiment of the present disclosure.
FIG. 13 is a schematic diagram after a pattern of a third insulation layer is formed according to an embodiment of the present disclosure.
FIGs. 14A and 14B are schematic diagrams after a pattern of a second conductive layer is formed according to an embodiment of the present disclosure.
FIG. 15 is a schematic diagram after a pattern of a fourth insulation layer is formed according to an embodiment of the present disclosure.
FIGs. 16A and 16B are schematic diagrams after a pattern of a third conductive layer is formed according to an embodiment of the present disclosure.
FIGs. 17A and 17B are schematic diagrams after patterns of a fifth insulation layer and a fourth conductive layer are formed according to an embodiment of the present disclosure.
FIG. 18 is a schematic diagram after a pattern of a sixth insulation layer is formed according to an embodiment of the present disclosure.
FIGs. 19A and 19B are schematic diagrams illustrating the structure obtained after a pattern of a fifth conductive layer is formed according to an embodiment of the present disclosure.
FIGs. 20A and 20B are schematic diagrams after patterns of a seventh insulation layer and a sixth conductive layer are formed according to an embodiment of the present disclosure.
FIG. 21 is a schematic diagram after a pattern of an eighth insulation layer is formed according to an embodiment of the present disclosure.
FIGs. 22A and 22B are schematic diagrams after a pattern of a seventh conductive layer is formed according to an embodiment of the present disclosure.
FIG. 23 is a schematic diagram of structures of a first capacitor and a second capacitor according to an embodiment of the present disclosure.

Reference signs are described as follows.

| | | | | | |
|---|---|---|---|---|---|
| 10A- | N-type well area; | 10B- | P-type well area; | 11- | First active region; |
| 12- | Second active region; | 13- | Third active region; | 14- | Fourth active region; |
| 15- | First power supply region; | 16- | Second power supply region; | 20A- | N-type doped region; |
| 20B- | P-type doped region; | 21- | First gate electrode; | 22- | Second gate electrode; |
| 23- | Third gate electrode; | 24- | Fourth gate electrode; | 31- | First scan signal line; |
| 32- | Second scan signal line; | 33- | Third scan signal line; | 41- | First connection electrode; |
| 42- | Second connection electrode; | 43- | Third connection electrode; | 44- | Fourth connection electrode; |
| 45- | Fifth connection electrode; | 46- | Sixth connection electrode; | 47- | Seventh connection electrode; |
| 48- | Eighth connection electrode; | 49- | Ninth connection electrode; | 50- | Shielding electrode; |
| 51- | Eleventh connection electrode; | 52- | Twelfth connection electrode; | 53- | Thirteenth connection electrode; |
| 54- | Fourteenth connection electrode; | 55- | Fifteenth connection electrode; | 56- | Sixteenth connection electrode; |
| 61- | Twenty-first connection electrode; | 62- | Twenty-second connection electrode; | 63- | Twenty-third connection electrode; |
| 64- | Twenty-fourth connection electrode; | 65- | Twenty-fifth connection electrode; | 70- | Data signal line; |
| 71- | Data connection strip; | 81- | First power supply line; | 82- | Second power supply line; |
| 83- | Anode connection electrode; | 92- | Second connection line; | 93- | Third connection line; |
| 94- | Fourth connection line; | 95- | Fifth connection line | 96- | Sixth connection line; |
| 97- | Seventh connection line; | 101- | Silicon substrate; | 102- | Drive circuit layer; |
| 103- | Light emitting structure layer; | 104- | First encapsulation layer; | 105- | Color film structure layer; |
| 106- | Second encapsulation layer; | 107- | Cover plate layer; | 110- | First plate; |
| 120- | Second plate; | 130- | Third plate; | 140- | Fourth plate; |
| 201- | First insulation layer; | 202- | Second insulation layer; | 203- | Third insulation layer; |
| 204- | Fourth insulation layer; | 205- | Fifth insulation layer; | 206- | Sixth insulation layer; |
| 207- | Seventh insulation layer; | 208- | Eighth insulation layer. | | |

### Detailed Description

To make objectives, technical solutions, and advantages of the present disclosure clearer, the embodiments of the present disclosure will be described in detail below with reference to the accompanying drawings. It is to be noted that implementations may be implemented in multiple different forms. Those of ordinary skill in the art may easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

Scale of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display device and a quantity of sub-pixels in each pixel are not limited to quantities shown in the drawings. The drawings described in the present disclosure are schematic structural diagrams only, and an implementation of the present disclosure is not limited to shapes, numerical values, or the like shown in the drawings.

Ordinal numerals "first", "second", "third" and the like in the specification are set not to form limits in numbers but only to avoid confusion between constituent elements.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that involved apparatus or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, or a detachable connection, or an integral connection; it may be a mechanical connection or an electrical connection; it may be a direct connection, or an indirect connection through a middleware, or an internal communication between two elements. Those of ordinary skill in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, in order to distinguish two electrodes of the transistor except the gate electrode, one of the two electrodes is directly described as a first electrode and the other is directly described as a second electrode. Among them, the first electrode may be a drain electrode and the second electrode may be a source electrode, or the first electrode may be a source electrode and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, and other elements with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

In the specification, "disposed in a same layer" adopted refers to a structure formed by patterning two (or more than two) structures through a same patterning process, and their materials may be the same or different. For example, materials of precursors for forming multiple structures disposed in a same layer are the same, and materials finally formed may be the same or different.

A triangle, rectangle, trapezoid, pentagon, or hexagon, or the like in the specification is not strictly defined, and it may be an approximate triangle, rectangle, trapezoid, pentagon, or hexagon, or the like. There may be some small deformations caused by tolerance, and there may be a chamfer, an arc edge, deformation, etc.

In the present disclosure, "about" means that a boundary is not defined so strictly and numerical values within process and measurement error ranges are allowed.

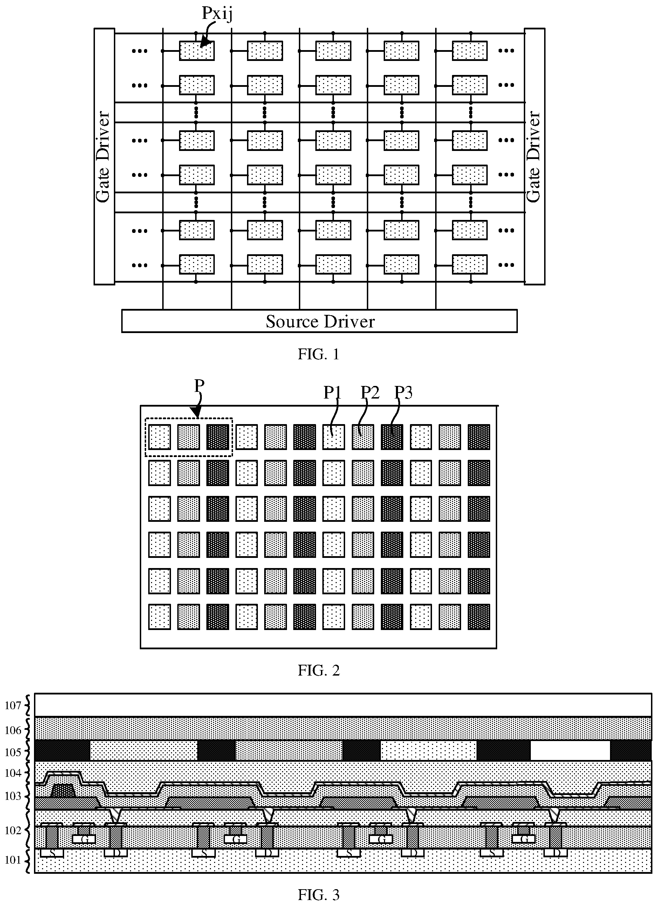

FIG. 1 is a schematic diagram of a structure of an OLED on silicon display device. As shown in FIG. 1, the OLED on silicon display device may include a display area and a non-display area. The display area may include a plurality of scan signal lines, a plurality of data signal lines, and a plurality of sub-pixels Pxij forming a plurality of pixel rows and a plurality of pixel columns, wherein the plurality of scan signal lines are respectively disposed in the plurality of pixel rows, and the plurality of data signal lines are respectively disposed in the plurality of pixel columns. Each sub-pixel Pxij may include, at least, a pixel driving circuit and a light emitting device, wherein the pixel driving circuit is configured to provide a current required for light emission to a light emitting device connected to the pixel driving circuit, a pixel driving circuit of each sub-pixel Pxij may be connected to a scan signal line of a corresponding pixel row and a data signal line of a corresponding pixel column, a sub-pixel Pxij may refer to a sub-pixel in an i-th pixel row and a j-th pixel column, a pixel driving circuit of the sub-pixel Pxij is connected with an i-th scan signal line and a j-th data signal line, respectively, and i and j may be natural numbers. The non-display area may include, at least, a gate driver (GD) and a source driver (SD). The gate driver is connected with a plurality of scan signal lines in the display area respectively, and is configured to provide a timing signal, which is needed by a pixel driving circuit connected to the gate driver, to the connected pixel driving circuit, to achieve a progressive scanning function. The source driver is connected with a plurality of data signal lines in the display area, respectively, and is configured to provide a data signal, which is needed by a pixel driving circuit connected to the gate driver, to the connected pixel driving circuit, to achieve switching and control of a displayed picture.

In an exemplary embodiment, the OLED on silicon display device may be of a single chip display architecture (One Chip) in which a gate driver, a source driver, a clock control circuit, an image processing unit, a storage unit, and the like are integrated on a same chip. A chip with the One Chip architecture includes digital and analog parts, and belongs to a mixed-signal chip.

In another exemplary embodiment, the OLED on silicon display device may be of a two-chip display architecture (Two Chip), a gate driver and a source driver are integrated in a display substrate, a clock control circuit, an image processing unit, a Mobile Industry Processor Interface (MIPI), and a storage unit are integrated in one chip, and such chip is bonded and connected with the display substrate via COC process.

FIG. 2 is a schematic diagram of a planar structure of a display area in an OLED on silicon display device. As shown in FIG. 2, on a plane parallel to the display device, the display area may include a plurality of pixel units P arranged in a matrix, at least one pixel unit P may include a first sub-pixel P1 emitting light of a first color, a second sub-pixel P2 emitting light of a second color, and a third sub-pixel P3 emitting light of a third color, each of the three sub-pixels may include a pixel driving circuit and a light emitting device. A pixel driving circuit in a sub-pixel is connected with a scan signal line and a data signal line, respectively, and the pixel driving circuit is configured to receive a data voltage transmitted by the data signal line and output a corresponding current to a display light emitting device under control of the scan signal line. A light emitting device in a sub-pixel is connected with a pixel driving circuit of the sub-pixel where the light emitting device is located, and is configured to emit light with corresponding brightness in response to a current output by the pixel driving circuit of the sub-pixel where the light emitting device is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light.

In an exemplary implementation, a sub-pixel may be in a shape of any one or more of a triangle, a square, a rectangle, a rhombus, a trapezoid, a parallelogram, a pentagon, a hexagon, and other polygons. The three sub-pixels may be arranged in a manner to stand side by side horizontally, in a manner to stand side by side vertically, or in a manner of a Chinese character " ", which is not limited here in the present disclosure. In some other possible implementations, a pixel unit may include four sub-pixels, which is not limited here in the present disclosure.

FIG. 3 is a schematic diagram of a sectional structure of a display area in an OLED on silicon display device, which illustrates a structure in which a manner of white light + color film is adopted to achieve full color. As shown in FIG. 3, in a direction perpendicular to the display device, the OLED on silicon display device may include a silicon substrate 101, a driving circuit layer 102 disposed on the silicon substrate 101, a light emitting structure layer 103 disposed at a side of the driving circuit layer 102 away from the silicon substrate 101, a first encapsulation layer 104 disposed at a side of the light emitting structure layer 103 away from the silicon substrate 101, a color filter structure layer 105 disposed at a side of the first encapsulation layer 104 away from the silicon substrate 101, a second encapsulation layer 106 disposed at a side of the color filter structure layer 105 away from the silicon substrate 101, and a cover plate layer 107 disposed at a side of the second encapsulation layer 106 away from the silicon substrate 101. In some possible implementations, the OLED on silicon display device may include another film layer, which is not limited here in the present disclosure.

In an exemplary implementation, the silicon substrate 101 may be a bulk silicon substrate or a Silicon-On-Insulator (SOI) substrate. The drive circuit layer 102 may be manufactured on the silicon substrate 101 through a silicon semiconductor process. The drive circuit layer 102 may include a plurality of circuit units, and a circuit unit may include, at least, a pixel driving circuit connected to a scan signal line and a data signal line, respectively. The pixel driving circuit may include a plurality of transistors and storage capacitors. A transistor may include a gate electrode G, a source electrode S, and a drain electrode D, which may be connected respectively to corresponding connection electrodes through vias filled with tungsten metal (i.e., tungsten vias, W-vias), and the transistor may be connected with other electrical structures (e.g., traces) through the connection electrodes.

In an exemplary implementation, the light emitting structure layer 103 may include a plurality of light emitting devices. A light emitting device may at least include an anode, an organic light emitting layer, and a cathode. The anode may be connected to the drain electrode D of the transistor through a connection electrode, the organic light emitting layer is connected to the anode, the cathode is connected to the organic light emitting layer, and the cathode is connected to a second power supply line. The organic light emitting layer emits light under drive of the anode and the cathode. In an exemplary implementation, the organic light emitting layer may include an Emitting Layer (EML) and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, for a light emitting device emitting white light, organic light emitting layers of all sub-pixels may be connected together to form a common layer.

In an exemplary implementation, for the first encapsulation layer 104 and the second encapsulation layer 106, a Thin Film Encapsulation (TFE) mode may be adopted, which may ensure that external water vapor cannot enter the light emitting structure layer. The color filter structure layer 105 may include, at least, red filter units, blue filter units, and green filter units, wherein a red filter unit is disposed at a red sub-pixel to filter white light emitted from a light emitting device into red light, a blue filter unit is disposed at a blue sub-pixel to filter white light emitted from the light emitting device into blue light, and a green filter unit is disposed at a green sub-pixel to filter white light emitted from the light emitting device into green light. The cover plate layer 107 may be made of glass, or made of plastic colorless polyimide with flexible properties, or the like.

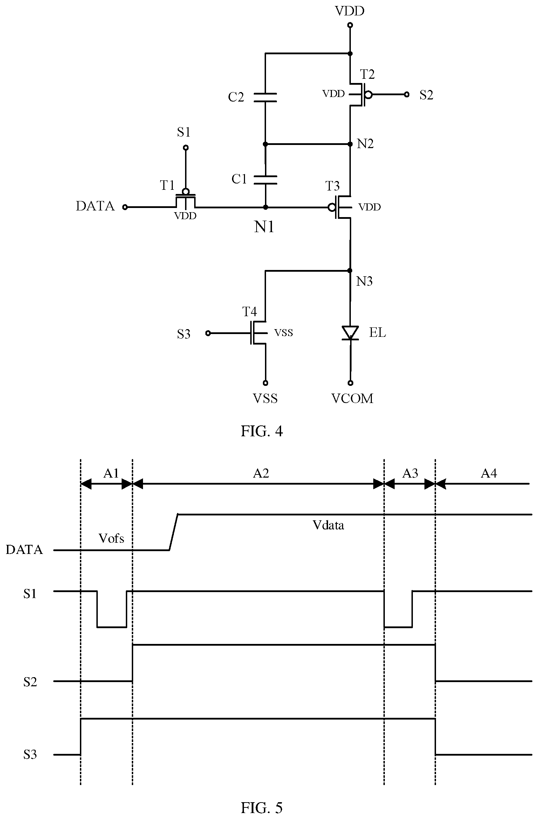

FIG. 4 is an equivalent circuit diagram of a pixel driving circuit. As shown in FIG. 4, the pixel driving circuit is of a current-type 4T2C structure, and may include four transistors (a first transistor T1, a second transistor T2, a third transistor T3, and a fourth transistor T4) and two storage capacitors (a first capacitor C1 and a second capacitor C2). The pixel driving circuit is coupled to six signal lines (a first scan signal line S1, a second scan signal line S2, a third scan signal line S3, a data signal line DATA, a first power supply line VDD, and a second power supply line VSS).

In an exemplary implementation, the pixel driving circuit may include a first node N1, a second node N2, and a third node N3. The first node N1 is coupled to a second electrode of the first transistor T1, a gate electrode of the third transistor T3, and a first terminal of the first capacitor C1, respectively. The second node N2 is coupled to a second electrode of the second transistor T2, a first electrode of the third transistor T3, a second terminal of the first capacitor C1, and a second terminal of the second capacitor C2, respectively. The third node N3 is coupled to a second electrode of the third transistor T3 and a second electrode of the fourth transistor T4, respectively.

In an exemplary implementation, a signal of the first scan signal line S1 may be a Write Switch (WS) signal, and the first scan signal line S1 may also be referred to as a Write Switch signal line WS. A signal of the second scan signal line S2 may be a Display Switch (DS) signal, and the second scan signal line S2 may also be referred to as a Display Switch signal line DS. A signal of the third scan signal line S3 may be an Auto Zero (AZ) signal, and the third scan signal line S3 may also be referred to as a display reset signal line AZ.

In an exemplary implementation, the first transistor T1 may be referred to as a source driver transistor or a data write transistor, wherein a gate electrode of the first transistor T1 is coupled to the first scan signal line S1, a first electrode of the first transistor T1 is coupled to the data signal line DATA, and a second electrode of the first transistor T1 is coupled to the first node N1.

In an exemplary implementation, the second transistor T2 may be referred to as a threshold voltage (Vth) compensation transistor, wherein a gate electrode of the second transistor T2 is coupled to the second scan signal line S2, a first electrode of the second transistor T2 is respectively coupled to the first power supply line VDD and a first terminal of the second capacitor C2, and a second electrode of the second transistor T2 is coupled to the second node N2.

In an exemplary implementation, the third transistor T3 may be referred to as a driver transistor, wherein a gate electrode of the third transistor T3 is coupled to the first node N1, a first electrode of the third transistor T3 is coupled to the second node N2, and a second electrode of the third transistor T3 is coupled to the third node N3.

In an exemplary implementation, the fourth transistor T4 may be referred to as a reset (Auto Zero) transistor, wherein a gate electrode of the fourth transistor T4 is coupled to the third scan signal line S3, a first electrode of the fourth transistor T4 is coupled to the second power supply line VSS, and a second electrode of the fourth transistor T4 is coupled to the third node N3.

In an exemplary implementation, a first terminal of the first capacitor C1 is coupled to the first node N1, and a second terminal of the first capacitor C1 is coupled to the second node N2. A first terminal of the second capacitor C2 is coupled to the first power supply terminal VDD, and a second terminal of the second capacitor C2 is coupled to the second control node N2.

In an exemplary implementation, a light emitting device EL may be an Organic Light Emitting Diode (OLED) including a first electrode (anode), an organic light emitting layer, and a second electrode (cathode) that are stacked. A first electrode of the light emitting device EL is connected with the third node N3, and a second electrode of the light emitting device EL is connected with a common voltage line VCOM.

In an exemplary implementation, a signal of the first power supply line VDD may be a first power supply signal (high-level signal) that is continuously provided, a signal of the second power supply line VSS may be a second power supply signal (low-level signal) that is continuously provided, a voltage of the first power supply signal is greater than a voltage of the second power supply signal, and a signal of the common voltage line VCOM may be a low-level signal that is continuously provided.

In an exemplary implementation, the first transistor T1 to the third transistor T3 may be P-type transistors, and the fourth transistor T4 may be an N-type transistor.

FIG. 5 is a drive timing diagram of the pixel driving circuit shown in FIG. 4. In an exemplary implementation, a working process of the pixel driving circuit may include following stages.

A first stage A1 may be referred to as a first reset stage. Signals of the first scan signal line S1 and the second scan signal line S2 are low-level signals, and a signal of the third scan signal line S3 is a high-level signal, so that the first transistor T1, the second transistor T2, and the fourth transistor T4 are turned on. The first transistor T1 is turned on, so that a bias voltage Vofs output by the data signal line DATA is written into the first capacitor C1, and a potential Vg of the first node N1 (i.e. the gate electrode of the third transistor T3) is equal to Vofs. The second transistor T2 is turned on, so that a first power supply voltage ELVDD output by the first power supply line VDD is written into the second node N2, a potential Vs of the second node N2 (i.e. the first electrode of the third transistor T3) is equal to ELVDD, and a potential Vd of the third node N3 (i.e. the second electrode of the third transistor T3) is equal to Vg+Vth. At this time, a gate-source voltage Vgs of the third transistor T3 is equal to Vcs=ELVDD-Vofs, and Vcs is a storage voltage of the first capacitor C1. Make ELVDD-Vofs>|Vth| in preparation for a next stage of discharge, wherein Vth is a threshold voltage of the third transistor T3.

A second stage A2 may be referred to as a self-discharge stage or a threshold read stage. A signal of the third scan signal line S3 is a high-level signal, and the fourth transistor T4 is continuously turned on. A signal of the first scan signal line S1 changes from a low-level signal to a high-level signal, so that the first transistor T1 is turned off first, and the first node N1 is floating. Subsequently, a signal of the second scan signal line S2 changes from a low-level signal to a high-level signal, so that the second transistor T2 is turned off, the second node N2 forms a loop through the turned-on third transistor T3, the third node N3, and the turned-on fourth transistor T4, and starts to discharge, and a potential at the second node N2 decreases. Since the first node N1 is floating, a voltage difference between two terminals of the first capacitor C1 does not change, and thus the potential at the first node N1 decreases as the potential at the second node N2 decreases. Due to a back gate effect of the third transistor T3, an equivalent threshold voltage |Vth_EF| of the third transistor T3 is equal to α(ELVDD-Vs)+|Vth|. As the potential Vs of the second node N2 decreases, the equivalent threshold voltage |Vth_EF| of the third transistor T3 gradually increases, and when the equivalent threshold voltage |Vth_EF| of the third transistor T3 increases to the gate-source voltage Vgs of the third transistor T3, the third transistor T3 is turned off, and the second node N2 stops discharging.

A third stage A3 is referred to as a data write stage or a threshold compensation stage. A signal of the third scan signal line S3 is a high-level signal, and the fourth transistor T4 is continuously turned on. A signal of the second scan signal line S2 is a high-level signal, and the second transistor T2 is continuously turned off. A signal of the first scan signal line S1 changes from a high-level signal to a low-level signal, so that the first transistor T1 is turned on. The first transistor T1 is turned on, so that a data voltage Vdata output by the data signal line DATA is written into the first node N1, and the potential at the first node N1 changes from Vofs to Vdata. Since the second node N2 is floating, threshold compensation can be achieved.

A fourth stage A4 may be referred to as a light emitting stage. Signals of the second scan signal line S2 and the third scan signal line S3 are low-level signals, and a signal of the first scan signal line S1 is a high-level signal, so that the second transistor T2 is turned on, and the first transistor T1 and the fourth transistor T4 are turned off. The second transistor T2 is turned on, so that a power supply voltage outputted by the first power supply line VDD provides a drive voltage to the first electrode of the light emitting device EL through the turned-on second transistor T2 and third transistor T3 to drive the light emitting device EL to emit light. In the light emitting stage, a drive current of the third transistor T3 is not affected by the threshold voltage of the third transistor T3, an influence of the threshold voltage of the third transistor T3 on the drive current is eliminated, uniformity of display brightness of display products is ensured, and a display effect of an entire display product is improved.

At present, OLED on silicon display devices are gradually applied in near-eye display fields such as Virtual Reality (VR), Augmented Reality (AR), Extended Reality (XR) devices, and Mixed Reality (MR) devices to enable users to experience real feelings in the virtual reality world, have a super strong simulation system, and implement human-computer interaction. Research has shown that when resolution of a screen is high enough, the human retina cannot distinguish between pixels. Resolution (Pixels Per Inch, PPI for short) refers to number of pixels per unit area, which may be called pixel density. The higher the PPI value, the higher the density of the display substrate to display the picture, and the richer the details of the picture. Therefore, in order to improve the display quality, improving the PPI greatly has become research emphasis of various manufacturers. The OLED on silicon is manufactured using semiconductor technology. With the improvement of PPI, spacing between signal lines is small. Due to process fluctuations or particles and other factors, short circuits will occur between different signal lines, resulting in defects such as horizontal lines, vertical lines or cross lines. In addition, with the improvement of PPI, spacing between capacitor plates and signal lines is small. When a short circuit between a signal line and a capacitor plate occurs, there will also be defects such as vertical lines.

An exemplary embodiment of the present disclosure provides a display substrate including a plurality of sub-pixels forming a plurality of pixel rows and a plurality of pixel columns, at least one sub-pixel including a pixel driving circuit and the pixel driving circuit including at least a first transistor, a second transistor, a third transistor, and a fourth transistor, wherein a first electrode of the first transistor is coupled to a data signal line, a second electrode of the first transistor is coupled to a gate electrode of the third transistor, a first electrode of the second transistor is coupled to a first power supply line, a second electrode of the second transistor is coupled to a first electrode of the third transistor, a first electrode of the fourth transistor is coupled to a second power supply line, a second electrode of the fourth transistor is coupled to a second electrode of the third transistor, the first power supply line is configured to provide a first power supply signal to the pixel driving circuit, and the second power supply line is configured to provide a second power supply signal to the pixel driving circuit; the at least one sub-pixel further includes a shielding electrode connected with the first power supply line, an orthographic projection of the shielding electrode on a plane of the display substrate is at least partially overlapped with an orthographic projection of the gate electrode of the third transistor on the plane of the display substrate.

In an exemplary implementation, the at least one sub-pixel further includes a first power supply connection electrode, and the shielding electrode is connected with the first power supply line through the first power supply connection electrode; and the first power supply connection electrode is disposed between a first node electrode and a second node electrode in the pixel row direction.

In an exemplary implementation, the pixel driving circuit further includes a first capacitor, the first capacitor includes at least a first plate and a second plate, an orthographic projection of the second plate on the plane of the display substrate is at least partially overlapped with an orthographic projection of the first plate on the plane of the display substrate, the first plate is connected with the first node electrode, and the second plate is connected with the second node electrode.

In an exemplary implementation, the at least one sub-pixel further includes a compensation electrode, the second plate is connected with the second node electrode through the compensation electrode, an orthographic projection of the compensation electrode on the plane of the display substrate is at least partially overlapped with the orthographic projection of the first plate on the plane of the display substrate, the compensation electrode and the first plate form a parasitic capacitor, and the parasitic capacitor is connected in parallel with the first capacitor.

Technical solutions of the display substrate according to the present disclosure will be described below through exemplary embodiments.

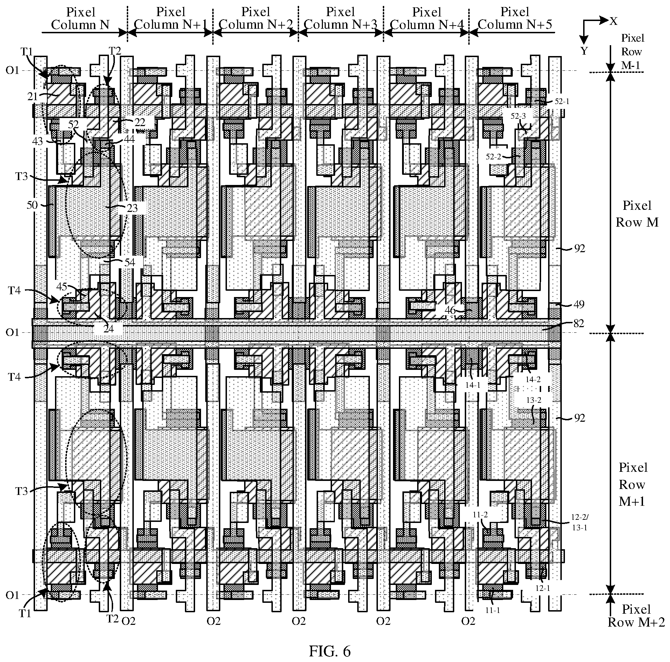

FIG. 6 is a schematic diagram of a planar structure of a display substrate according to an exemplary embodiment of the present disclosure, and schematically illustrates a pixel driving circuit structure of 12 sub-pixels in two pixel rows (an M-th pixel row and an (M+1)-th pixel row) and six pixel columns (an N-th pixel column to an (N+5)-th pixel column). On a plane parallel to the display substrate, the display substrate may include a plurality of sub-pixels forming a plurality of pixel rows and a plurality of pixel columns, a plurality of sub-pixels in a pixel row may be sequentially disposed in a first direction X (i.e., a pixel row direction), a plurality of sub-pixels in a pixel column may be sequentially disposed in a second direction Y (i.e., a pixel column direction), the plurality of pixel rows and the plurality of pixel columns constitute a pixel array arranged in an array, and the first direction X intersects the second direction Y.

In an exemplary implementation, at least one sub-pixel may include a pixel driving circuit, and at least one pixel driving circuit may include at least a first transistor T1 as a data write transistor, a second transistor T2 as a threshold voltage compensation transistor, a third transistor T3 as a drive transistor, and a fourth transistor T4 as a reset transistor. A gate electrode of the first transistor T1 is coupled to a first scan signal line, a first electrode of the first transistor T1 is coupled to a data signal line, and a second electrode of the first transistor T1 is coupled to a gate electrode of the third transistor T3. A gate electrode of the second transistor T2 is coupled to a second scan signal line, a first electrode of the second transistor T2 is coupled to a first power supply line, and a second electrode of the second transistor T2 is coupled to a first electrode of the third transistor T3. A gate electrode of the fourth transistor T4 is coupled to a third scan signal line, a first electrode of the fourth transistor T4 is coupled to a second power supply line, and a second electrode of the fourth transistor T4 is coupled to a second electrode of the third transistor T3. The first scan signal line, the second scan signal line, and the third scan signal line are configured to provide a first scan signal, a second scan signal, and a third scan signal to the pixel driving circuit, respectively. The data signal line is configured to provide a data signal to the pixel driving circuit. The first power supply line and the second power supply line are configured to provide a first power supply signal and a second power supply signal to the pixel driving circuit, respectively, and a voltage of the first power supply signal may be greater than a voltage of the second power supply signal.

In an exemplary implementation, the first scan signal line, the second scan signal line, the third scan signal line, the first power supply line and the second power supply line may be in a shape of a straight line or a polyline extending in the first direction X, and the data signal line may be in a shape of a straight line or a polyline extending in the second direction Y.

In an exemplary implementation, in the at least one sub-pixel, the second transistor T2 may be disposed on a side of the first transistor T1 in the first direction X, the first transistor T1 and the second transistor T2 may be disposed on a side of the third transistor T3 in the second direction Y, and the fourth transistor T4 may be disposed on the other side of the third transistor T3 in the second direction Y, that is, the second transistor T2 and the fourth transistor T4 may be respectively disposed on two sides of the third transistor T3 in the second direction Y. For example, in an M-th pixel row, the first transistor T1 and the second transistor T2 may be disposed on a side of the third transistor T3 in an opposite direction of the second direction Y, and the fourth transistor T4 may be disposed on the side of the third transistor T3 in the second direction Y. For another example, in an (M+1)-th pixel row, the first transistor T1 and the second transistor T2 may be disposed on the side of the third transistor T3 in the second direction Y, and the fourth transistor T4 may be disposed on the side of the third transistor T3 in the opposite direction of the second direction Y.

In an exemplary implementation, the first transistor T1 may include at least a first active region and a first gate electrode 21, and the first active region may include at least a first source region 11-1 and a first drain region 11-2 located on two sides of the first gate electrode 21 in the second direction Y. The second transistor T2 may include at least a second active region and a second gate electrode 22, and the second active region may include at least a second source region 12-1 and a second drain region 12-2 located on two sides of the second gate electrode 22 in the second direction Y. The third transistor T3 may include at least a third active region and a third gate electrode 23, and the third active region may include at least a third source region 13-1 and a third drain region 13-2 located on two sides of the third gate electrode 23 in the second direction Y. The fourth transistor T4 may include at least a fourth active region and a fourth gate electrode 24, and the fourth active region may include at least a fourth source region 14-1 and a fourth drain region 14-2 located on two sides of the fourth gate electrode 24 in the first direction X.

In an exemplary implementation, the at least one sub-pixel may further include a third connection electrode 43 as a first node electrode, a fourth connection electrode 44 as a second node electrode, and a fifth connection electrode 45 as a third node electrode. The first drain region 11-2 may be connected with the third gate electrode 23 through the third connection electrode 43, the second drain region 12-2 and the third source region 13-1 may be connected with each other and with the fourth connection electrode 44, and the third drain region 13-2 may be connected with the fourth drain region 14-2 through the fifth connection electrode 45. Among them, a first terminal of the third connection electrode 43 is connected with the first drain region 11-2 through a via, the first terminal of the third connection electrode 43 is connected with the third gate electrode 23 through a via, the fourth connection electrode 44 is connected with the second drain region 12-2 and the third source region 13-1 through a via, a first terminal of the fifth connection electrode 45 is connected with the third drain region 13-2 through a via, and a second terminal of the fifth connection electrode 45 is connected with the fourth drain region 14-2 through a via.

In an exemplary implementation, the at least one sub-pixel may further include a shielding electrode 50 connected with the first power supply line, and an orthographic projection of the shielding electrode 50 on the plane of the display substrate is at least partially overlapped with an orthographic projection of the third gate electrode (the gate electrode of the third transistor T3) 23 on the plane of the display substrate.

In an exemplary implementation, an overlapping area between the orthographic projection of the shielding electrode 50 on the plane of the display substrate and the orthographic projection of the third gate electrode 23 on the plane of the display substrate defines a first area, the orthographic projection of the third gate electrode 23 on the plane of the display substrate defines a second area, and a ratio of the first area to the second area may be greater than or equal to 0.8.

In an exemplary implementation, the display substrate may include a plurality of conductive layers in a direction perpendicular to the display substrate, and the third connection electrode 43, the fourth connection electrode 44, the fifth connection electrode 45, and the shielding electrode 50 may be disposed in a same conductive layer and synchronously formed by a same patterning process.

In an exemplary implementation, the at least one sub-pixel may further include a twelfth connection electrode 52 as a first power supply connection electrode, and the shielding electrode 50 may be connected with the first power supply line through the twelfth connection electrode 52. In the first direction X, at least a portion of the twelfth connection electrode 52 may be disposed between the third connection electrode 43 and the fourth connection electrode 44.

In an exemplary implementation, the twelfth connection electrode 52 may include at least a first vertical electrode 52-1, a second vertical electrode 52-2, and a lateral electrode 52-3, the first vertical electrode 52-1 and the second vertical electrode 52-2 may be in a shape of a strip extending in the second direction Y, and the lateral electrode 52-3 may be in a shape of a strip extending in the first direction X. In at least one sub-pixel, the first vertical electrode 52-1 and the second vertical electrode 52-2 may be disposed on two sides of the lateral electrode 52-3 in the second direction Y, respectively, one terminal of the first vertical electrode 52-1 is connected with the first power supply line, the other terminal is connected with the lateral electrode 52-3, and one terminal of the second vertical electrode 52-2 is connected with the shielding electrode 50, and the other terminal is connected with the lateral electrode 52-3. The second vertical electrode 52-2 may be disposed between the third connection electrode 43 and the fourth connection electrode 44 in the first direction X.

In an exemplary implementation, the fifth connection electrode 45 may include a first sub-electrode 45-1, a second sub-electrode 45-2, and a third sub-electrode 45-3 connected sequentially, the second sub-electrode 45-2 may be disposed on a side of the first sub-electrode 45-1 away from the third gate electrode 23, and the third sub-electrode 45-3 may be disposed on a side of the second sub-electrode 45-2 away from the third gate electrode 23. The first sub-electrode 45-1 and the third sub-electrode 45-3 may be in a shape of a strip extending in the first direction X, the second sub-electrode 45-2 may be in a shape of a strip extending in the second direction Y, both terminals of the second sub-electrode 45-2 are respectively connected with the first sub-electrode 45-1 and the third sub-electrode 45-3, the first sub-electrode 45-1 is connected with the third drain region 13-2 through a via, and the third sub-electrode 45-3 is connected with the fourth drain region 14-2 through a via.

In an exemplary implementation, the second power supply line 82 may be disposed on a side of the fourth transistor T4 away from the third transistor T3 and continuously disposed in the first direction X, and two adjacent pixel rows may share a same second power supply line 82.

In an exemplary implementation, the at least one sub-pixel may further include a second connection line 92, the second connection line 92 may be in a shape of a straight line or a polyline extending in the second direction Y, and is discontinuously disposed in the second direction Y, and the second power supply line 82 is connected with the second connection line 92 to form a mesh-like interconnect structure that transmits the second power supply signal.

In an exemplary implementation, in the second direction Y, second connection lines 92 are spaced apart by third scan signal lines.

In an exemplary implementation, the at least one sub-pixel may further include a sixth connection electrode 46 or a ninth connection electrode 49 as a power supply connection portion, the sixth connection electrode 46 and the ninth connection electrode 49 may be in a shape of a strip extending in the second direction Y, first terminals of the sixth connection electrode 46 and the ninth connection electrode 49 are connected with the second power supply line 82, and second terminals of the sixth connection electrode 46 and the ninth connection electrode 49 extend in a direction away from the second power supply line 82 and are connected with the second connection line 92 through vias.

In an exemplary implementation, the pixel driving circuit may further include a first capacitor including at least a first plate and a second plate, an orthographic projection of the second plate on the plane of the display substrate is at least partially overlapped with an orthographic projection of the first plate on the plane of the display substrate, the first plate is connected with the third connection electrode 43, and the second plate is connected with the fourth connection electrode 44.

In an exemplary implementation, the at least one sub-pixel further includes a fourteenth connection electrode 54 as a compensation electrode, and the second plate is connected with the fourth connection electrode 44 through the fourteenth connection electrode 54. An orthographic projection of the fourteenth connection electrode 54 on the plane of the display substrate is at least partially overlapped with the orthographic projection of the first plate on the plane of the display substrate, the fourteenth connection electrode 54 and the first plate form a parasitic capacitor, and the parasitic capacitor is connected in parallel with the first capacitor.

In an exemplary implementation, an overlapping area between the orthographic projection of the fourteenth connection electrode 54 on the plane of the display substrate and the orthographic projection of the first plate on the plane of the display substrate defines a third area, the orthographic projection of the first plate on the plane of the display substrate defines a fourth area, and a ratio of the third area to the fourth area may be greater than or equal to 0.5.

In an exemplary implementation, in a direction perpendicular to the display substrate, the display substrate may include at least a first metal layer (first conductive layer) disposed on the silicon substrate, a second metal layer (second conductive layer) disposed on a side of the first metal layer away from the silicon substrate, and a third metal layer (third conductive layer) disposed on a side of the second metal layer away from the silicon substrate. The third connection electrode 43, the fourth connection electrode 44, the fifth connection electrode 45, and the shielding electrode 50 may be disposed in the first metal layer, the twelfth connection electrode 52 and the fourteenth connection electrode 54 may be disposed in the second metal layer, and the first plate may be disposed in the third metal layer.

In an exemplary implementation, the second power supply line 82 may be disposed in the first metal layer, the second connection line 92 may be disposed in the second metal layer, and the data signal line may be disposed in the third metal layer.

In an exemplary implementation, the display substrate may at least include a first center line O1 and a second center line O2, wherein the first center line O1 may be a straight line located between adjacent pixel rows and extending in the first direction X, and the second center line O2 may be a straight line located between adjacent pixel columns and extending in the second direction Y.

In an exemplary implementation, pixel driving circuits in adjacent pixel rows may be substantially mirror-symmetrical with respect to the first center line O1.

In an exemplary implementation, positions and shapes of first transistors T1, second transistors T2, and third transistors T3 in adjacent pixel columns may be substantially the same, and fourth transistors T4 in adjacent pixel columns may be substantially mirror-symmetrical with respect to the second center line O2.

Exemplary description is made below through a manufacturing process of the display device.

A "patterning process" mentioned in the present disclosure includes film layer deposition, photoresist coating on a film layer, mask exposure, development, etching, photoresist stripping, and other treatments for a metal material, an inorganic material, or a transparent conductive material, and the patterning process includes organic material coating, mask exposure, development, and other treatments for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a substrate using deposition, coating, or other processes. If the "thin film" does not need to be processed through a patterning process in the entire preparation process, the "thin film" may also be called a "layer". If the "thin film" needs to be processed through the patterning process in the entire preparation process, the "thin film" is called a "thin film" before the patterning process is performed and is called a "layer" after the patterning process is performed. At least one "pattern" is contained in the "layer" which has been processed through the patterning process. "A and B being disposed in a same layer" mentioned in the present disclosure means that A and B are formed simultaneously through a same patterning process, and a "thickness" of a film layer is a dimension of the film layer in a direction perpendicular to the display device. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A overlaps with the boundary of the orthographic projection of B.

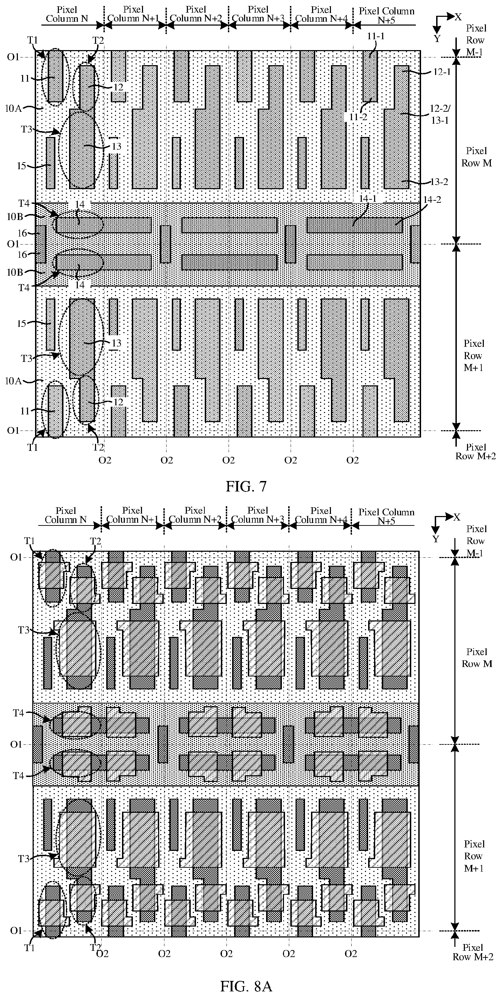

In an exemplary implementation, taking 12 sub-pixels in 2 pixel rows (an M-th pixel row and an (M+1)-th pixel row) and 6 pixel columns (an N-th pixel column to an (N+5)-th pixel column) as an example, the manufacturing process of the display substrate may include the following action.
(1) A pattern of an N-well area, a P-well area, and an active region are formed on the silicon substrate, as shown in FIG. 7.

In an exemplary implementation, the silicon substrate may be a P-type silicon substrate, and the P-type silicon substrate may serve as a channel region of an N-type transistor. In some possible implementations, the silicon substrate may be made of an N-type silicon material which may serve as a channel region of a P-type transistor, and the present disclosure is not limited thereto.

In an exemplary implementation, a photoresist pattern including an opening region may be formed by coating a photoresist on a P-type silicon substrate, exposure and development, and the photoresist within the opening region is removed to expose a surface of the P-type silicon substrate. N-type doped ions are implanted within the opening region by ion implantation, then remaining photoresist is peeled off, an N-type well (NW) area 10A is formed on the P-type silicon substrate, and a P-type well (PW) area 10B is formed in an area other than the N-type well area 10A. Subsequently, a pattern of an active region is formed on the silicon substrate on which the aforementioned pattern is formed.

In an exemplary implementation, the N-type well area 10A is configured to form a P-type transistor and a P-type device, and the P-type well (PW) area 10B (area other than the N-type well area 10A) is configured to form an N-type transistor and an N-type device.

In an exemplary implementation, plasma implants such as phosphorus or arsenic may be used for n-type doped ions, and a depth and doping concentration of ion implantation may be achieved by controlling the implantation energy and dose. A process of forming the N-type well area may further include a process such as annealing to allow the ion implant to diffuse in the P-type silicon substrate, to form a stable N-type well structure.

In an exemplary implementation, in at least one sub-pixel, the N-type well area 10A and the P-type well area 10B may be in a shape of a rectangle, and the N-type well area 10A and the P-type well area 10B may be sequentially disposed in the second direction Y. For example, among a plurality of sub-pixels in the M-th pixel row, P-type well areas 10B may be disposed on a side of N-type well areas 10A in the second direction Y. For another example, among a plurality of sub-pixels in the (M+1)-th pixel row, N-type well areas 10A may be disposed on a side of P-type well areas 10B in the second direction Y.

In an exemplary implementation, in one pixel row, N-type well areas 10A of a plurality of sub-pixels may be of an interconnected integral structure, and P-type well areas 10B of the plurality of sub-pixels may be of an interconnected integral structure.

In an exemplary implementation, N-type well areas 10A and P-type well areas 10B of adjacent pixel rows may be mirror-symmetrical with respect to the first center line O1. For example, N-type well areas 10A in the M-th pixel row and the (M+1)-th pixel row may be mirror-symmetrical with respect to the first center line O1. For another example, P-type well areas 10B in the M-th pixel row and the (M+1)-th pixel row may be mirror-symmetrical with respect to the first center line O1.

In an exemplary implementation, two N-type well areas 10A of some of adjacent pixel rows may be of an interconnected integral structure, and P-type well areas 10B of some of adjacent pixel rows may be of an interconnected integral structure. For example, two N-type well areas 10A in an (M-1)-th pixel row and the M-th pixel row may be of an interconnected integral structure, and two N-type well areas 10A in the (M+1)-th pixel row and an (M+2)-th pixel row may be of an interconnected integral structure. For another example, two P-type well areas 10B in the M-th pixel row and the (M+1)-th pixel row may be of an interconnected integral structure.

By disposing the N-type well areas 10A and the P-type well areas 10B of adjacent pixel rows to be mirror-symmetrical with respect to the first center line O1, first transistors T1, second transistors T2 and third transistors T3 in the adjacent pixel rows can share a same N-type well area 10A, and fourth transistors T4 in the adjacent pixel rows can share a same P-type well area 10B, so that a layout space used in the N-type well areas and the P-type well areas can be effectively reduced, the occupied area of the pixel driving circuit can be reduced, which is beneficial to achieving high resolution.

In an exemplary implementation, a pattern of an active area (AA) of each sub-pixel in the display substrate may at least include a first active region 11, a second active region 12, a third active region 13, and a fourth active region 14.

In an exemplary implementation, the first active region 11 may be in a shape of a strip extending in the second direction Y, and may be disposed within an area where the N-type well area 10A is located, and the first active region 11 may serve as an active region of the first transistor T1.

In an exemplary implementation, the second active region 12 may be in a shape of a strip extending in the second direction Y, and may be disposed within an area where the N-type well area 10A is located, and the second active region 12 may serve as an active region of the second transistor T2.

In an exemplary implementation, the third active region 13 may be in a shape of a strip extending in the second direction Y, and may be disposed within an area where the N-type well area 10A is located, and the third active region 13 may serve as an active region of the third transistor T3.

In an exemplary implementation, the fourth active region 14 may be in a shape of a strip extending in the first direction X, and may be disposed within an area where the P-type well area 10B is located, and the fourth active region 14 may serve as an active region of the fourth transistor T4.

In an exemplary implementation, in at least one sub-pixel, the first active region 11 may be disposed on a side of the third active region 13 in the opposite direction of the first direction, and the second active region 12 and the fourth active region 14 may be disposed on two sides of the third active region 13 in the second direction Y, respectively. For example, in the M-th pixel row, first active regions 11 and second active regions 12 may be disposed on two sides of third active regions 13 in the opposite direction of the second direction Y, and fourth active regions 14 may be disposed on a side of the third active regions 13 in the second direction Y. For another example, in the (M+1)-th pixel row, first active regions 11 and second active regions 12 may be disposed on one side of third active regions 13 in the second direction Y, and fourth active regions 14 may be disposed on a side of third active regions 13 in the opposite direction of the second direction Y.

In an exemplary implementation, the pattern of the active region may further include a first power supply region 15 and a second power supply region 16.

In an exemplary implementation, the first power supply region 15 may be in a shape of a strip extending in the second direction Y, and may be disposed within an area where the N-type well area 10A is located. In the first direction X, the first power supply region 15 is disposed on a side of the third active region 13 in the opposite direction of the first direction. In the second direction Y, an edge of the first power supply region 15 on a side close to the fourth active region 14 and an edge of the third active region 13 on a side close to the fourth active region 14 may be substantially flush. In an exemplary implementation, the first power supply region 15 is configured to be connected with a first power supply line formed subsequently.

In an exemplary implementation, second power supply regions 16 may be in a shape of a strip extending in the second direction Y, may be disposed within areas where the P-type well areas 10B are located, and may be disposed between some of adjacent pixel columns. For example, second power supply regions 16 may be disposed between an (N-1)-th pixel column and an N-th pixel column, between an (N+1)-th pixel column and an (N+2)-th pixel column, between an (N+3)-th pixel column and an (N+4)-th pixel column, and between an (N+5)-th pixel column and an (N+6)-th pixel column, respectively. In an exemplary implementation, the second power supply region 16 is configured to be connected with a second power supply line formed subsequently.

In an exemplary implementation, patterns of the active regions of adjacent pixel rows may be mirror-symmetrical with respect to the first center line O1. For example, the first active regions 11 to the fourth active regions 14, the first power supply regions 15, and the second power supply regions 16 in the (M-1)-th pixel row and the M-th pixel row may be mirror-symmetrical with respect to the first center line O1. For another example, the first active regions 11 to the fourth active regions 14, the first power supply regions 15, and the second power supply regions 16 in the M-th pixel row and the (M+1)-th pixel row may be mirror-symmetrical with respect to the first center line O1. For another example, the first active regions 11 to the fourth active regions 14, the first power supply regions 15, and the second power supply regions 16 in the (M+1)-th pixel row and the (M+2)-th pixel row may be mirror-symmetrical with respect to the first center line O1.

In an exemplary implementation, positions and shapes of the first active regions 11 to the second active regions 13, and the first power supply regions 15 of adjacent pixel columns may be substantially the same.

In an exemplary implementation, the fourth active regions 14 and the second power supply regions 16 of adjacent pixel columns may be mirror-symmetrical with respect to the second center line O2. For example, the fourth active regions 14 and the second power supply regions 16 in the N-th pixel column and the (N+1)-th pixel column may be mirror-symmetrical with respect to the second center line O2. For another example, the fourth active regions 14 and the second power supply regions 16 in the (N+1)-th pixel column and the (N+2)-th pixel column may be mirror-symmetrical with respect to the second center line O2.

In an exemplary implementation, an active region of each transistor may include a source region, a drain region, and a channel region located between the source region and the drain region.

In an exemplary implementation, in at least one sub-pixel, a first source region 11-1 of the first active region may be located on a side of a first channel region of the first active region away from the third active region 13, and a first drain region 11-2 of the first active region may be located on a side of the first channel region of the first active region close to the third active region 13. A second source region 12-1 of the second active region may be located on a side of a second channel region of the second active region away from the third active region 13, and a second drain region 12-2 of the second active region may be located on a side of the second channel region of the second active region close to the third active region 13. A third source region 13-1 of the third active region may be located on a side of a third channel region of the third active region close to the second active region 12, and a third drain region 13-2 of the third active region may be located on a side of the third channel region of the third active region away from the second active region 12. A fourth source region 14-1 of the fourth active region and a fourth drain region 14-2 of the fourth active region may be located on two sides of a fourth channel region of the fourth active region in the first direction X.

In an exemplary implementation, in at least one sub-pixel, the second drain region 12-2 of the second active region and the third source region 13-1 of the third active region may be connected to each other, and the second drain region 12-2 of the second active region may serve as the third source region 13-1 of the third active region.

In an exemplary implementation, in at least one sub-pixel, the second active region 12 and the third active region 13 may be of an interconnected integral structure.

In an exemplary implementation, in at least one pixel column, the first active regions 11 in adjacent sub-pixels may be of an interconnected integral structure, and the first active regions 11 of two sub-pixels may share a same first source region 11-1. For example, two sub-pixels in the (M-1)-th pixel row and the M-th pixel row may share a same first source region 11-1. For another example, two sub-pixels in the (M+1)-th pixel row and the (M+2)-th pixel row may share a same first source region 11-1. In the present disclosure, by disposing first transistors T1 of adjacent pixel rows to be mirrored and share a first electrode of the first transistor T1, the longitudinal wiring space can be effectively reduced, the quantity of vias can be reduced, and the occupied area of the pixel driving circuit can be reduced, which is beneficial to achieving high resolution.

In an exemplary implementation, in at least one pixel row, fourth active regions 14 in some of adjacent sub-pixels may be of an interconnected integral structure, and fourth active regions 14 of two sub-pixels may share a same fourth source region 14-1. For example, two sub-pixels in the N-th pixel column and the (N+1)-th pixel column may share a same fourth source region 14-1. For another example, two sub-pixels in the (N+2)-th pixel column and the (N+3)-th pixel column may share a same fourth source region 14-1. For another example, two sub-pixels in the (N+4)-th pixel column and the (N+5)-th pixel column may share a same fourth source region 14-1. In the present disclosure, by disposing fourth transistors T4 of some of adjacent pixel columns to be mirrored and share first electrodes of the fourth transistors T4, the lateral wiring space can be effectively reduced, the quantity of vias can be reduced, and the occupied area of the pixel driving circuit can be reduced, which is beneficial to achieving high resolution.

In an exemplary implementation, in at least one pixel column, second power supply regions 16 of adjacent sub-pixels may be of an interconnected integral structure. In the present disclosure, by disposing power supply regions 16 of adjacent pixel rows to be mirrored and be of an interconnected integral structure, the longitudinal wiring space can be effectively reduced, the quantity of vias can be reduced, and the occupied area of the pixel driving circuit can be reduced, which is beneficial to achieving high resolution.

In the exemplary implementation, since first active regions 11, second active regions 12, third active regions 13, and first power supply regions 15 in adjacent pixel rows are disposed to be mirrored, it is possible to dispose the first active regions 11, the second active regions 12, the third active regions 13, and the first power supply regions 15 in the adjacent pixel rows to share a same N-type well area 10A, that is, transistors of a same type share substrate area of a same type, which can effectively reduce the layout space used by the N-type well area, reduce the occupied area of the pixel driving circuit, which is beneficial to achieving high resolution.

In an exemplary implementation, since fourth active regions 14 and second power supply regions 16 in adjacent pixel rows are disposed to be mirrored, the fourth transistors T4 in the adjacent pixel rows can be configured to share a same P-type well area 10B, that is, transistors of a same type share a substrate area of a same type, which can effectively reduce the layout space used in the second substrate area, reduce the occupied area of the pixel driving circuit, which is beneficial to achieving high resolution.

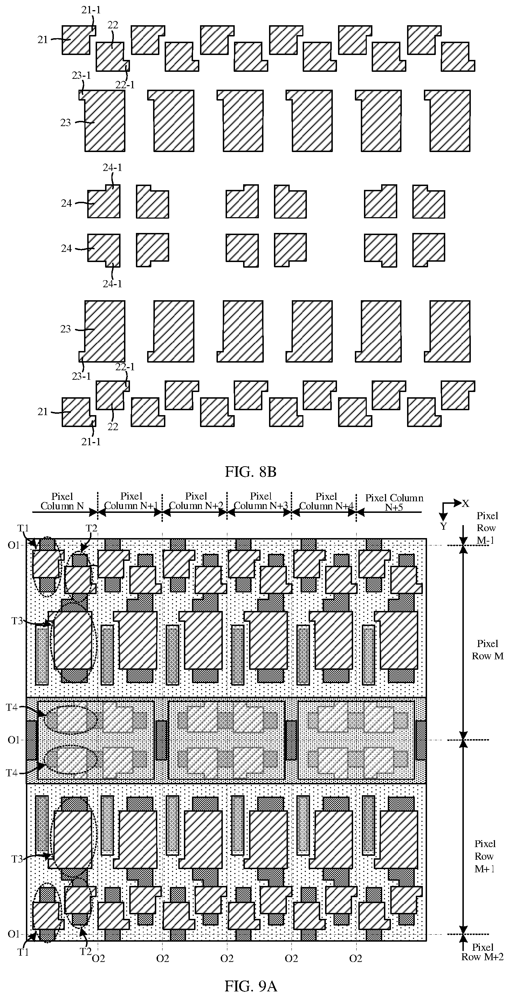

(2) A pattern of a gate conductive layer is formed. In an exemplary implementation, forming the pattern of the gate conductive layer may include: depositing a first insulation thin film and a polysilicon thin film sequentially on the silicon substrate on which the aforementioned pattern is formed, firstly patterning the polysilicon thin film through a patterning process to form a first insulation layer covering the pattern of the active region and a pattern of a polysilicon layer disposed on the first insulation layer, and then performing doping on the polysilicon layer to form the pattern of the gate conductive layer, as shown in FIGs. 8A and 8B, wherein FIG. 8B is a schematic diagram of the gate conductive layer in FIG. 8A.

In an exemplary implementation, a pattern of a gate conductive layer of each sub-pixel in the display substrate may at least include a first gate electrode 21, a second gate electrode 22, a third gate electrode 23, and a fourth gate electrode 24.

In an exemplary implementation, the first gate electrode 21 may be in a shape of a block (e.g., a rectangle), a chamfer or a groove may be disposed at a corner of the rectangle, an orthographic projection of the first gate electrode 21 on the silicon substrate is at least partially overlapped with an orthographic projection of the first active region on the silicon substrate, and the first gate electrode 21 may serve as a gate electrode of a first transistor T1.

In an exemplary implementation, a first gate connection block 21-1 may be disposed on the first gate electrode 21, and the first gate connection block 21-1 may be in a shape of a block (e.g., a rectangle). In the first direction X, the first gate connection block 21-1 may be disposed on a side of the first gate electrode 21 in the first direction X. In the second direction Y, edges of the first gate electrode 21 and the first gate connection block 21-1 on a side away from the third gate electrode 23 may be substantially flush.

In an exemplary implementation, in at least one sub-pixel, the first gate electrode 21 and the first gate connection block 21-1 may be of an interconnected integral structure.

In an exemplary implementation, the second gate electrode 22 may be in a shape of a block (e.g., a rectangle), an orthographic projection of the second gate electrode 22 on the silicon substrate is at least partially overlapped with an orthographic projection of a second active region on the silicon substrate, and the second gate electrode 22 may serve as a gate electrode of a second transistor T2.

In an exemplary implementation, a second gate connection block 22-1 may be disposed on the second gate electrode 22, and the second gate connection block 22-1 may be in a shape of a block (e.g., a rectangle). In the first direction X, the second gate connection block 22-1 may be disposed on a side of the second gate electrode 22 in the first direction X. In the second direction Y, edges of the second gate electrode 22 and the second gate connection block 22-1 on a side close to the second gate electrode 22 may be substantially flush.

In an exemplary implementation, in at least one sub-pixel, the second gate electrode 22 and the second gate connection block 22-1 may be of an interconnected integral structure.

In the exemplary implementation, the first gate connection block 21-1 is disposed at an upper position of the first gate electrode 21 and the second gate connection block 22-1 is disposed at a lower position of the second gate electrode 22, so that the occupied area of the pixel driving circuit can be effectively reduced by a staggered arrangement of gate connection blocks, which is beneficial to achieving high resolution.

In an exemplary implementation, the third gate electrode 23 may be in a shape of a block (e.g., a rectangle), an orthographic projection of the third gate electrode 23 on the silicon substrate is at least partially overlapped with an orthographic projection of a third active region on the silicon substrate, and the third gate electrode 23 may serve as a gate electrode of a third transistor T3.

In an exemplary implementation, a third gate connection block 23-1 may be disposed on the third gate electrode 23, and the third gate connection block 23-1 may be in a shape of a block (e.g., a rectangle). In the first direction X, the third gate connection block 23-1 may be disposed on a side of the third gate electrode 23 in the opposite direction of the first direction X. In the second direction Y, edges of the third gate electrode 23 and the third gate connection block 23-1 on a side close to the second gate electrode 22 may be substantially flush.

In an exemplary implementation, in at least one sub-pixel, the third gate electrode 23 and the third gate connection block 23-1 may be of an interconnected integral structure.

In an exemplary implementation, the fourth gate electrode 24 may be in a shape of a block (e.g., a rectangle), an orthographic projection of the fourth gate electrode 24 on the silicon substrate is at least partially overlapped with an orthographic projection of a fourth active region 14 on the silicon substrate, and the fourth gate electrode 24 may serve as a gate electrode of a fourth transistor T4.

In an exemplary implementation, a fourth gate connection block 24-1 may be disposed on the fourth gate electrode 24. The fourth gate connection block 24-1 may be in a shape of a block (e.g., a rectangle). In the first direction X, edges of the fourth gate electrode 24 and the fourth gate connection block 24-1 on a side in the first direction X may be substantially flush, or edges of the fourth gate electrode 24 and the fourth gate connection block 24-1 on a side in the opposite direction of the first direction X may be substantially flush.

In an exemplary implementation, patterns of gate conductive layers of adjacent pixel rows may be mirror-symmetrical with respect to a first center line O1. For example, first gate electrodes 21, second gate electrodes 22, third gate electrodes 23, and fourth gate electrodes 24 in the M-th pixel row and the (M+1)-th pixel row may be mirror-symmetrical with respect to a first center line O1.

In an exemplary implementation, positions and shapes of first gate electrodes 21, second gate electrodes 22, and third gate electrodes 23 of adjacent pixel columns may be substantially the same.

In an exemplary implementation, fourth gate electrodes 24 of adjacent pixel columns may be mirror-symmetrical with respect to a second center line O2. For example, fourth gate electrodes 24 in the N-th pixel column and the (N+1)-th pixel column may be mirror-symmetrical with respect to a second center line O2. For another example, fourth gate electrodes 24 in the (N+1)-th pixel column and the (N+2)-th pixel column may be mirror-symmetrical with respect to a second center line O2.

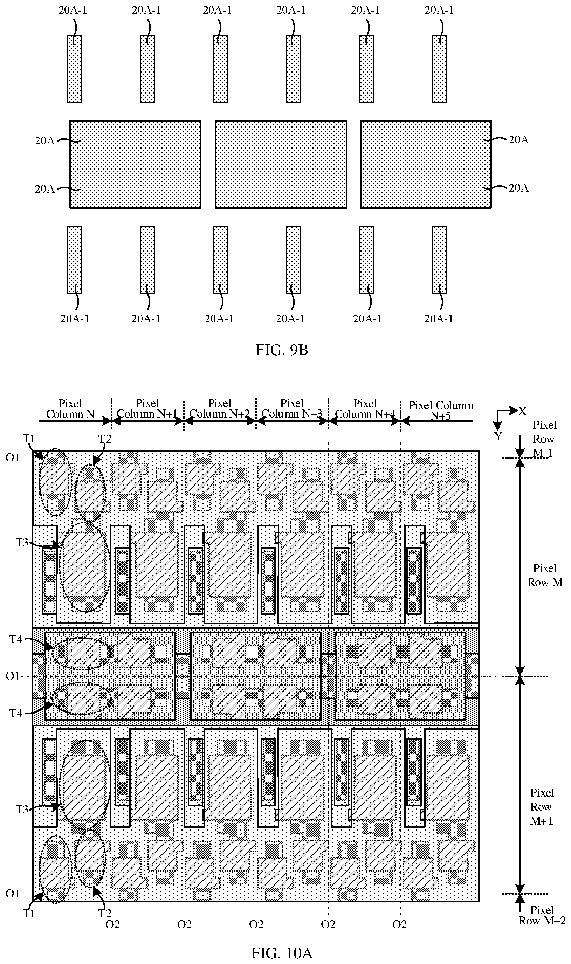

(3) A pattern of an N-type doped (SN) region is formed. In an exemplary implementation, forming the pattern of the N-type doped region may include: coating a photoresist on the silicon substrate on which the aforementioned patterns are formed, forming a plurality of opening regions through exposure and development, removing the photoresist within the plurality of opening regions, and forming an N-type doped region within an opening region through a doping process, as shown in FIGs. 9A and 9B, wherein FIG. 9B is a schematic diagram of the N-type doped region in FIG. 9A.

In an exemplary implementation, an N-type doped pattern of each sub-pixel in the display substrate may include an N-type doped region 20A and an N-type doped block 20A-1.

In an exemplary implementation, the N-type doped region 20A may be in a shape of a rectangle, and may be located in the area where the P-well area 10B is located, and an orthographic projection of the N-type doped region 20A on the silicon substrate may include an orthographic projection of a fourth active region on the silicon substrate, so that the fourth active region forms a fourth channel region, a fourth source region, and a fourth drain region.

In an exemplary implementation, the N-type doped block 20A-1 may be in a shape of a strip extending in the second direction Y, may be located in an area where the N-well area 10A is located, and an orthographic projection of the N-type doped block 20A-1 on the silicon substrate may include an orthographic projection of a first power supply region 15 on the silicon substrate, that is, the first power supply region 15 is N-type doped.

In an exemplary implementation, in one pixel row, N-type doped regions 20A of some of adjacent sub-pixels may be of an interconnected integral structure. For example, N-type doped regions 20A in the N-th pixel column and the (N+1)-th pixel column may be of an interconnected integral structure. For another example, N-type doped regions 20 A in the (N+1)-th pixel column and the (N+2)-th pixel column may be of an interconnected integral structure. For yet another example, N-type doped regions 20 A in the (N+2)-th pixel column and the (N+3)-th pixel column may be of an interconnected integral structure.

In an exemplary implementation, in one pixel column, N-type doped regions 20A of adjacent sub-pixels may be of an interconnected integral structure.

In an exemplary implementation, N-type doped regions 20A and N-type doped blocks 20A-1 of adjacent pixel rows may be mirror-symmetrical with respect to a first center line O1.

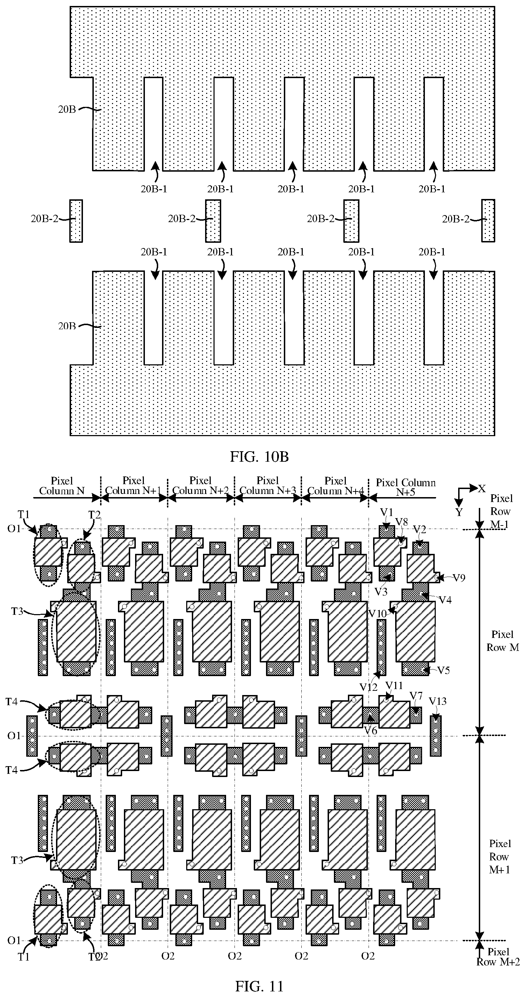

(4) A pattern of a P-type doped (SP) region is formed. In an exemplary implementation, forming the pattern of the P-type doped region may include: coating a photoresist on the silicon substrate on which the aforementioned patterns are formed, forming a plurality of opening regions through exposure and development, removing the photoresist within the plurality of opening regions, and forming a P-type doped region within an opening region through a doping process, as shown in FIGs. 10A and 10B, wherein FIG. 10B is a schematic diagram of the P-type doped region in FIG. 10A.

In an exemplary implementation, a P-type doped pattern of each sub-pixel in the display substrate may include a P-type doped region 20B and a P-type groove 20B-1.

In an exemplary implementation, in at least one sub-pixel, the P-type doped region 20B may be in a shape of a rectangle, may be located in the area where the N-well area 10A is located, and an orthographic projection of the P-type doped region 20B on the silicon substrate may include orthographic projections of the first active region to the third active region on the silicon substrate, such that the first active region forms a first channel region, a first source region, and a second drain region, the second active region forms a second channel region, a second source region, and a second drain region, and the third active region forms a third channel region, a third source region, and a third drain region.

In an exemplary implementation, the P-type groove 20B-1 may be in a shape of a strip extending in the second direction Y, may be disposed on a side of the P-type doped region 20B close to the N-type doped region 20A, and an orthographic projection of the P-type groove 20B-1 on the silicon substrate may include an orthographic projection of the N-type doped block 20A-1 on the silicon substrate.

In an exemplary implementation, the orthographic projection of the P-type groove 20B-1 on the silicon substrate may include an orthographic projection of a first power supply region 15 on the silicon substrate, i.e., the first power supply region 15 is not P-type doped.

In an exemplary implementation, in one pixel row, P-type doped regions 20B of a plurality of sub-pixels may be of an interconnected integral structure.

In an exemplary implementation, patterns of active regions of adjacent pixel rows may be mirror-symmetrical with respect to a first center line O1. For example, P-type doped regions 20B in the M-th pixel row and the (M+1)-th pixel row may be mirror-symmetrical with respect to a first center line O1.

In an exemplary implementation, the P-type doped pattern may further include a P-type doped block 20B-2. P-type doped blocks 20B-2 may be in a shape of a strip extending in the second direction Y, and may be disposed between some of adjacent pixel columns. For example, P-type doped blocks 20B-2 may be disposed between the (N-1)-th pixel column and the N-th pixel column, between the (N+1)-th pixel column and the (N+2)-th pixel column, between the (N+3)-th pixel column and the (N+4)-th pixel column, and between the (N+5)-th pixel column and the (N+6)-th pixel column, respectively.

In an exemplary implementation, an orthographic projection of the P-type doped block 20B-2 on the silicon substrate may include an orthographic projection of a second power supply region 16 on the silicon substrate, i.e., the second power supply region 16 is P-type doped.

In an exemplary implementation, P-type doped regions 20B, P-type grooves 20B-1, and P-type doped blocks 20B-2 of adjacent pixel rows may be mirror-symmetrical with respect to a first center line O1.

(5) A pattern of a second insulation layer is formed. In an exemplary implementation, forming the pattern of the second insulation layer may include: depositing a second insulation thin film on the silicon substrate on which the aforementioned patterns are formed, and patterning the second insulation thin film through a patterning process to form the second insulation layer covering the pattern of the gate conductive layer. wherein a plurality of vias are disposed in the second insulation layer, as shown in FIG. 11.

In an exemplary implementation, a plurality of vias in each sub-pixel in the display substrate may include at least: a first via V1, a second via V2, a third via V3, a fourth via V4, a fifth via V5, a sixth via V6, a seventh via V7, an eighth via V8, a ninth via V9, a tenth via V10, an eleventh via V11, and a twelfth via V12.

In an exemplary implementation, an orthographic projection of the first via V1 on the silicon substrate may be located within a range of an orthographic projection of a first source region of a first active region on the silicon substrate. The first insulation layer and the second insulation layer within the first via V1 are etched away to expose a surface of the first source region, and the first via V1 is configured such that a first connection electrode formed subsequently is connected with the first source region through this via.

In an exemplary implementation, the orthographic projection of the first via V1 on the silicon substrate is at least partially overlapped with an orthographic projection of a first center line O1 on the silicon substrate.

In an exemplary implementation, since first active regions of adjacent sub-pixels in one pixel column are of an interconnected integral structure, and two sub-pixels share a first source region, the adjacent sub-pixels in the one pixel column can share a same first via V1, which can effectively reduce a quantity of vias, and not only reduce the occupied area of the pixel driving circuit, which is beneficial to achieving high resolution, but also reduce process difficulty and improve yield.

In an exemplary implementation, an orthographic projection of the second via V2 on the silicon substrate may be located within a range of an orthographic projection of a second source region of a second active region on the silicon substrate. The first insulation layer and the second insulation layer within the second via V2 are etched away to expose a surface of the second source region, and the second via V2 is configured such that a second connection electrode formed subsequently is connected with the second source region through this via.

In an exemplary implementation, an orthographic projection of the third via V3 on the silicon substrate may be located within a range of an orthographic projection of a first drain region of a first active region on the silicon substrate. The first insulation layer and the second insulation layer within the third via V3 are etched away to expose a surface of the first drain region, and the third via V3 is configured such that a third connection electrode formed subsequently is connected with the first drain region through this via.

In an exemplary implementation, an orthographic projection of the fourth via V4 on the silicon substrate may be within a range of an orthographic projection of a second drain region of the second active region (also a third source region of a third active region) on the silicon substrate. The first insulation layer and the second insulation layer within the fourth via V4 are etched away to expose a surface of the second drain region (also the third source region), and the fourth via V4 is configured such that a fourth connection electrode 44 subsequently formed is connected with the second drain region (also the third source region) through this via.

In an exemplary implementation, an orthographic projection of the fifth via V5 on the silicon substrate may be located within a range of an orthographic projection of a third drain region of the third active region on the silicon substrate. The first insulation layer and the second insulation layer within the fifth via V5 are etched away to expose a surface of the third drain region, and the fifth via V5 is configured such that a fifth connection electrode formed subsequently is connected with the third drain region through this via. In an exemplary implementation, there may be a plurality of fifth vias V5 to reduce a contact resistance and improve connection reliability.

In an exemplary implementation, an orthographic projection of the sixth via V6 on the silicon substrate may be within a range of an orthographic projection of a fourth source region of a fourth active region on the silicon substrate. The first insulation layer and the second insulation layer within the sixth via V6 are etched away to expose a surface of the fourth source region, and the sixth via V6 is configured such that a sixth connection electrode formed subsequently is connected with the fourth source region through this via.

In an exemplary implementation, since fourth active regions of some of adjacent sub-pixels in one pixel row are of an interconnected integral structure, and two sub-pixels share a fourth source region, some of the adjacent sub-pixels in the one pixel column can share a same sixth via V6, which can effectively reduce the quantity of vias, not only can reduce the occupied area of the pixel driving circuit, which is beneficial to achieving high resolution, but also can reduce process difficulty and improve yield.

In an exemplary implementation, an orthographic projection of the seventh via V7 on the silicon substrate may be located within a range of an orthographic projection of a fourth drain region of the fourth active region on the silicon substrate. The first insulation layer and the second insulation layer within the seventh via V7 are etched away to expose a surface of the fourth drain region, and the seventh via V7 is configured such that a fifth connection electrode subsequently formed is connected with the fourth drain region through this via.

In an exemplary implementation, an orthographic projection of the eighth via V8 on the silicon substrate may be located within a range of an orthographic projection of the first gate connection block 21-1 of the first gate electrode 21 on the silicon substrate. The second insulation layer within the eighth via V8 is etched away to expose a surface of the first gate connection block 21-1, and the eighth via V8 is configured such that a seventh connection electrode subsequently formed is connected with the first gate connection block 21-1 through this via.

In an exemplary implementation, an orthographic projection of the ninth via V9 on the silicon substrate may be located within a range of an orthographic projection of the second gate connection block 22-1 of the second gate electrode 22 on the silicon substrate. The second insulation layer within the ninth via V9 is etched away to expose a surface of the second gate connection block 22-1, and the ninth via V9 is configured such that a second scan signal line subsequently formed is connected with the second gate connection block 22-1 through this via.

In an exemplary implementation, an orthographic projection of the tenth via V10 on the silicon substrate may be within a range of an orthographic projection of the third gate connection block 23-1 of the third gate electrode 23 on the silicon substrate. The second insulation layer within the tenth via V10 is etched away to expose a surface of the third gate connection block 23-1, and the tenth via V10 is configured such that a third connection electrode formed subsequently is connected with the third gate connection block 23-1 through this via.

In an exemplary implementation, an orthographic projection of the eleventh via V11 on the silicon substrate may be located within a range of an orthographic projection of the fourth gate connection block 24-1 of the fourth gate electrode 24 on the silicon substrate. The second insulation layer within the eleventh via V11 is etched away to expose a surface of the fourth gate connection block 24-1, and the eleventh via V11 is configured such that an eighth connection electrode formed subsequently is connected with the fourth gate connection block 24-1 through this via.

In an exemplary implementation, an orthographic projection of the twelfth via V12 on the silicon substrate is located within a range of an orthographic projection of the first power supply region 15 on the silicon substrate. The first insulation layer and the second insulation layer within the twelfth via V12 are etched away to expose a surface of the first power supply region 15, and the twelfth via V12 is configured such that a shielding electrode formed subsequently is connected with the first power supply region 15 through this via. In an exemplary implementation, there may be a plurality of twelfth vias V12 to reduce a contact resistance and improve connection reliability.

In an exemplary implementation, the second insulation layer may further include a thirteenth via V13. An orthographic projection of the thirteenth via V13 on the silicon substrate may be located within a range of an orthographic projection of the second power supply region 16 on the silicon substrate. The first insulation layer and the second insulation layer within the thirteenth via V13 are etched away to expose a surface of the second power supply region 16, and the thirteenth via V13 is configured such that a second power supply line formed subsequently is connected with the second power supply region 16 through this via. In an exemplary implementation, there may be a plurality of thirteenth vias V13 to reduce a contact resistance and improve connection reliability.

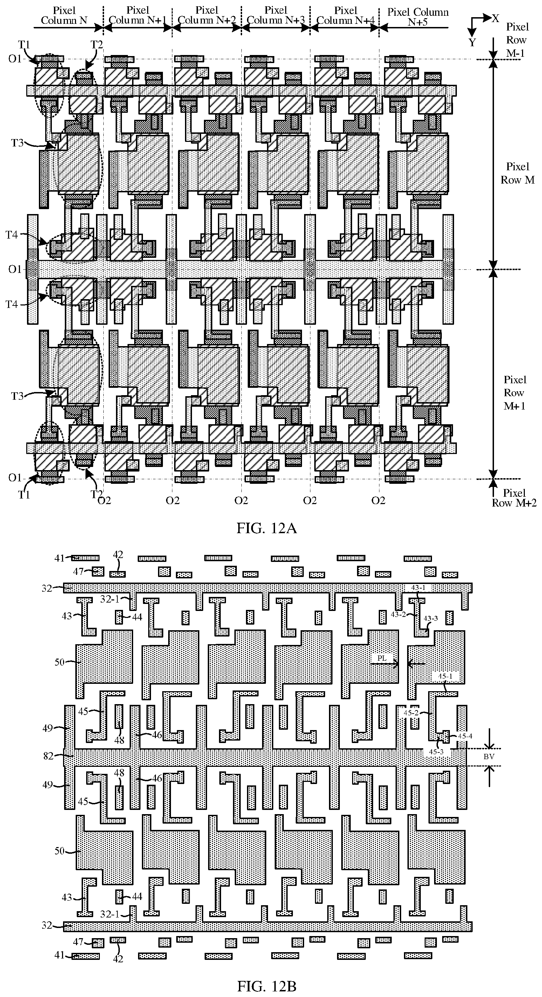

(6) A pattern of a first conductive layer is formed. In an exemplary implementation, forming the pattern of the first conductive layer may include: depositing a first conductive thin film on the silicon substrate on which the aforementioned patterns are formed, and patterning the first conductive thin film through a patterning process to form the pattern of the first conductive layer on the second insulation layer, as shown in FIGs. 12A and 12B, wherein FIG. 12B is a schematic diagram of the first conductive layer in FIG. 12A. In an exemplary implementation, the first conductive layer may be referred to as a first metal (Metal1) layer.

In an exemplary implementation, a pattern of a first conductive layer in each sub-pixel in the display substrate may include at least: a second scan signal line 32, a first connection electrode 41, a second connection electrode 42, a third connection electrode 43, a fourth connection electrode 44, a fifth connection electrode 45, a sixth connection electrode 46, a seventh connection electrode 47, an eighth connection electrode 48, a shielding electrode 50, and a second power supply line 82.

In an exemplary implementation, the second scan signal line 32 may be in a shape of a straight line in which a main body portion extends in the first direction X, and may be located on a side of the third gate electrode 23 away from the fourth gate electrode 24. A second scan connection block 32-1 may be disposed on the second scan signal line 32, and the second scan connection block 32-1 may be disposed in each sub-pixel. The second scan connection block 32-1 may be in a shape of a strip extending in the second direction Y. A first terminal of the second scan connection block 32-1 is connected with the second scan signal line 32, and a second terminal of the second scan connection block 32-1 extends in a direction toward the third gate electrode 23 and then is connected with the second gate connection block 22-1 through the ninth via V9. Since the second gate connection block 22-1 is connected with the second gate electrode 22, a connection between the second scan signal line 32 and a gate electrode of the second transistor T2 in each sub-pixel is achieved, and the second scan signal line 32 can control the turn-on or turn-off of the second transistor T2.

In an exemplary implementation, in at least one pixel row, a second scan signal line 32 and a plurality of second scan connection blocks 32-1 may be of an interconnected integral structure.

In an exemplary implementation, an orthographic projection of the second scan signal line 32 on the silicon substrate is at least partially overlapped with orthographic projections of the first gate electrode 21 and the second gate electrode 22 on the silicon substrate.

In an exemplary implementation, the second power supply line 82 may be in a shape of a straight line in which a main body portion extends in the first direction X, may be disposed on a side of the fourth transistor T4 away from the third transistor T3, and the second power supply line 82 may be connected with second power supply regions 16 through some of thirteenth vias V13, thereby realizing that the second power supply line 82 writes the second power supply signal to the second power supply regions 16. Since the second power supply regions 16 are located in the P-well areas 10B, it is realized that the second power supply line 82 writes the second power supply signal (negative voltage) into the P-well areas 10B, which can not only increase an anode dynamic range and improve a contrast ratio of the display device, but also provide a better signal isolation effect, reduce signal crosstalk and interference, and improve the stability and reliability of the circuit.

In an exemplary implementation, a second power supply line 82 may be located between two fourth gate electrodes 24 of adjacent pixel rows, an orthographic projection of the second power supply line 82 on the silicon substrate is at least partially overlapped with an orthographic projection of a first center line O1 on the silicon substrate, and two adjacent pixel rows may share a same second power supply line 82.

In an exemplary implementation, the first connection electrode 41 may be in a shape of a strip in which a main body portion extends in the first direction X, and may be located on a side of the second scan signal line 32 away from the third gate electrode 23. The first connection electrode 41 is connected with the first source region through the first via V1, and the first connection electrode 41 is configured to be connected with an eleventh connection electrode formed subsequently.

In an exemplary implementation, since adjacent sub-pixels in one pixel column share the first source region and the first via V1, the adjacent sub-pixels in the one pixel column can share a same first connection electrode 41, effectively reducing the quantity of connection electrodes, reducing the occupied area of the pixel driving circuit, which is beneficial to achieving high resolution.

In an exemplary implementation, in at least one sub-pixel, an orthographic projection of the first connection electrode 41 on the silicon substrate is at least partially overlapped with an orthographic projection of the first center line O1 on the silicon substrate.

In an exemplary implementation, the second connection electrode 42 may be in a shape of a strip extending in the first direction X, and may be disposed on a side of the second scan signal line 32 away from the third gate electrode 23. The second connection electrode 42 may be connected with the second source region through the second via V2, and the second connection electrode 42 is configured to be connected with the twelfth connection electrode formed subsequently.

In an exemplary implementation, the third connection electrode 43 may include a first connection strip 43-1, a second connection strip 43-2, and a third connection strip 43-3 connected sequentially. In the first direction X, center lines of the first connection strip 43-1 and the second connection strip 43-2 may be substantially overlapped with each other, the third connection strip 43-3 may be disposed on one side of the second connection strip 43-2 in the first direction X, a center line of the first connection strip 43-1 may be a straight line bisecting the first connection strip 43-1 in the first direction X and extending in the second direction Y, and a center line of the second connection strip 43-2 may be a straight line bisecting the second connection strip 43-2 in the first direction X and extending in the second direction Y. In the second direction Y, the second connection strip 43-2 may be disposed on a side of the third connection strip 43-3 away from the third gate electrode 23, and the first connection strip 43-1 may be disposed on a side of the second connection strip 43-2 away from the third gate electrode 23. The first connection strip 43-1 may be in a shape of a block (e.g., a rectangle), the second connection strip 43-2 may be in a shape of a strip extending in the second direction Y, and the third connection strip 43-3 may be in a shape of a strip extending in the first direction X. Both terminals of the second connection strip 43-2 are respectively connected with the first connection strip 43-1 and the third connection strip 43-3, the first connection strip 43-1 is connected with the first drain region through the third via V3, and the third connection strip 43-3 is connected with the third gate connection block 23-1 through the tenth via V10. Since the third gate connection block 23-1 is connected with the third gate electrode 23, the third connection electrode 43 realizes interconnection between the second electrode of the first transistor T1 and the gate electrode of the third transistor T3. In an exemplary implementation, the third connection electrode 43 may serve as a first node electrode in the present disclosure.

In an exemplary implementation, the fourth connection electrode 44 may be in a shape of a strip extending in the second direction Y, the fourth connection electrode 44 is connected with the second drain region (also the third source region) through the fourth via V4, and the fourth connection electrode 44 is configured to be connected with a fourteenth connection electrode formed subsequently. In an exemplary implementation, the fourth connection electrode 44 may serve as a second node electrode in the present disclosure.

In an exemplary implementation, the fifth connection electrode 45 may be in a shape of a polyline, a first terminal of the fifth connection electrode 45 is connected with the third drain region through the fifth via V5, and a second terminal of the fifth connection electrode 45 is connected with the fourth drain region through the seventh via V7. In an exemplary implementation, the fifth connection electrode 45 realizes a connection between a second electrode of the third transistor T3 and a second electrode of the fourth transistor T4, forming the third node N3 of the pixel driving circuit. In an exemplary implementation, the fifth connection electrode 45 may serve as a third node electrode in the present disclosure.

In an exemplary implementation, the fifth connection electrode 45 may include a first sub-electrode 45-1, a second sub-electrode 45-2, and a third sub-electrode 45-3 connected sequentially, the second sub-electrode 45-2 may be disposed on a side of the first sub-electrode 45-1 away from the third gate electrode 23, and the third sub-electrode 45-3 may be disposed on a side of the second sub-electrode 45-2 away from the third gate electrode 23. The first sub-electrode 45-1 and the third sub-electrode 45-3 may be in a shape of a strip extending in the first direction X, the second sub-electrode 45-2 may be in a shape of a strip extending in the second direction Y, both terminals of the second sub-electrode 45-2 are respectively connected with the first sub-electrode 45-1 and the third sub-electrode 45-3, the first sub-electrode 45-1 is connected with the third drain region through the fifth via V5, and the third sub-electrode 45-3 is connected with the fourth drain region through the seventh via V7.

In an exemplary implementation, a terminal of the third sub-electrode 45-3 away from the second sub-electrode 45-2 may be provided with a sub-electrode block 45-4, and the third sub-electrode 45-3 and the sub-electrode block 45-4 are connected with the fourth drain region through the seventh via V7.

In an exemplary implementation, orthographic projections of the second sub-electrode 45-2 and the third sub-electrode 45-3 on the silicon substrate are at least partially overlapped with an orthographic projection of the fourth gate electrode 24 on the silicon substrate.

In an exemplary implementation, in at least one pixel row, shapes of fifth connection electrodes 45 in adjacent sub-pixels may be different.

In an exemplary implementation, in at least one pixel row, shapes of the fifth connection electrodes 45 may include a first shape and a second shape, and the fifth connection electrodes 45 in the first shape and the fifth connection electrodes 45 in the second shape may be alternately disposed in the first direction X. For example, the fifth connection electrodes 45 in the first shape may be disposed in the N-th pixel column, the (N+2)-th pixel column, and the (N+4)-th pixel column, respectively, and the fifth connection electrodes 45 in the second shape may be disposed in the (N+1)-th pixel column, the (N+3)-th pixel column, and the (N+5)-th pixel column, respectively.

In an exemplary implementation, in the fifth connection electrode 45 in the first shape, the first sub-electrode 45-1 may be disposed on a side of the second sub-electrode 45-2 in the first direction X, and the third sub-electrode 45-3 may be disposed on a side of the second sub-electrode 45-2 in the opposite direction of the first direction X, forming a shape similar to a shape of character "Z".

In an exemplary implementation, in the fifth connection electrode 45 in the second shape, the first sub-electrode 45-1 and the third sub-electrode 45-3 may both be disposed on one side of the second sub-electrode 45-2 in the first direction X, forming a shape similar to a shape of character "C".

In an exemplary implementation, the sixth connection electrode 46 may be in a shape of a strip extending in the second direction Y, and may be disposed between some of adjacent fourth gate electrodes 24 in the first direction X. A first terminal of the sixth connection electrode 46 is connected with the second power supply line 82, and a second terminal of the sixth connection electrode 46 extends in the second direction Y toward a direction toward the third transistor T3, and then is connected with the fourth source region through the sixth via V6, so that the second power supply line 82 writes the second power supply signal to the first electrode of the fourth transistor T4. In an exemplary implementation, the sixth connection electrode 46 may serve as a power supply connection portion of the present disclosure.

In the exemplary implementation, since fourth active regions of some of adjacent sub-pixels in one pixel row are of an interconnected integral structure, two sub-pixels share a fourth source region and a sixth via V6, some of adjacent sub-pixels in one pixel row may share a same sixth connection electrode 46, and one sixth connection electrode 46 may be disposed for every two pixel columns, that is, two adjacent sixth connection electrodes 46 in the first direction X may be separated by two sub-pixels. For example, a sixth connection electrode 46 may be disposed between fourth gate electrodes 24 in the N-th pixel column and the (N+1)-th pixel column. For another example, a sixth connection electrode 46 may be disposed between fourth gate electrodes 24 in the (N+2)-th pixel column and the (N+3)-th pixel column. For yet another example, a sixth connection electrode 46 may be disposed between fourth gate electrodes 24 of the (N+4)-th pixel column and the (N+5)-th pixel column.

In an exemplary implementation, in at least one sub-pixel, the sixth connection electrode 46 and the second power supply line 82 may be of an interconnected integral structure.

In an exemplary implementation, in at least one pixel row, one second power supply line 82 and a plurality of sixth connection electrodes 46 may be of an interconnected integral structure.

In an exemplary implementation, in at least one pixel column, two sixth connection electrodes 46 and a second power supply line 82 in adjacent sub-pixels may be of an interconnected integral structure.

In an exemplary implementation, the seventh connection electrode 47 may be in a shape of a block (e.g., a rectangle), the seventh connection electrode 47 is connected with the first gate connection block 21-1 through the eighth via V8, and the seventh connection electrode 47 is configured to be connected with a fifteenth connection electrode formed subsequently.

In an exemplary implementation, the eighth connection electrode 48 may be in a shape of a strip extending in the second direction Y, the eighth connection electrode 48 is connected with the fourth gate connection block 24-1 through the eleventh via V11, and the eighth connection electrode 48 is configured to be connected with a third scan signal line formed subsequently.

In some exemplary implementations, the pattern of the first conductive layer may further include a ninth connection electrode 49. The ninth connection electrode 49 may be in a shape of a strip in which a main body portion extends in the second direction Y, a first terminal of the ninth connection electrode 49 is connected to the second power supply line 82, a second terminal of the ninth connection electrode 49 extends in a direction toward the third gate electrode 23, and the ninth connection electrode 49 is connected with the second power supply region 16 through some of thirteenth vias V13. In an exemplary implementation, the ninth connection electrode 49 may serve as another power supply connection portion of the present disclosure.

In an exemplary implementation, ninth connection electrodes 49 may be disposed between two fifth connection electrodes 45 of some of adjacent pixel columns. For example, ninth connection electrodes 49 may be disposed between fifth connection electrodes 45 of the (N-1)-th pixel column and the N-th pixel column, the (N+1)-th pixel column and the (N+2)-th pixel column, the (N+3)-th pixel column and the (N+4)-th pixel column, and the (N+5)-th pixel column and the (N+6)-th pixel column, respectively.

In an exemplary implementation, in at least one sub-pixel, a ninth connection electrode 49 and a second power supply line 82 may be of an interconnected integral structure.

In an exemplary implementation, in at least one pixel row, one second power supply line 82 and a plurality of ninth connection electrodes 49 may be of an interconnected integral structure.

In an exemplary implementation, in at least one pixel column, two ninth connection electrodes 49 in adjacent sub-pixels may be of an interconnected integral structure.

In an exemplary implementation, in at least one pixel row, the sixth connection electrodes 46 and the ninth connection electrodes 49 may be alternately disposed in the first direction X.

In the exemplary implementation, since the sixth connection electrodes 46 are disposed between some of adjacent fourth gate electrodes 24 in one pixel row, the ninth connection electrodes 49 are disposed between some of adjacent fifth connection electrodes 45 in one pixel row, and the sixth connection electrodes 46 and the ninth connection electrodes 49 are both connected with the second power supply line 82, a sixth connection electrode 46, a ninth connection electrode 49, and the second power supply line 82 in one sub-pixel can form a shielding structure surrounding the fourth transistor T4 in three directions, and the shielding structure has a potential of the second power supply line, can effectively shield the fourth transistor T4 and the third node N3 in the sub-pixel, can effectively reduce a mutual interference between an adjacent fourth transistor T4 and a third node N3, improve the reset performance and operational stability of the fourth transistor T4, and improve the uniformity and stability of the output current or voltage of the pixel driving circuit.

In an exemplary implementation, since the fifth connection electrode is configured to be connected with the anode through a plurality of connection electrodes, the ninth connection electrode disposed between adjacent fifth connection electrodes can also effectively shield crosstalk between adjacent anodes and improve output stability. The pixel driving circuit of the present disclosure adopts an N-type fourth transistor T4, and the fourth transistor T4 has a good isolation structure, which can effectively improve the dynamic range of the anode, and improve the brightness of the OLED.

In an exemplary implementation, the shielding electrode 50 may be in a shape of a block (e.g., a rectangle), corners or edges of the shape of the block may be provided with chamfers or grooves, an orthographic projection of the shielding electrode 50 on the silicon substrate is at least partially overlapped with the orthographic projection of the third gate electrode 23 on the silicon substrate, the shielding electrode 50 is connected with the first power supply region 15 through the twelfth via V12, and the shielding electrode 50 is configured to be connected with the first power supply line through a plurality of connection electrodes formed subsequently, so that the shielding electrode 50 has a potential of the first power supply line. Since the first power supply region 15 is located in the N-well area 10A, it is realized that the first power supply line writes the first power supply signal to the N-well area 10A, which can not only provide better current driving capability and response speed, meet the operation requirements of the pixel driving circuit, but also improve the overall efficiency of the pixel driving circuit.

In an exemplary implementation, an overlapping region of the orthographic projection of the shielding electrode 50 on the silicon substrate and the orthographic projection of the third gate electrode 23 on the silicon substrate has a first area, the orthographic projection of the third gate electrode 23 on the silicon substrate has a second area, and a ratio of the first area to the second area may be greater than or equal to 0.8, that is, a coverage area of the shielding electrode 50 covering the third gate electrode 23 is greater than 80% of the area of the third gate electrode.

In the exemplary implementation, in the light emitting stage, the gate electrode (i.e., the third gate electrode 23) of the third transistor T3 is in a floating state, and is easily interfered by some signal traces and electrodes. Further, since the third gate electrode 23 has a large area, it is easy to form parasitic capacitor with other signal traces and electrodes, which affects a performance of the third transistor T3. For example, in the light emitting stage, anode potentials (potentials of third nodes N3) in different sub-pixels will change from the voltage of the second power supply signal to corresponding voltage values (a maximum voltage can be increased to the voltage of the first power supply signal) according to the display requirements of different gray scales, and at this time, the changes of the anode potentials will affect gate voltages of the third transistors T3 through parasitic capacitors between anodes and gate electrodes of the third transistors T3, resulting in unstable output. In the present disclosure, by disposing a shielding electrode 50 in the first conductive layer, the shielding electrode 50 basically covers the gate electrode of the third transistor T3, the shielding electrode 50 having a constant potential (a potential of the first power supply line) can effectively shield the gate electrode of the third transistor T3, effectively eliminate the interference of signal traces and other electrodes to the third transistor T3, improve the working stability of the third transistor T3, effectively improve the uniformity and stability of the output current or voltage of the pixel driving circuit, and improve the display performance and display quality.

In an exemplary implementation, in the first direction X, there may be a shield spacing PL between the shielding electrodes 50 in adjacent sub-pixels, the second power supply line 82 may have a width BV, and the shield spacing PL may be greater than or equal to the width BV of the second power supply line, but less than 2 * the width BV of the second power supply line. The shield spacing PL may be an average spacing between the two shielding electrodes 50, and is a dimension in the first direction X. The width BV of the second power supply line may be an average width of the second power supply line 82, and may be a dimension in the second direction Y.

In an exemplary implementation, the shield spacing PL may be equal to the width BV of the second power supply line.

In an exemplary implementation, patterns of first conductive layers of adjacent pixel rows may be mirror-symmetrical with respect to a first center line O1. For example, second scan signal lines 32, first connection electrodes 41 to ninth connection electrodes 49, shielding electrodes 50, and second power supply lines 82 in the M-th pixel row and the (M+1)-th pixel row may be mirror-symmetrical with respect to a first center line O1.

In an exemplary implementation, positions and shapes of second scan signal lines 32, first connection electrodes 41 to fourth connection electrodes 44, seventh connection electrodes 47, and shielding electrodes 50 in adjacent pixel columns may be substantially the same.

In an exemplary implementation, sixth connection electrodes 46, eighth connection electrodes 48, ninth connection electrodes 49, and second power supply lines 82 in adjacent pixel columns may be mirror-symmetrical with respect to a second center line O2.

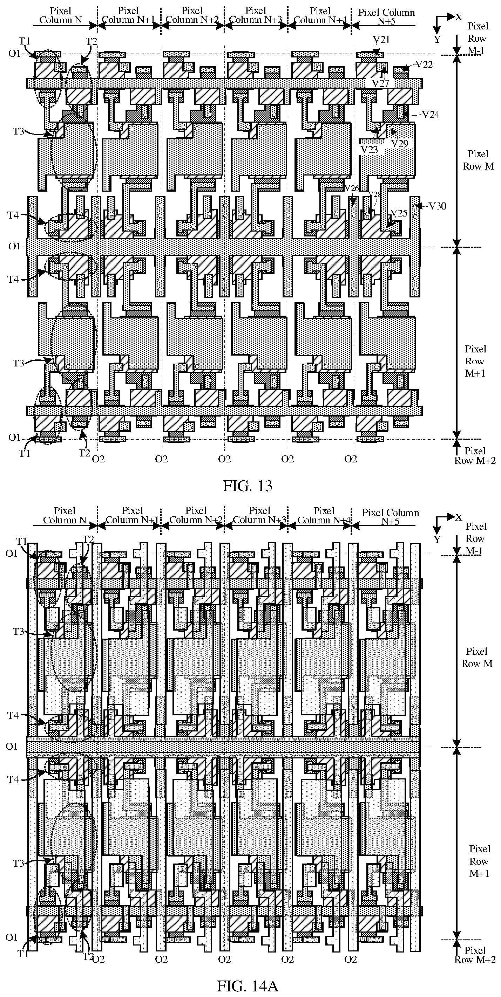

(7) A pattern of a third insulation layer is formed. In an exemplary implementation, forming the pattern of the third insulation layer may include: depositing a third insulation thin film on the silicon substrate on which the aforementioned patterns are formed, and patterning the third insulation thin film through a patterning process to form the third insulation layer covering the pattern of the first conductive layer; a plurality of vias are disposed in the third insulation layer, as shown in FIG. 13.

In an exemplary implementation, a plurality of vias in each sub-pixel in the display substrate may at least include: a twenty-first via V21, a twenty-second via V22, a twenty-third via V23, a twenty-fourth via V24, a twenty-fifth via V25, a twenty-sixth via V26, a twenty-seventh via V27, a twenty-eighth via V28, and a twenty-ninth via V29.

In an exemplary implementation, an orthographic projection of the twenty-first via V21 on the silicon substrate may be within a range of an orthographic projection of the first connection electrode 41 on the silicon substrate. The third insulation layer within the twenty-first via V21 is etched away to expose a surface of the first connection electrode 41, and the twenty-first via V21 is configured such that an eleventh connection electrode formed subsequently is connected with the first connection electrode 41 through this via.

In an exemplary implementation, the orthographic projection of the twenty-first via V21 on the silicon substrate is at least partially overlapped with an orthographic projection of the first center line O1 on the silicon substrate.

In an exemplary implementation, an orthographic projection of the twenty-second via V22 on the silicon substrate may be within a range of an orthographic projection of the second connection electrode 42 on the silicon substrate. The third insulation layer within the twenty-second via V22 is etched away to expose a surface of the second connection electrode 42, and the twenty-second via V22 is configured such that a twelfth connection electrode formed subsequently is connected with the second connection electrode 42 through this via.

In an exemplary implementation, an orthographic projection of the twenty-third via V23 on the silicon substrate may be within a range of an orthographic projection of the third connection electrode 43 on the silicon substrate. The third insulation layer within the twenty-third via V23 is etched away to expose a surface of the third connection electrode 43, and the twenty-third via V23 is configured such that a thirteenth connection electrode formed subsequently is connected with the third connection electrode 43 through this via.

In an exemplary implementation, an orthographic projection of the twenty-fourth via V24 on the silicon substrate may be within a range of an orthographic projection of the fourth connection electrode 44 on the silicon substrate. The third insulation layer within the twenty-fourth via V24 is etched away to expose a surface of the fourth connection electrode 44, and the twenty-fourth via V24 is configured such that a fourteenth connection electrode formed subsequently is connected with the fourth connection electrode 44 through this via.

In an exemplary implementation, an orthographic projection of the twenty-fifth via V25 on the silicon substrate may be within a range of an orthographic projection of the third sub-electrode 45-3 of the fifth connection electrode 45 on the silicon substrate. The third insulation layer in the twenty-fifth via V25 is etched away to expose a surface of the third sub-electrode 45-3, and the twenty-fifth via V25 is configured such that a fifteenth connection electrode formed subsequently is connected with the third sub-electrode 45-3 through this via.

In an exemplary implementation, an orthographic projection of the twenty-sixth via V26 on the silicon substrate may be within a range of an orthographic projection of the sixth connection electrode 46 on the silicon substrate. The third insulation layer within the twenty-sixth via V26 is etched away to expose a surface of the sixth connection electrode 46, and the twenty-sixth via V26 is configured such that a second connection line formed subsequently is connected with the sixth connection electrode 46 through this via.

In an exemplary implementation, since some of adjacent sub-pixels in one pixel row share a same sixth connection electrode 46, some adjacent sub-pixels in the one pixel column may share a same twenty-sixth via V26. In an exemplary implementation, there may be a plurality of twenty-sixth vias V26 to reduce a contact resistance and improve connection reliability.

In an exemplary implementation, an orthographic projection of the twenty-seventh via V27 on the silicon substrate may be within a range of an orthographic projection of the seventh connection electrode 47 on the silicon substrate. The third insulation layer within the twenty-seventh via V27 is etched away to expose a surface of the seventh connection electrode 47, and the twenty-seventh via V27 is configured such that a sixteenth connection electrode formed subsequently is connected with the seventh connection electrode 47 through this via.

In an exemplary implementation, an orthographic projection of the twenty-eighth via V28 on the silicon substrate may be within a range of an orthographic projection of the eighth connection electrode 48 on the silicon substrate. The third insulation layer within the twenty-eighth via V28 is etched away to expose a surface of the eighth connection electrode 48, and the twenty-eighth via V28 is configured such that a third scan signal line formed subsequently is connected with the eighth connection electrode 48 through this via.

In an exemplary implementation, an orthographic projection of the twenty-ninth via V29 on the silicon substrate may be within a range of an orthographic projection of the shielding electrode 50 on the silicon substrate. The third insulation layer within the twenty-ninth via V29 is etched away to expose a surface of the shielding electrode 50, and the twenty-ninth via V29 is configured such that a twelfth connection electrode formed subsequently is connected with the shielding electrode 50 through this via.

In an exemplary implementation, a plurality of vias on the third insulation layer may further include a thirtieth via V30. An orthographic projection of the thirtieth via V30 on the silicon substrate is within a range of an orthographic projection of the ninth connection electrode 49 on the silicon substrate. The third insulation layer within the thirtieth via V30 is etched away to expose a surface of the ninth connection electrode 49, and the thirtieth via V30 is configured such that a second connection line formed subsequently is connected with the ninth connection electrode 49 through this via. In an exemplary implementation, there may be a plurality of thirtieth vias V30 to reduce a contact resistance and improve connection reliability.

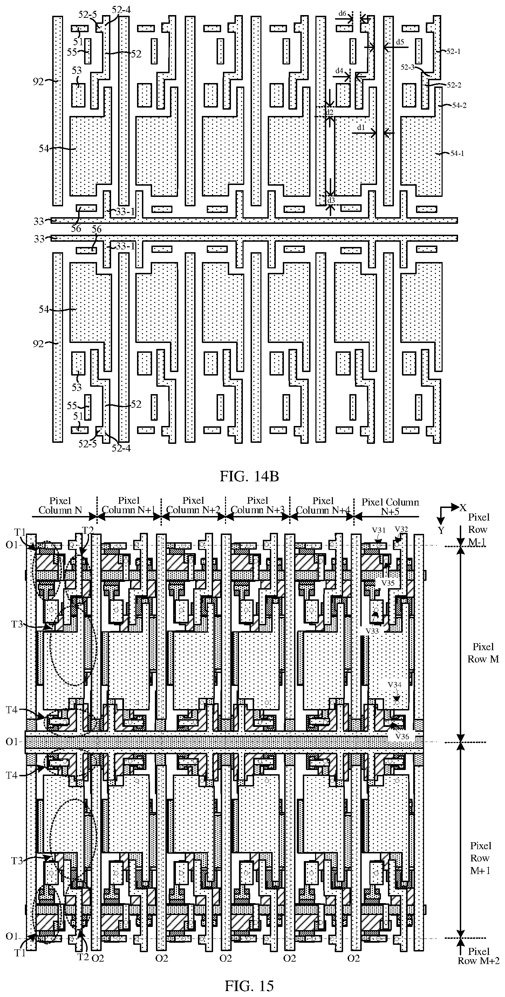

(8) A pattern of a second conductive layer is formed. In an exemplary implementation, forming the pattern of the second conductive layer may include: depositing a second conductive thin film on the silicon substrate on which the aforementioned patterns are formed, and patterning the second conductive thin film through a patterning process to form the pattern of the second conductive layer on the third insulation layer, as shown in FIGs. 14A and 14B, wherein FIG. 14B is a schematic diagram of the second conductive layer in FIG. 14A. In an exemplary implementation, the second conductive layer may be referred to as a second metal (Metal2) layer.

In an exemplary implementation, a pattern of a second conductive layer in each sub-pixel in the display substrate may at least include: a third scan signal line 33, an eleventh connection electrode 51, a twelfth connection electrode 52, a thirteenth connection electrode 53, a fourteenth connection electrode 54, a fifteenth connection electrode 55, a sixteenth connection electrode 56, and a second connection line 92.

In an exemplary implementation, the eleventh connection electrode 51 may be in a shape of a strip in which a main body portion extends in the first direction X, and may be located on a side of the second scan signal line 32 away from the third gate electrode 33. The eleventh connection electrode 51 may be connected with the first connection electrode 41 through the twenty-first via V21, and the eleventh connection electrode 51 is configured to be connected with a data signal line formed subsequently.

In an exemplary implementation, in at least one sub-pixel, an orthographic projection of the eleventh connection electrode 51 on the silicon substrate is at least partially overlapped with an orthographic projection of a first center line O1 on the silicon substrate, and adjacent sub-pixels in one pixel column may share a same eleventh connection electrode 51.

In an exemplary implementation, the twelfth connection electrode 52 includes a first vertical electrode 52-1, a second vertical electrode 52-2, and a lateral electrode 52-3. In the first direction X, the first vertical electrode 52-1 may be disposed on a side of the lateral electrode 52-3 in the first direction X, and the second vertical electrode 52-2 may be disposed on a side of the lateral electrode 52-3 in the opposite direction of the first direction X. In the second direction Y, the lateral electrode 52-3 may be disposed on a side of the first vertical electrode 52-1 close to the shielding electrode 50, and the second vertical electrode 52-2 may be disposed on a side of the lateral electrode 52-3 close to the shielding electrode 50. The first vertical electrode 52-1 and the second vertical electrode 52-2 may be in a shape of a strip extending in the second direction Y, and the lateral electrode 52-3 may be in a shape of a strip extending in the first direction X, and both terminals of the lateral electrode 52-3 are connected with the first vertical electrode 52-1 and the second vertical electrode 52-2, respectively. One terminal of the first vertical electrode 52-1 away from the lateral electrode 52-3 may be connected with the second connection electrode 42 through the twenty-second via V22, and one terminal of the second vertical electrode 52-2 away from the lateral electrode 52-3 may be connected with the shielding electrode 50 through the twenty-ninth via V29. In an exemplary implementation, the twelfth connection electrode 52 may serve as a first power supply connection electrode in the present disclosure.

In an exemplary implementation, in the first direction X, the second vertical electrode 52-2 of the twelfth connection electrodes 52 may be disposed between the third connection electrode 43 as the first node electrode and the fourth connection electrode 44 as the second node electrode. Since the third connection electrode 43 is connected with the gate electrode of the third transistor T3 and the fourth connection electrode 44 is connected with the first electrode of the third transistor T3, the twelfth connection electrode 52 having a constant potential (the potential of the first power supply line) can form a constant potential shield, effectively eliminate crosstalk between the gate electrode and the first electrode of the third transistor T3, improve uniformity and stability of the output current or voltage of the pixel driving circuit, and improve display performance and display quality.

In an exemplary implementation, twelfth connection electrodes 52 of adjacent sub-pixels in one pixel column may be connected with each other by electrode connection strips 52-4. The electrode connection strip 52-4 may be in a shape of a strip extending in the second direction Y, and is disposed between the twelfth connection electrodes 52 of some of adjacent pixel rows, and both terminals of an electrode connection strip 52-4 are respectively connected with the twelfth connection electrodes 52 of two sub-pixels.

In an exemplary implementation, an electrode connection block 52-5 may be disposed on the electrode connection strip 52-4, and the electrode connection block 52-5 may be disposed on a side of the electrode connection strip 52-4 close to the eleventh connection electrode 51 and connected with the electrode connection strip 52-4, and the electrode connection block 52-5 is configured to be connected with a twenty-first connection electrode formed subsequently.

In an exemplary implementation, an orthographic projection of the electrode connection block 52-5 on the silicon substrate is at least partially overlapped with an orthographic projection of the first center line O1 on the silicon substrate.

In an exemplary implementation, two twelfth connection electrodes 52, electrode connection strips 52-4, and electrode connection blocks 52-5 of adjacent sub-pixels in one pixel column may be of an interconnected integral structure.

In an exemplary implementation, the thirteenth connection electrode 53 may be in a shape of a block (e.g., a rectangle), and the thirteenth connection electrode 53 is connected with the third connection electrode 43 through the twenty-third via V23, and the thirteenth connection electrode 53 is configured to be connected with a first plate formed subsequently.

In an exemplary implementation, the fourteenth connection electrode 54 may include a block-shaped sub-electrode 54-1 and a strip-shaped sub-electrode 54-2 connected with each other to form an integral structure, the strip-shaped sub-electrode 54-2 may be disposed on a side of the block-shaped sub-electrode 54-1 close to the eleventh connection electrode 51, and the strip-shaped sub-electrode 54-2 may be connected with the fourth connection electrode 44 through the twenty-fourth via V24. Since the fourth connection electrode 44 is connected with the second drain region (also the third source region) through a via, the fourteenth connection electrode 54 has a potential of the second node N2. In an exemplary implementation, the fourteenth connection electrode 54 may serve as a compensation electrode in the present disclosure.

In an exemplary implementation, an orthographic projection of the block-shaped sub-electrode 54-1 of the fourteenth connection electrode 54 on the silicon substrate is at least partially overlapped with the orthographic projection of the shielding electrode 50 on the silicon substrate, the orthographic projection of the block-shaped sub-electrode 54-1 on the silicon substrate is at least partially overlapped with the orthographic projection of the fifth connection electrode 45 on the silicon substrate, the orthographic projection of the block-shaped sub-electrode 54-1 on the silicon substrate is at least partially overlapped with the orthographic projection of the eighth connection electrode 48 on the silicon substrate.

In an exemplary implementation, an area of the orthographic projection of the block-shaped sub-electrode 54-1 on the silicon substrate may be greater than an area of the orthographic projection of the shielding electrode 50 on the silicon substrate.

In an exemplary implementation, the fifteenth connection electrode 55 may be in a shape of a strip extending in the second direction Y, the fifteenth connection electrode 55 may be connected with the seventh connection electrode 47 through the twenty-seventh via V27, and the fifteenth connection electrode 55 is configured to be connected with a twenty-third connection electrode formed subsequently.

In an exemplary implementation, the sixteenth connection electrode 56 may be in a shape of a strip extending in the first direction X, the sixteenth connection electrode 56 may be connected with the third sub-electrode 45-3 of the fifth connection electrode 45 through the twenty-fifth via V25, and the sixteenth connection electrode 56 is configured to be connected with a twenty-fourth connection electrode formed subsequently.

In an exemplary implementation, the third scan signal line 33 may be in a shape of a straight line in which a main body portion extends in the first direction X, and may be disposed on a side of the sixteenth connection electrode 56 away from the fourteenth connection electrode 54. A third scan connection block 33-1 may be disposed on the third scan signal line 33, and the third scan connection block 33-1 may be disposed in each sub-pixel. The third scan connection block 33-1 may be in a shape of a strip extending in the second direction Y, a first terminal of the third scan connection block 33-1 is connected to the third scan signal line 33, a second terminal of the third scan connection block 33-1 extends in a direction toward the third gate electrode 23 and then is connected with the eighth connection electrode 48 through the twenty-eighth via V28. Since the eighth connection electrode 48 is connected with the fourth gate connection block 24-1 through a via, the fourth gate connection block 24-1 is connected with the fourth gate connection electrode 24, it is realized that a connection between the third scan signal line 33 and the gate electrode of the fourth transistor T4 in each sub-pixel, and the third scan signal line 33 can control the turn-on or turn-off of the fourth transistor T4.

In an exemplary implementation, in at least one pixel row, the third scan signal line 33 and a plurality of third scan connection blocks 33-1 may be of an interconnected integral structure.

In an exemplary implementation, an orthographic projection of the third scan signal line 33 on the silicon substrate is at least partially overlapped with an orthographic projection of the second power supply line 82 on the silicon substrate, and the second power supply line 82 having a constant potential can effectively shield an influence of the third scan signal on the pixel driving circuit.

In an exemplary implementation, the second connection line 92 may be in a shape of a straight line or a polyline extending in the first direction X. In the first direction X, the second connection line 92 may be disposed between two fourth gate electrodes 24 of adjacent sub-pixels. In the second direction Y, the second connection line 92 may be disposed on a side of the third scan signal line 33 away from the second power supply line 82. Herein, second connection lines 92 between the N-th pixel column and the (N+1)-th pixel column, between the (N+2)-th pixel column and the (N+3)-th pixel column, and between the (N+4)-th pixel column and the (N+5)-th pixel column may be connected with sixth connection electrodes 46 through twenty-sixth vias V26. Second connection lines 92 between the (N-1)-th pixel column and the N-th pixel column, between the (N+1)-th pixel column and the (N+2)-th pixel column, between the (N+3)-th pixel column and the (N+4)-th pixel column, and between the (N+5)-th pixel column and the (N+6)-th pixel column may be connected with ninth connection electrodes 49 through thirtieth vias V30.

In an exemplary implementation, in at least one pixel column, second connection lines 92 in some of adjacent sub-pixels may be of an interconnected integral structure, and the second connection lines 92 in some of the adjacent sub-pixels may be spaced apart by third scan signal lines 33. For example, second connection lines 92 in the M-th pixel row and second connection lines 92 in the (M+1)-th pixel row may be spaced apart by third scan signal lines 33. For another example, second connection lines 92 in the (M-1)-th pixel row and the M-th pixel row may be of an interconnected integral structure, and second connection lines 92 in the (M+1)-th pixel row and the (M+2)-th pixel row may be of an interconnected integral structure.

In an exemplary implementation, in at least one pixel column, two second connection lines 92 spaced apart by third scan signal lines 33 may be connected through sixth connection electrodes 46 or ninth connection electrodes 49 to form vertical traces that continuously transmit the second power supply signal in the second direction Y. The second power supply line 82 in the first conductive layer serves as a horizontal line trace that continuously transmits the second power supply signal in the first direction X, so that the horizontal line trace extending in the first direction X and the vertical line extending in the second direction Y form a mesh-like interconnect structure for transmitting the second power supply signal on the display substrate, which can not only effectively reduce the resistance of the second power supply line and reduce the voltage drop of the second power supply signal, but also effectively improve the uniformity of the second power supply signal in the display substrate, ensure that the potential (anode potential) of the third node N3 at each position during the reset phase, the self-discharge phase, and the data write phase is reset to the voltage of the second power supply signal, effectively improve the uniformity of the display, and improve the display performance and the display quality.

In an exemplary implementation, an orthographic projection of the second connection line 92 on the silicon substrate is at least partially overlapped with an orthographic projection of the first center line O2 on the silicon substrate. Since the second connection line 92 is disposed between adjacent pixel columns, the second connection line 92 having a constant potential can not only effectively shield the pixel driving circuit in the sub-pixel and improve the output stability of the pixel driving circuit, but also effectively reduce mutual interference between pixel driving circuits in sub-pixels and effectively improve the uniformity and stability of the output current or voltage of the pixel driving circuit.

In an exemplary implementation, there may be a first distance d1 between the fourteenth connection electrode 54 and the second connection line 92, there may be a second distance d2 between the fourteenth connection electrode 54 and the thirteenth connection electrode 53, and the first distance d1 may be less than the second distance d2. The first distance d1 may be an average distance between an edge of the fourteenth connection electrode 54 on a side close to the second connection line 92 and an edge of the second connection line 92 on a side close to the fourteenth connection electrode 54, and may be a dimension in the first direction X. The second distance d2 may be an average distance between an edge of the fourteenth connection electrode 54 on a side of the block-shaped sub-electrode 54-1 close to the thirteenth connection electrode 53 and an edge of the thirteenth connection electrode 53 on a side close to the block-shaped sub-electrode 54-1 of the fourteenth connection electrode 54, and is a dimension in the second direction Y.

In an exemplary implementation, there may be a third distance d3 between the fourteenth connection electrode 54 and the sixteenth connection electrode 56, and the first distance d1 may be less than the third distance d3. The third distance d3 may be an average distance between an edge of the block-shaped sub-electrode 54-1 of the fourteenth connection electrode 54 on a side close to the sixteenth connection electrode 56 and an edge of the sixteenth connection electrode 56 on a side close to the block-shaped sub-electrode 54-1 of the fourteenth connection electrode 54, and is a dimension in the second direction Y.

In an exemplary implementation, there may be a fourth distance d4 between the twelfth connection electrode 52 and the thirteenth connection electrode 53, and the second distance d2 may be greater than the fourth distance d4. The fourth distance d4 may be an average distance between an edge of the second vertical electrode 52-2 of the twelfth connection electrode 52 on a side close to the thirteenth connection electrode 53 and an edge of the thirteenth connection electrode 53 on a side close to the second vertical electrode 52-2 of the twelfth connection electrode 52, and is a dimension in the first direction X.

In an exemplary implementation, there may be a fifth distance d5 between the twelfth connection electrode 52 and the second connection line 92, there may be a sixth distance d6 between the twelfth connection electrode 52 and the eleventh connection electrode 51, and the fifth distance d5 may be less than the sixth distance d6. The fifth distance d5 may be an average distance between an edge of the first vertical electrode 52-1 of the twelfth connection electrode 52 on a side close to the second connection line 92 and an edge of the second connection line 92 on a side close to the first vertical electrode 52-1 of the twelfth connection electrode 52, and may be a dimension in the first direction X. The sixth distance d6 may be an average distance between an edge of the electrode connection block 52-5 of the twelfth connection electrode 52 on a side close to the eleventh connection electrode 51 and an edge of the eleventh connection electrode 51 on a side close to the electrode connection block 52-5 of the twelfth connection electrode 52, and is a dimension in the first direction X.

In an exemplary implementation, patterns of second conductive layers of adjacent pixel rows may be mirror-symmetrical with respect to a first center line O1. For example, third scan signal lines 33, eleventh connection electrodes 51 to sixteenth connection electrodes 56, and second connection lines 92 in the M-th pixel row and the (M+1)-th pixel row may be mirror-symmetrical with respect to a first center line O1.

In an exemplary implementation, positions and shapes of eleventh connection electrodes 51 to fifteenth connection electrodes 55 of adjacent pixel columns may be substantially the same.

In an exemplary implementation, third scan signal line 33, sixteenth connection electrodes 56, and second connection lines 92 of adjacent pixel columns may be mirror-symmetrical with respect to a second center line O2.

(9) A pattern of a fourth insulation layer is formed. In an exemplary implementation, forming the pattern of the fourth insulation layer may include: depositing a fourth insulation thin film on the silicon substrate on which the aforementioned patterns are formed, and patterning the fourth insulation thin film through a patterning process to form the fourth insulation layer covering the pattern of the second conductive layer; wherein a plurality of vias are disposed in the fourth insulation layer, as shown in FIG. 15.

In an exemplary implementation, the plurality of vias in each sub-pixel in the display substrate may include a thirty-first via V31, a thirty-second via V32, a thirty-third via V33, a thirty-fourth via V34, a thirty-fifth via V35, and a thirty-sixth via V36.

In an exemplary implementation, an orthographic projection of the thirty-first via V31 on the silicon substrate may be within a range of an orthographic projection of the eleventh connection electrode 51 on the silicon substrate. The fourth insulation layer within the thirty-first via V31 is etched away to expose a surface of the eleventh connection electrode 51, and the thirty-first via V31 is configured such that a data signal line formed subsequently is connected with the eleventh connection electrode 51 through this via.

In an exemplary implementation, the orthographic projection of the thirty-first via V31 on the silicon substrate is at least partially overlapped with an orthographic projection of the first center line O1 on the silicon substrate.

In an exemplary implementation, an orthographic projection of the thirty-second via V32 on the silicon substrate may be within a range of an orthographic projection of the electrode connection block 52-5 on the silicon substrate. The fourth insulation layer within the thirty-second via V32 is etched away to expose a surface of the electrode connection block 52-5, and the thirty-second via V32 is configured such that a twenty-first connection electrode formed subsequently is connected with the electrode connection block 52-5 through this via.

In an exemplary implementation, the orthographic projection of the thirty-second via V32 on the silicon substrate is at least partially overlapped with the orthographic projection of the first center line O1 on the silicon substrate.

In an exemplary implementation, an orthographic projection of the thirty-third via V33 on the silicon substrate is within a range of an orthographic projection of the thirteenth connection electrode 53 on the silicon substrate. The fourth insulation layer within the thirty-third via V33 is etched away to expose a surface of the thirteenth connection electrode 53, and the thirty-third via V33 is configured such that a first plate formed subsequently is connected with the thirteenth connection electrode 53 through this via.

In an exemplary implementation, an orthographic projection of the thirty-fourth via V34 on the silicon substrate is within a range of an orthographic projection of the fourteenth connection electrode 54 on the silicon substrate. The fourth insulation layer within the thirty-fourth via V34 is etched away to expose a surface of the fourteenth connection electrode 54, and the thirty-fourth via V34 is configured such that a twenty-second connection electrode formed subsequently is connected with the fourteenth connection electrode 54 through this via.

In an exemplary implementation, an orthographic projection of the thirty-fifth via V35 on the silicon substrate is within a range of an orthographic projection of the fifteenth connection electrode 55 on the silicon substrate. The fourth insulation layer within the thirty-fifth via V35 is etched away to expose a surface of the fifteenth connection electrode 55, and the thirty-fifth via V35 is configured such that a twenty-third connection electrode formed subsequently is connected with the fifteenth connection electrode 55 through this via.

In an exemplary implementation, an orthographic projection of the thirty-sixth via V36 on the silicon substrate may be within a range of an orthographic projection of the sixteenth connection electrode 56 on the silicon substrate. The fourth insulation layer within the thirty-sixth via V36 is etched away to expose a surface of the sixteenth connection electrode 56, and the thirty-sixth via V36 is configured such that a twenty-fourth connection electrode formed subsequently is connected with the sixteenth connection electrode 56 through this via.

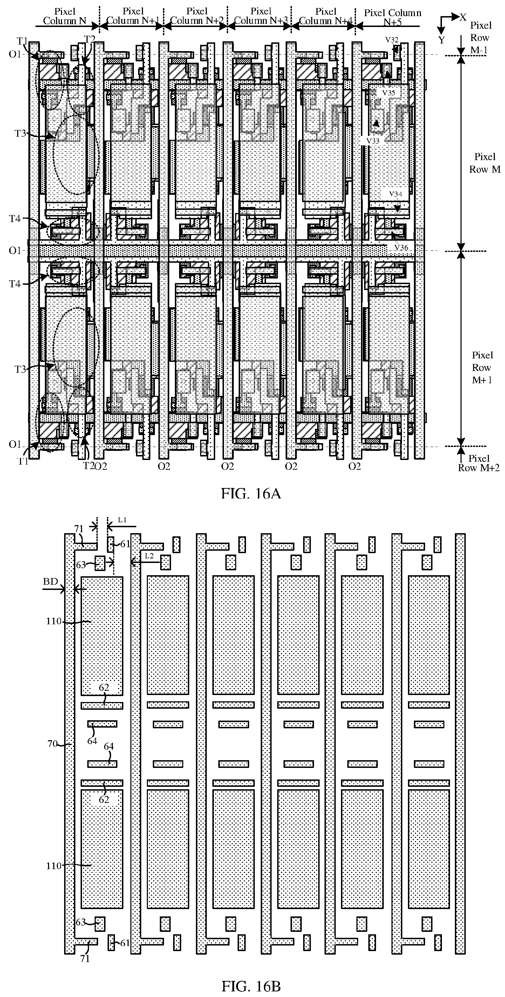

(10) A pattern of a third conductive layer is formed. In an exemplary embodiment, forming the pattern of the third conductive layer may include: depositing a third conductive thin film on the silicon substrate on which the aforementioned patterns are formed, and patterning the third conductive thin film through the patterning process to form the pattern of the third conductive layer on the fourth insulation layer, as shown in FIGs. 16A and 16B. FIG. 16B is a schematic diagram of the third conductive layer in FIG. 16A. In an exemplary implementation, the third conductive layer may be referred to as a third metal (Metal3) layer.

In an exemplary implementation, a pattern of a third conductive layer in each sub-pixel in the display substrate may at least include: a twenty-first connection electrode 61, a twenty-second connection electrode 62, a twenty-third connection electrode 63, a twenty-fourth connection electrode 64, a data signal line 70, and a first plate 110.

In an exemplary implementation, the data signal line 70 may be in a shape of a straight line or a polyline extending in the second direction Y. A data connection strip 71 may be disposed on the data signal line 70, the data connection strip 71 may be in a shape of a strip extending in the first direction X, a first terminal of the data connection strip 71 is connected with the data signal line 70, and a second terminal of the data connection strip 71 extends in the first direction X (a direction toward the twenty-first connection electrode 61), and is connected with the eleventh connection electrode 51 through the thirty-first via V31. Since the eleventh connection electrode 51 is connected with the first connection electrode 41 through a via, and the first connection electrode 41 is connected with the first source region through a via, it is realized that the data signal line 70 writes a data signal into the first electrode of the first transistor T1.

In an exemplary implementation, an orthographic projection of the data connection strip 71 on the silicon substrate is at least partially overlapped with the orthographic projection of the first center line O1 on the silicon substrate, and adjacent sub-pixels in one pixel column may share a same data connection strip 71, effectively reducing the quantity of connection electrodes, reducing the occupied area of the pixel driving circuit, which is beneficial to achieving high resolution.

In an exemplary implementation, in at least one pixel column, the data signal line 70 and the data connection strip 71 may be of an interconnected integral structure.

In an exemplary implementation, since adjacent sub-pixels in one pixel column share a first source region, a first connection electrode 41, an eleventh connection electrode 51, and a data connection strip 71, first transistors T1 of the adjacent sub-pixels in the one pixel column are written with a same data signal.

In an exemplary implementation, an orthographic projection of the data signal line 70 on the silicon substrate is at least partially overlapped with an orthographic projection of the second connection line 92 on the silicon substrate, and the second connection line 92 having a constant potential can effectively shield an influence of a jump voltage in the data signal line 70 on a key node in the pixel driving circuit.

In the exemplary implementation, the data signal line is disposed in the third conductive layer, and even if a short circuit occurs between the data signal line and the first plate due to process fluctuations and particles, only dark spots or bright spots are caused, and no vertical line defect occurs. Compared with the scheme in which the data signal lines are disposed in other conductive layers, the present embodiment neither affects the formation of the mesh-like interconnect structure for transmitting the second power supply signal, nor does a vertical line defect due to a short circuit between the data signal lines and the first power supply lines occur.

In an exemplary implementation, the first plate 110 may be in a shape of a rectangle, corners or edges of the rectangle may be provided with chamfers or grooves, the first plate 110 may be connected with the thirteenth connection electrode 53 through the thirty-third via V33, and the first plate 110 may serve as one plate of the first capacitor. Since the thirteenth connection electrode 53 is connected with the third connection electrode 43 through a via, and the third connection electrode 43 is respectively connected with the first drain region and the third gate electrode through a via, mutual connection between the second electrode of the first transistor T1, the gate electrode of the third transistor T3, and the first plate 110 is realized to form the first node N1 of the pixel driving circuit, and the first plate 110 has a potential of the first node N1.

In an exemplary implementation, an orthographic projection of the first plate 110 on the base substrate is at least partially overlapped with an orthographic projection of the fourteenth connection electrode 54 on the silicon substrate. An overlapping region of the orthographic projection of the fourteenth connection electrode 54 on the silicon substrate and the orthographic projection of the first plate 110 on the silicon substrate has a third area, the orthographic projection of the first plate 110 on the silicon substrate has a fourth area, and a ratio of the third area to the fourth area may be greater than or equal to 0.5.

In an exemplary implementation, the twenty-first connection electrode 61 may be in a shape of a strip extending in the second direction Y, the twenty-first connection electrode 61 is connected with the electrode connection block 52-5 through the thirty-second via V32, and the twenty-first connection electrode 61 is configured to be connected with a first power supply line formed subsequently. In an exemplary implementation, the twenty-first connection electrode 61 may serve as a second power supply connection electrode in the present disclosure.

In an exemplary implementation, an orthographic projection of the twenty-first connection electrode 61 on the silicon substrate is at least partially overlapped with the orthographic projection of the first center line O1 on the silicon substrate, and adjacent sub-pixels in one pixel column may share a same twenty-first connection electrode 61.

In an exemplary implementation, there is a first spacing L1 between a twenty-first connection electrode 61 in a current sub-pixel and a data connection strip 71 in the current sub-pixel, the data signal line 70 may have a width BD, and the first spacing L1 may be greater than or equal to the width BD of the data signal line. The first spacing L1 may be a minimum distance between an edge of the twenty-first connection electrode 61 on a side close to the data connection strip 71 and an edge of the data connection strip 71 on a side close to the twenty-first connection electrode 61, and is a dimension in the first direction X. The width BD of the data signal line may be an average width of the data signal line 70 (excluding the data connection strip), and is a dimension in the first direction X.

In an exemplary implementation, the first spacing L1 may be greater than or equal to 0.5µm. In the present disclosure, by disposing the spacing between the twenty-first connection electrode 61 and the data connection strip 71, it is possible to avoid a short circuit between the data signal line and the first power supply line, and it is possible to avoid a vertical line defect caused by the short circuit.

In an exemplary implementation, there is a second spacing L2 between the twenty-first connection electrode 61 in the current sub-pixel and a data signal line 70 in an adjacent sub-pixel in the first direction X, and the second spacing L2 may be greater than or equal to the width BD of the data signal line. The second spacing L2 may be a minimum distance between an edge of the twenty-first connection electrode 61 on a side close to the data signal line 70 and an edge of the data signal line 70 on a side close to the twenty-first connection electrode 61, and is a dimension in the first direction X.

In an exemplary implementation, the second spacing L2 may be greater than or equal to 0.5µm. In the present disclosure, by disposing the spacing between the twenty-first connection electrode 61 and the data signal line 70, it is possible to avoid a short circuit between the data signal line and the first power supply line, and it is possible to avoid a vertical line failure caused by the short circuit.

In an exemplary implementation, the twenty-second connection electrode 62 may be in a shape of a strip extending in the first direction X, and may be disposed on a side of the first plate 110 away from the twenty-first connection electrode 61. The twenty-second connection electrode 62 is connected with the fourteenth connection electrode 54 through the thirty-fourth via V34, and the twenty-second connection electrode 62 is configured to be connected with a third plate formed subsequently. Since the fourteenth connection electrode 54 has a potential of the second node N2, the twenty-second connection electrode 62 has the potential of the second node N2.

In an exemplary implementation, the twenty-third connection electrode 63 may be in a shape of a strip extending in the second direction Y, the twenty-third connection electrode 63 may be connected with the fifteenth connection electrode 55 through the thirty-fifth via V35, and the twenty-third connection electrode 63 is configured to be connected with a first scan signal line formed subsequently.

In an exemplary implementation, the twenty-fourth connection electrode 64 may be in a shape of a strip extending in the first direction X, the twenty-fourth connection electrode 64 may be connected with the sixteenth connection electrode 56 through the thirty-sixth via V36, and the twenty-fourth connection electrode 64 is configured to be connected with a twenty-fifth connection electrode formed subsequently.

In an exemplary implementation, patterns of third conductive layers of adjacent pixel rows may be mirror-symmetrical with respect to a first center line O1. For example, twenty-first connection electrodes 61 to twenty-fourth connection electrodes 64, data signal lines 70, and first plates 110 in the M-th pixel row and the (M+1)-th pixel row may be mirror-symmetrical with respect to a first center line O1.

In an exemplary implementation, positions and shapes of twenty-first connection electrodes 61 to twenty-fourth connection electrodes 64, data signal lines 70, and first plates 110 of adjacent pixel columns may be substantially the same.

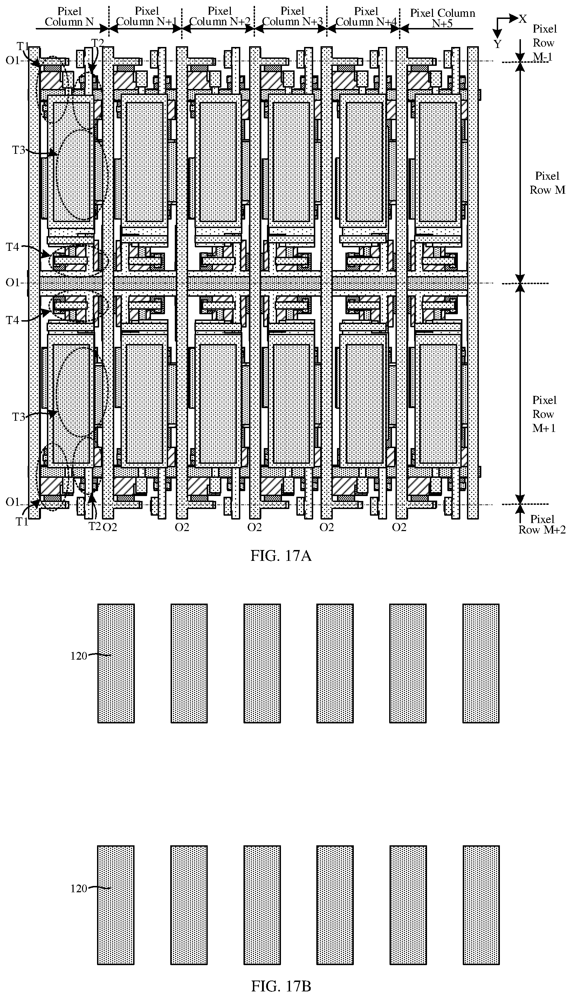

(11) A fifth insulation layer and a pattern of a fourth conductive layer are formed. In an exemplary embodiment, forming the fifth insulation layer and the pattern of the fourth conductive layer may include: sequentially depositing a fifth insulation film and a fourth conductive thin film on the silicon substrate on which the aforementioned patterns are formed, patterning the fourth conductive thin film by a patterning process, to form a fifth insulation layer covering the pattern of the third conductive layer, and the pattern of the fourth conductive layer disposed on the fifth insulation layer, as shown in FIGs. 17A and 17B, and FIG. 17B is a schematic diagram of the fourth conductive layer in FIG. 17A. In an exemplary implementation, the fourth conductive layer may be referred to as a metal-insulator-metal (MIM) layer.

In an exemplary implementation, a pattern of a fourth conductive layer in each sub-pixel may at least include a second plate 120.

In an exemplary implementation, the second plate 120 may be in a shape of a rectangle, corners of the rectangle may be provided with chamfers or grooves. An orthographic projection of the second plate 120 on the silicon substrate is at least partially overlapped with an orthographic projection of a first plate 110 on the silicon substrate, and the second plate 120 may serve as another plate of a first capacitor.

In an exemplary implementation, second plates 120 of adjacent pixel rows may be mirror-symmetrical with respect to a first center line O1, and positions and shapes of second plates 120 of adjacent pixel columns may be substantially the same.

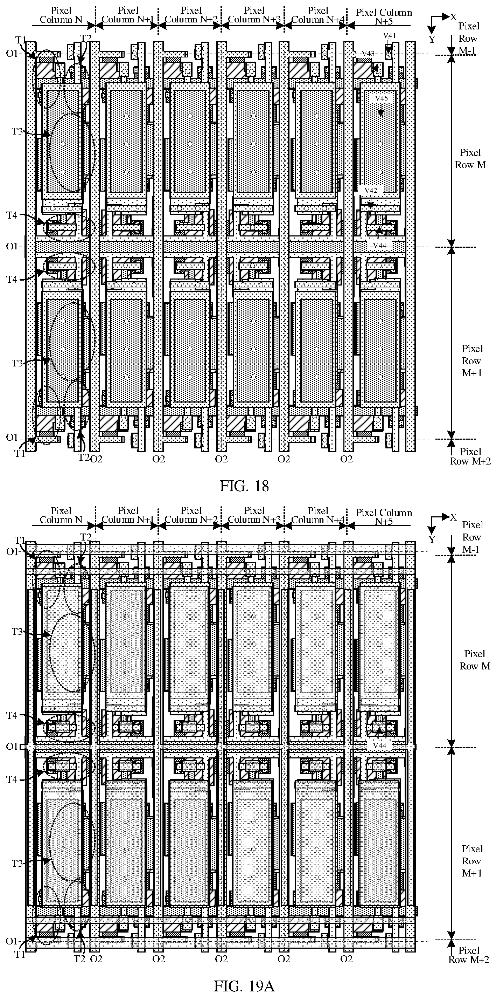

(12) A pattern of a sixth insulation layer is formed. In an exemplary implementation, forming the pattern of the sixth insulation layer may include: depositing a sixth insulation thin film on the silicon substrate on which the aforementioned patterns are formed, and patterning the sixth insulation thin film through a patterning process to form the sixth insulation layer covering the pattern of the third conductive layer; wherein a plurality of vias are disposed in the sixth insulation layer, as shown in FIG. 18.

In an exemplary implementation, the plurality of vias in each sub-pixel may include a forty-first via V41, a forty-second via V42, a forty-third via V43, a forty-fourth via V44, and a forty-fifth via V45.

In an exemplary implementation, an orthographic projection of the forty-first via V41 on the silicon substrate is within a range of an orthographic projection of the twenty-first connection electrode 61 on the silicon substrate. The fifth insulation layer and the sixth insulation layer within the forty-first via V41 are etched away to expose a surface of the twenty-first connection electrode 61. The forty-first via V41 is configured such that a first power supply line formed subsequently is connected with the twenty-first connection electrode 61 through this via.

In an exemplary implementation, an orthographic projection of the forty-second via V42 on the silicon substrate is within a range of an orthographic projection of the twenty-second connection electrode 62 on the silicon substrate. The sixth insulation layer and the fifth insulation layer within the forty-second via V42 are etched away to expose a surface of the twenty-second connection electrode 62, and the forty-second via V42 is configured such that a third plate formed subsequently is connected with the twenty-second connection electrode 62 through this via. In an exemplary implementation, there may be a plurality of forty-second vias V42 that may be sequentially disposed in the first direction X, to reduce a contact resistance and improve connection reliability.

In an exemplary implementation, an orthographic projection of the forty-third via V43 on the silicon substrate is within a range of an orthographic projection of the twenty-third connection electrode 63 on the silicon substrate. The sixth insulation layer and the fifth insulation layer within the forty-third via V43 are etched away to expose a surface of the twenty-third connection electrode 63, and the forty-third via V43 is configured such that a first scan signal line formed subsequently is connected with the twenty-third connection electrode 63 through this via.

In an exemplary implementation, an orthographic projection of the forty-fourth via V44 on the silicon substrate is within a range of an orthographic projection of the twenty-fourth connection electrode 64 on the silicon substrate. The sixth insulation layer and the fifth insulation layer within the forty-fourth via V44 are etched away to expose a surface of the twenty-fourth connection electrode 64, and the forty-fourth via V44 is configured such that a twenty-fifth connection electrode formed subsequently is connected with the twenty-fourth connection electrode 64 through this via.

In an exemplary implementation, an orthographic projection of the forty-fifth via V45 on the silicon substrate is within a range of an orthographic projection of the second plate 120 on the silicon substrate. The sixth insulation layer within the forty-fifth via V45 is etched away to expose a surface of the second plate 120, and the forty-fifth via V45 is configured such that a third plate formed subsequently is connected with the second plate 120 through this via. In an exemplary implementation, there may be a plurality of forty-fifth vias V45, and the plurality of vias may be sequentially disposed in the second direction Y, to reduce contact resistance and improve connection reliability.

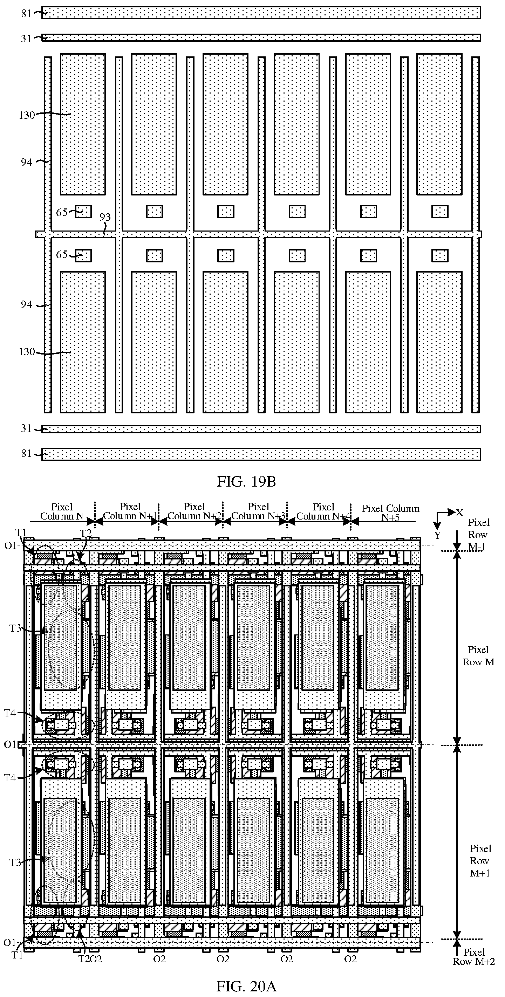

(13) A pattern of a fifth conductive layer is formed. In an exemplary implementation, forming the pattern of the fifth conductive layer may include: depositing a fifth conductive thin film on the silicon substrate on which the aforementioned patterns are formed, and patterning the fifth conductive thin film through the patterning process to form the pattern of the fifth conductive layer on the sixth insulation layer, as shown in FIGs. 19A and 19B. FIG. 19B is a schematic diagram of the fifth conductive layer in FIG. 19A. In an exemplary implementation, the fifth conductive layer may be referred to as a fourth metal (Metal4) layer.

In an exemplary implementation, a fifth conductive layer pattern in each sub-pixel in the display substrate may include at least a first scan signal line 31, a twenty-fifth connection electrode 65, a first power supply line 81, and a third plate 130.

In an exemplary implementation, the third plate 130 may be in a shape of a rectangle, corners of the rectangle may be provided with chamfers or grooves, the third plate 130 is connected with the twenty-second connection electrode 62 through the forty-second via V42 on the one hand, and is connected with the second plate 120 through the forty-fifth via V45 on the other hand, and the third plate 130 may serve as one plate of the second capacitor. Since the twenty-second connection electrode 62 has the potential of the second node N2, the second plate 120 and the third plate 130 have the potential of the second node N2.

In an exemplary implementation, the orthographic projection of the second plate 120 on the silicon substrate is at least partially overlapped with the orthographic projection of the first plate 110 on the silicon substrate, and the first plate 110 having the potential of the first node N1 and the second plate 120 having the potential of the second node N2 form the first capacitor C1 of the pixel driving circuit.

In the exemplary implementation, since the fourteenth connection electrode 54 as a compensation electrode has the potential of the second node N2, the first plate 110 having the potential of the first node N1 and the fourteenth connection electrode 54 having the potential of the second node N2 form a parasitic capacitor, and the parasitic capacitor is connected in parallel with the first capacitor C1, which effectively increases a capacity of the first capacitor C1 and is beneficial to reducing the Flicker phenomenon.

In the exemplary implementation, the first power supply line 81 may be in a shape of a straight line or a polyline extending in the first direction X, may be disposed on a side of the third plate 130 away from the fourth transistor T4, and may be connected with the twenty-first connection electrode 61 through the forty-first via V41. Since the twenty-first connection electrode 61 is connected with the electrode connection block 52-5 through a via, the electrode connection block 52-5 is connected with the twelfth connection electrode 52 through the electrode connection strip 52-4, the twelfth connection electrode 52 is connected with the second connection electrode 42 through this via, and the second connection electrode 42 is connected with the second source region through a via, it is realized that the first power supply line 81 writes the first power supply signal to the first electrode of the second transistor T2.

In the exemplary implementation, since the twelfth connection electrode 52 is also connected with the shielding electrode 50 through a via, a connection between the shielding electrode 50 and the first power supply line 81 is realized, and the shielding electrode 50 has the potential of the first power supply line.

In an exemplary implementation, in the first direction X, a shielding spacing PL between shielding electrodes 50 in adjacent sub-pixels may be less than 2 * the width of the first power supply line. The width of the first power supply line may be an average width of the first power supply line 81, and is a dimension in the second direction Y.

In an exemplary implementation, in at least one sub-pixel, an orthographic projection of the power supply line 81 on the silicon substrate is at least partially overlapped with an orthographic projection of the first center line O1 on the silicon substrate, and two adjacent pixel rows may share a same power supply line 81.

In an exemplary implementation, the first scan signal line 31 may be in a shape of a straight line in which a main body portion extends in the first direction X, may be located between the first power supply line 81 and the third plate 130, and the first scan signal line 31 may be connected with the twenty-third connection electrode 63 through the forty-third via V43. Since the twenty-third connection electrode 63 is connected with the fifteenth connection electrode 55 through a via, the fifteenth connection electrode 55 is connected with the seventh connection electrode 47 through a via, the seventh connection electrode 47 is connected with the first gate connection block 21-1 through a via, and the first gate connection block 21-1 is connected with the first gate electrode 21, it is achieved that a connection between the first scan signal line 31 and a gate electrode of a first transistor T1 in each sub-pixel, and the first scan signal line 31 can control the turn-on or turn-off of the first transistor T1.

In an exemplary implementation, a first power supply line 81 may be disposed between two first scan signal lines 31 of two adjacent pixel rows, and the first power supply line 81 having a constant potential may be shielded at a constant potential to prevent crosstalk between a shifted first scan signal in one pixel row and an unshifted first scan signal in the other pixel row, improve the accuracy of data signal writing, and improve the display accuracy.

In an exemplary implementation, the twenty-fifth connection electrode 65 may be in a shape of a block (e.g., a rectangle), the twenty-fifth connection electrode 65 is connected with the twenty-fourth connection electrode 64 through the forty-fourth via V44, and the twenty-fifth connection electrode 65 is configured to be connected with an anode connection electrode formed subsequently.

In an exemplary implementation, the pattern of the fourth conductive layer may further include a third connection line 93 and a fourth connection line 94.

In an exemplary implementation, the third connection line 93 may be in a shape of a straight line or a polyline in which a main body portion extends in the first direction X, may be disposed between two fourth gate electrodes 24 of some of adjacent pixel rows, and an orthographic projection of the third connection line 93 on the silicon substrate is at least partially overlapped with an orthographic projection of a first center line O1 on the silicon substrate, and is continuously disposed in the first direction X.

In an exemplary implementation, the fourth connection line 94 may be in a shape of a straight line or a polyline extending in the second direction Y. In the first direction X, the fourth connection line 94 may be disposed between two third plates 130 of adjacent sub-pixels. In the second direction Y, the fourth connection line 94 may be disposed on a side of the first scan signal line 31 close to the third connection line 93, and an orthographic projection of the fourth connection line 94 on the silicon substrate is at least partially overlapped with an orthographic projection of a second center line O2 on the silicon substrate.

In an exemplary implementation, in at least one pixel column, fourth connection lines 94 of some adjacent sub-pixels may be of an interconnected integral structure, and fourth connection lines 94 in some adjacent sub-pixels may be spaced apart by first scan signal lines 31. For example, fourth connection lines 94 in the M-th pixel row and fourth connection lines 94 in the (M+1)-th pixel row may be of an interconnected integral structure. For another example, fourth connection lines 94 in the (M-1)-th pixel row and the M-th pixel row may be spaced apart by a first scan signal line 31, and fourth connection lines 94 in the (M+1)-th pixel row and the (M+2)-th pixel row may be spaced apart by a first scan signal line 31.

In an exemplary implementation, in at least one pixel row, a plurality of fourth connection lines 94 are connected with a third connection line 93. Since the third connection line 93 and the fourth connection lines 94 are configured to be connected with the first power supply line, the third connection line 93 extending in the first direction X and the fourth connection lines 94 extending in the second direction Y form a first layer of mesh-like interconnect structure for transmitting the first power supply signal on the display substrate, which can not only effectively reduce a resistance of the first power supply line and reduce a voltage drop of the first power supply signal, but also effectively improve uniformity of the first power supply signal in the display substrate, effectively improve uniformity of display, and improve display performance and display quality.

In the exemplary implementation, since the third connection lines 93 are disposed between adjacent pixel rows and the fourth connection lines 94 are disposed between adjacent pixel columns, the third connection lines 93 and the fourth connection lines 94 having constant potentials can not only effectively shield pixel driving circuits in sub-pixels and improve the output stability of the pixel driving circuits, but also effectively reduce mutual interference between the pixel driving circuits in the sub-pixels and effectively improve the uniformity and stability of the output current or voltage of the pixel driving circuits.

In an exemplary implementation, in at least one sub-pixel, a third connection line 93 and a fourth connection line 94 may be of an interconnected integral structure.

In an exemplary implementation, in at least one pixel row, a third connection line 93 and a plurality of fourth connection lines 94 may be of an interconnected integral structure.

In an exemplary implementation, an orthographic projection of the fourth connection line 94 on the silicon substrate is at least partially overlapped with an orthographic projection of the data signal line 70 on the silicon substrate, and the fourth connection line 94 having a constant potential can shield an influence of a jump voltage in the data signal line 70 on a key node in the pixel driving circuit.

In an exemplary implementation, in a direction perpendicular to the silicon substrate, the second connection lines 92 and the fourth connection lines 94 are disposed below and above the data signal lines 70, respectively, which can shield an influence of an jump voltage in the data signal lines 70 on key nodes in the pixel driving circuits from up and down directions.

In an exemplary implementation, patterns of fourth conductive layers of adjacent pixel rows may be mirror-symmetrical with respect to a first center line O1. For example, first scan signal lines 31, twenty-fifth connection electrodes 65, third connection lines 93, fourth connection lines 94 and third plates 130 in the M-th pixel row and the (M+1)-th pixel row may be mirror-symmetrical with respect to a first center line O1.

In an exemplary implementation, positions and shapes of first scan signal lines 31, twenty-fifth connection electrodes 65, first power supply lines 81, third connection lines 93, fourth connection lines 94 and third plates 130 of adjacent pixel columns may be substantially the same.

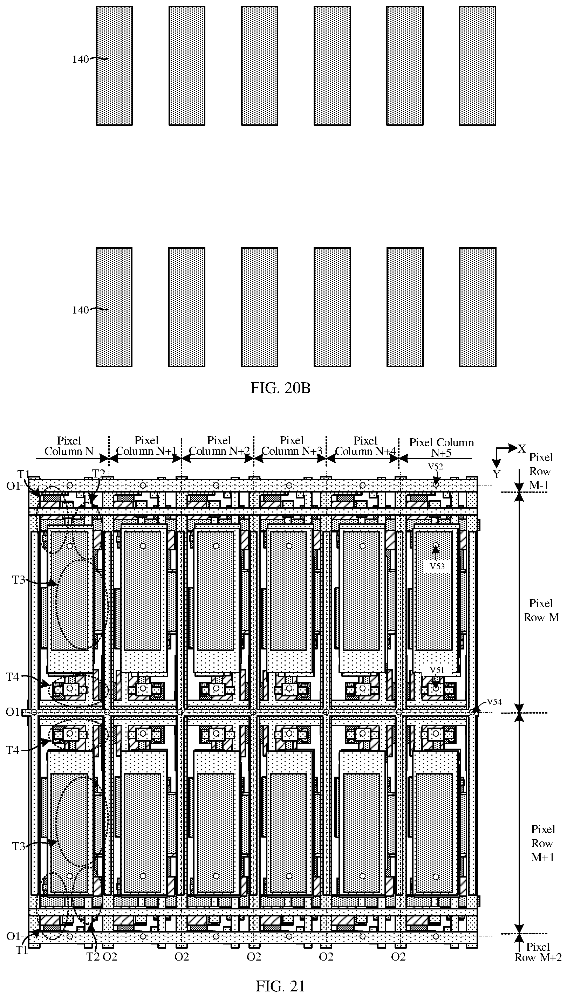

(14) A seventh insulation layer and a pattern of a sixth conductive layer are formed. In an exemplary embodiment, forming the seventh insulation layer and the pattern of the sixth conductive layer may include: depositing in sequence a seventh insulation film and a sixth conductive thin film on the silicon substrate on which the aforementioned patterns are formed, and patterning the sixth conductive thin film through a patterning process, to form the seventh insulation layer covering the pattern of the fifth conductive layer, and the pattern of the sixth conductive layer disposed on the seventh insulation layer, as shown in FIGs. 20A and 20B. FIG. 20B is a schematic diagram of the sixth conductive layer in FIG. 20A. In an exemplary implementation, the sixth conductive layer may be referred to as a top layer plate (CTOP) layer.

In an exemplary implementation, a pattern of a sixth conductive layer in each sub-pixel may at least include a fourth plate 140.

In an exemplary implementation, the fourth plate 140 may be in a shape of a rectangle, corners of the rectangle may be provided with chamfers or grooves. An orthographic projection of the fourth plate 140 on the silicon substrate is at least partially overlapped with an orthographic projection of the third plate 130 on the silicon substrate, and the fourth plate 140 may serve as another plate of the second capacitor.

In the exemplary implementation, orthographic projections of the first plate 110, the second plate 120, the third plate 130, and the fourth plate 140 on the silicon substrate do not overlap with the orthographic projection of the data signal line 70 on the silicon substrate, which can reduce the parasitic capacitor between the data signal line and each plate, can avoid the corresponding electrode in the pixel driving circuit from affecting the data voltage of the data signal line, improve the anti-interference ability of the data signal line, and maximize the display quality.

In an exemplary implementation, fourth plates 140 of adjacent pixel rows may be mirror-symmetrical with respect to a first center line O1, and positions and shapes of the fourth plates 140 of adjacent pixel columns may be substantially the same.

(15) A pattern of an eighth insulation layer is formed. In an exemplary implementation, forming the pattern of the eighth insulation layer may include: depositing an eighth insulation thin film on the silicon substrate on which the aforementioned patterns are formed, and patterning the eighth insulation thin film through a patterning process to form the eighth insulation layer covering the pattern of the sixth conductive layer; wherein a plurality of vias are disposed in the eighth insulation layer, as shown in FIG. 21.

In an exemplary implementation, the plurality of vias in each sub-pixel may include a fifty-first via V51, a fifty-second via V52, a fifty-third via V53, and a fifty-fourth via V54.

In an exemplary implementation, an orthographic projection of the fifty-first via V51 on the silicon substrate is within the range of an orthographic projection of the twenty-fifth connection electrode 65 on the silicon substrate. The seventh insulation layer and the eighth insulation layer within the fifty-first via V51 are etched away to expose a surface of the twenty-fifth connection electrode 65. The fifty-first via V51 is configured such that an anode connection electrode formed subsequently is connected with the twenty-fifth connection electrode 65 through this via.

In an exemplary implementation, an orthographic projection of the fifty-second via V52 on the silicon substrate is within the range of the orthographic projection of the first power supply line 81 on the silicon substrate. The seventh insulation layer and the eighth insulation layer within the fifty-second via V52 are etched away to expose a surface of the first power supply line 81. The fifty-second via V52 is configured such that a fifth connection line formed subsequently is connected with the first power supply line 81 through this via.

In an exemplary implementation, an orthographic projection of the fifty-third via V53 on the silicon substrate is within a range of an orthographic projection of the fourth plate 140 on the silicon substrate. The eighth insulation layer within the fifty-third via V53 is etched away to expose a surface of the fourth plate 140, and the fifty-third via V53 is configured such that a seventh connection line formed subsequently is connected with the fourth plate 140 through this via.

In an exemplary implementation, an orthographic projection of the fifty-fourth via V54 on the silicon substrate is within a range of the orthographic projection of the third connection line 93 on the silicon substrate. The eighth insulation layer and the seventh insulation layer within the fifty-fourth via V54 are etched away to expose a surface of the third connection line 93, and the fifty-fourth via V54 is configured such that a sixth connection line formed subsequently is connected with the third connection line 93 through this via.

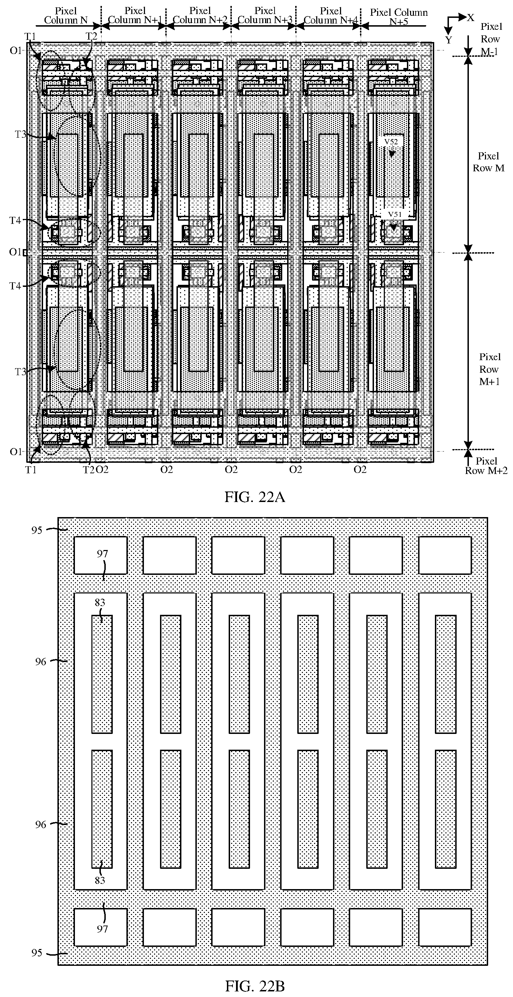

(16) A pattern of a seventh conductive layer is formed. In an exemplary implementation, forming the pattern of the seventh conductive layer may include: depositing a seventh conductive thin film on the silicon substrate on which the aforementioned patterns are formed, patterning the seventh conductive thin film through a patterning process to form the pattern of the seventh conductive layer on the eighth insulation layer, as shown in FIGs. 22A and 22B, FIG.22B is a schematic diagram of the seventh conductive layer in FIG. 22A. In an exemplary implementation, the seventh conductive layer may be referred to as a fifth metal (Metal5) layer or a second metal connection (TM2) layer.

In an exemplary implementation, a seventh conductive layer in each sub-pixel may at least include an anode connection electrode 83, a fifth connection line 95, a sixth connection line 96, and a seventh connection line 97.

In an exemplary implementation, the anode connection electrode 83 may be in a shape of a strip extending in the second direction Y, the anode connection electrode 83 is connected with the twenty-fifth connection electrode 65 through the fifty-first via V51, and the anode connection electrode 83 is configured to be connected with an anode formed subsequently. Since the twenty-fifth connection electrode 65 is connected with the twenty-fourth connection electrode 64 through a via, the twenty-fourth connection electrode 64 is connected with the sixteenth connection electrode 56 through a via, the sixteenth connection electrode 56 is connected with the fifth connection electrode 45 through a via, and the fifth connection electrode 45 is respectively connected with the third drain region and the fourth drain region through a via, the anode connection electrode 83 has the potential of the third node N3 of the pixel driving circuit, connections between an anode formed subsequently and the second electrode of the third transistor T3 and the second electrode of the fourth transistor T4 can be achieved, and the current output by the pixel driving circuit can be provided to the anode.

In an exemplary implementation, shape of the fifth connection line 95 may be in a shape of a straight line or a polyline in which a main body portion extends in the first direction X, may be disposed between two first scan signal lines 31 of two adjacent pixel rows, and the fifth connection line 95 is connected with the first power supply line 81 through the fifty-second via V52.

In an exemplary implementation, in at least one sub-pixel, an orthographic projection of the fifth connection line 95 on the silicon substrate is at least partially overlapped with the orthographic projection of the first center line O1 on the silicon substrate.

In an exemplary implementation, the sixth connection line 96 may be in a shape of a straight line in which a main body portion extends in the second direction Y, may be disposed between two third plates 130 of adjacent pixel columns, and may be directly connected with the fifth connection line 95 on the one hand, and connected with the third connection line 93 through the fifty-fourth via V54 on the other hand.

In an exemplary implementation, in at least one sub-pixel, an orthographic projection of the sixth connection line 96 on the silicon substrate is at least partially overlapped with an orthographic projection of a second center line O2 on the silicon substrate.

In an exemplary implementation, the seventh connection line 97 may be in a shape of a straight line or a polyline in which a main body portion extends in the first direction X, may be disposed between the fifth connection line 95 and the anode connection electrode 83, and may be directly connected with the sixth connection line 96 on the one hand, and connected with the fourth plate 140 through the fifty-third via V53 on the other hand.

In an exemplary implementation, in at least one pixel row, a plurality of sixth connection lines 96 are connected with the fifth connection line 95 and the seventh connection line 97, respectively. Since the fifth connection line 95 is connected with the first power supply line 81 through a via, the fifth connection line 95 extending in the first direction X and the sixth connection lines 96 extending in the second direction Y form a second layer of mesh-like interconnect structure for transmitting the first power supply signal on the display substrate, and the seventh connection line 97 extending in the first direction X and the sixth connection lines 96 extending in the second direction Y form another second layer of mesh-like interconnect structure for transmitting the first power supply signal on the display substrate, which can not only effectively reduce the resistance of the first power supply line and reduce the voltage drop of the first power supply signal, but also improve the uniformity of the first power supply signal in the display substrate, improve the display uniformity, and improve the display performance and display quality.

In an exemplary implementation, an orthographic projection of the fifth connection line 95 on the silicon substrate is at least partially overlapped with the orthographic projection of the first power supply line 81 on the silicon substrate, forming two layers of transverse power supply lines for transmitting the first power supply signal, and the two layers of transverse power supply lines can further reduce the resistance of the first power supply line, further reduce the voltage drop of the first power supply signal, further improve the uniformity of the first power supply signal in the display substrate, further improve the display uniformity, and further improve the display performance and display quality.

In an exemplary implementation, an orthographic projection of the sixth connection line 96 on the silicon substrate is at least partially overlapped with the orthographic projection of the fourth connection line 94 on the silicon substrate, forming two layers of vertical power lines for transmitting the first power supply signal, which can further reduce the resistance of the first power supply line, further reduce the voltage drop of the first power supply signal, further improve the uniformity of the first power supply signal in the display substrate, further improve the display uniformity, and further improve the display performance and display quality.

In an exemplary implementation, in at least one sub-pixel, the fifth power supply connection line 95, the sixth connection line 96, and the seventh connection line 97 may be of an interconnected integral structure.

In an exemplary implementation, in at least one pixel row, one fifth connection line 95, one sixth connection line 96, and a plurality of seventh connection lines 97 may be of an interconnected integral structure.

In an exemplary implementation, two fifth connection lines 95, two seventh connection lines 97, and a plurality of sixth connection lines 96 of adjacent pixel rows may be of an interconnected integral structure.

In the exemplary implementation, since the seventh connection line 97 is connected with the first power supply line 81, the fourth plate 140 has the potential of the first power supply line. Thus, the third plate 130 having the potential of the second node N2 and the fourth plate 140 having the potential of the first power supply line form the second capacitor C2 of the pixel driving circuit.

In an exemplary implementation, patterns of eighth conductive layers of adjacent pixel rows may be mirror-symmetrical with respect to a first center line O1. For example, anode connection electrodes 83, fifth connection lines 95 to seventh connection lines 97 in the M-th pixel row and the (M+1)-th pixel row may be mirror-symmetrical with respect to a first center line O1.

In an exemplary implementation, positions and shapes of anode connection electrodes 83 of adjacent pixel columns may be substantially the same.

In an exemplary implementation, fifth connection lines 95 to seventh connection lines 97 of adjacent pixel columns may be mirror-symmetrical with respect to a second center line O2.

In an exemplary implementation, the subsequent manufacturing processes may include: forming an anode, a pixel definition layer, an organic light emitting layer, a cathode, a first encapsulation layer, a color filter structure layer and a second encapsulation layer, etc., the details thereof will not be repeated herein.

In an exemplary implementation, the first insulation layer to the eighth insulation layer may be made of silicon oxide (SiOx), silicon nitride (SiNx) or silicon oxynitride (SiON), or the like, and may be single-layer structures or multi-layer composite structures. The first metal layer to the fifth metal layer may be made of a metal material, such as Argentum (Ag), Copper (Cu), Aluminum (Al), or Molybdenum (Mo), or may be made of an alloy material formed by metals, such as Aluminum Neodymium (AlNd) alloy or Molybdenum Niobium (MoNb) alloy, and the alloy material may be a single-layer structure or may be a multi-layer composite structure, such as a composite structure formed by an Mo layer, a Cu layer, and an Mo layer. In an exemplary implementation, a plane shape of a via may be a rectangle, a circle, or an ellipse. Sizes of a plurality of vias may be the same or different, which is not limited here in the present disclosure.

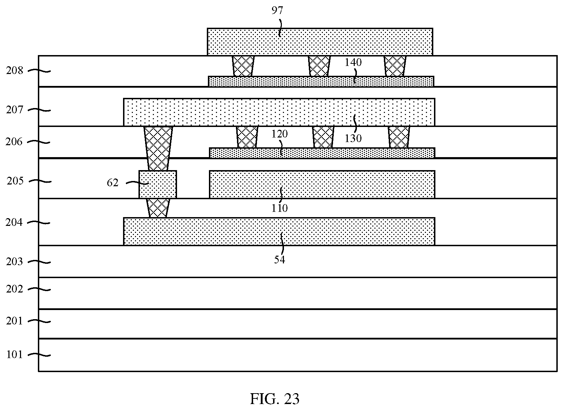

FIG. 23 is a schematic diagram of structures of a first capacitor and a second capacitor in an exemplary embodiment of the present disclosure. As shown in FIG. 23, the first capacitor and the second capacitor are stacked, and the second capacitor is disposed on a side of the first capacitor away from the silicon substrate. The first capacitor may include a first plate 110 and a second plate 120 that are stacked, and the second capacitor may include a third plate 130 and a fourth plate 140 that are stacked.

In an exemplary implementation, the display substrate may at least include a silicon substrate 101, a first insulation layer 201 disposed on the silicon substrate 101, a second insulation layer 202 disposed on a side of the first insulation layer 201 away from the silicon substrate 101, a third insulation layer 203 disposed on a side of the second insulation layer 202 away from the silicon substrate 101, a second conductive layer (Metal2) disposed on a side of the third insulation layer 203 away from the silicon substrate 101, a fourth insulation layer 204 disposed on a side of the second conductive layer away from the silicon substrate 101, a third conductive layer (Metal3) disposed on a side of the fourth insulation layer 204 away from the silicon substrate 101, a fifth insulation layer 205 disposed on a side of the third conductive layer away from the silicon substrate 101, a fourth conductive layer (MIM) disposed on a side of the fifth insulation layer 205 away from the silicon substrate 101, a sixth insulation layer 206 disposed on a side of the fourth conductive layer away from the silicon substrate 101, a fifth conductive layer (Metal4) disposed on a side of the sixth insulation layer 206 away from the silicon substrate 101, a seventh insulation layer 207 disposed on a side of the fifth conductive layer away from the silicon substrate 101, a sixth conductive layer (CTOP) disposed on a side of the seventh insulation layer 207 away from the silicon substrate 101, an eighth insulation layer 208 disposed on a side of the sixth conductive layer away from the silicon substrate 101, and a seventh conductive layer (TM2) disposed on a side of the eighth insulation layer 208 away from the silicon substrate 101.

In an exemplary implementation, the second conductive layer may include at least a fourteenth connection electrode 54 as a compensation electrode, the third conductive layer may include at least a first plate 110, the fourth conductive layer may include at least a second plate 120 (MIM), the fifth conductive layer may include at least a third plate 130, the sixth conductive layer may include at least a fourth plate 140 (CTOP), and the seventh conductive layer may include at least a seventh connection line 97.

In an exemplary implementation, the first plate 110 has a potential of a first node N1, the third plate 130 is connected with the second plate 120 through vias on the one hand, and with the fourteenth connection electrode 54 through a twenty-second connection electrode 62 on the other hand, so that the fourteenth connection electrode 54, the second plate 120, and the third plate 130 have a same potential of a second node N2. Since the fourth plate 140 is connected with the seventh connection line 97 through vias, the fourth plate 140 has a potential of the first power supply line. In this way, the first plate 110 having the potential of the first node N1 and the third plate 120 having the potential of the second node N2 form a first capacitor C1 of the pixel driving circuit, and the third plate 130 having the potential of the second node N2 and the fourth plate 140 having the potential of the first power supply line form the second capacitor C2 of the pixel driving circuit.

In an exemplary implementation, the first plate 110 having the potential of the first node N1 and the fourteenth connection electrode 54 having the potential of the second node N2 also form a parasitic capacitor, and the parasitic capacitor is connected in parallel with the first capacitor C1, effectively increasing a capacity of the first capacitor C1.

In an exemplary implementation, since both the first capacitor and the second capacitor have a plate capacitor structure, only one insulation layer is disposed between the first plate 110 and the second plate 120, and only one insulation layer is disposed between the third plate 130 and the fourth plate 140, therefore capacities of the first capacitor and the second capacitor can be effectively ensured, and the arrangement of the pixel driving circuit can be made more compact under the premise of meeting the design requirements, which helps to improve the resolution of the display device.

In an exemplary implementation, the capacities of the first capacitor and the second capacitor may be further increased by increasing a quantity of conductive layers or decreasing thicknesses of insulation layers, and the present disclosure is not limited herein.

An exemplary embodiment of the present disclosure provides a display substrate, in which, by disposing a shielding electrode connected with a first power supply line, the shielding electrode covering a gate electrode of a third transistor T3, the gate electrode of the third transistor T3 can be effectively shielded, the interference of signal traces and electrodes on the third transistor T3 can be effectively eliminated, the operation stability of the third transistor T3 can be improved, the uniformity and stability of the output current or voltage of the pixel driving circuit can be effectively improved, and the display performance and the display quality can be improved.

By disposing the first capacitor and the second capacitor having a plate capacitor structure, and stacking the first capacitor and the second capacitor, the present disclosure not only can solve the problem of limited area of the capacitor, but also can superimpose the parasitic capacitor generated by the stacked structure on the capacitor itself, which reduces the influence of the parasitic capacitor, and can be beneficial to gain of the capacitor value of the capacitor, ensuring the stability and uniformity of the output current of the pixel driving circuit, and can make the arrangement of the pixel driving circuit more compact under the premise of meeting the design requirements, and is beneficial to improving the resolution of the display device.

In the present disclosure, by providing a compensation electrode, the compensation electrode and the first plate form a parasitic capacitor, and the parasitic capacitor is connected in parallel with the first capacitor, the capacity of the first capacitor is effectively increased, and the flicker phenomenon is reduced.

In the present disclosure, by disposing a first power supply connection electrode between the first node electrode and the second node electrode, the first power supply connection electrode having a constant potential can form a constant potential shield, which can effectively eliminate crosstalk between the gate electrode and the first electrode of the third transistor T3, improve uniformity and stability of the output current or voltage of the pixel driving circuit, and improve display performance and display quality.

In the present disclosure, by disposing a spacing between the second power supply connection electrode and the data signal line, a short circuit between the data signal line and the first power supply line can be avoided, and a vertical line defect caused by the short circuit can be avoided.

In the present disclosure, by disposing the first power supply line between two first scan signal lines of two adjacent pixel rows, the first power supply line having a constant potential can be shielded at a constant potential, which can prevent crosstalk between the shifted first scan signal in one pixel row and the unshifted first scan signal in the other pixel row, improve the accuracy of data signal writing, and improve the display accuracy.

In the present disclosure, by disposing a shielding structure surrounding the fourth transistor T4 in three directions, and the shielding structure having the potential of the second power supply line, the fourth transistor T4 and the third node N3 in the sub-pixel can be effectively shielded, the mutual interference between the adjacent fourth transistor T4 and the third node N3 can be effectively reduced, the reset performance and operation stability of the fourth transistor T4 can be improved, and the uniformity and stability of the output current or voltage of the pixel driving circuit can be improved.

In the present disclosure, by disposing the first connection line and the second connection line to form a mesh-like interconnect structure on the display substrate for transmitting the second power supply signal, not only a resistance of the second power supply line can be effectively improved, a voltage drop of the second power supply signal can be reduced, but also the uniformity of the second power supply signal in the display substrate can be effectively improved, the uniformity of display can be effectively improved, and the display performance and the display quality can be improved.

In the present disclosure, a third connection line and a fourth connection line are disposed to form a first layer of mesh-like interconnect structure for transmitting a first power supply signal, a fifth connection line, a sixth connection line and a seventh connection line form a second layer of mesh-like interconnect structure for transmitting the first power supply signal, and the second layer of mesh-like interconnect structure is connected with the first layer of mesh-like interconnect structure, thereby maximally reducing the resistance of the first power supply line, maximally reducing the voltage drop of the first power supply signal, maximally improving the uniformity of the first power supply signal in the display substrate, improving the display uniformity, maximally improving the display performance and the display quality, and being beneficial to improving the low gray scale display effect.

In the present disclosure, pixel driving circuits of adjacent pixel rows are disposed to be mirrored with respect to a first center line, improving the uniformity and the symmetry of the pixel driving circuits, which not only can achieve the uniformity design for the process and coupling capacitor, but also can achieve current distribution uniformity design, effectively improving display stability and uniformity, and effectively improving display performance and display quality.

In the present disclosure, first transistors T1 of adjacent pixel rows are mirrored and share first electrodes of the first transistors T1, and fourth transistors T4 of adjacent pixel columns are mirrored and share first electrodes of the fourth transistors T4, the horizontal wiring space and the longitudinal wiring space can be effectively reduced, the quantity of vias can be reduced, and the occupied area of the pixel driving circuit can be reduced, which is beneficial to achieving high resolution.

In the present disclosure, the same type of transistors are disposed to share the same type of substrate region, such that the layout space used in the substrate region can be effectively reduced, and the occupied area of the pixel driving circuit can be reduced, which is beneficial to achieving high resolution.

In the present disclosure, by disposing the second connection line and the fourth connection line below and above the data signal line, respectively, the second connection line and the fourth connection line having constant potentials can shield the influence of the jump voltage in the data signal line on key nodes of the pixel driving circuit from the upper and lower directions. In the present disclosure, the data signal line is not overlapped with a plurality of plates, which can reduce parasitic capacitors between the data signal line and the plates, can prevent corresponding electrodes in the pixel driving circuit from affecting data voltage of the data signal line, improve the anti-interference ability of the data signal line, and maximally improve the display performance.

In the present disclosure, the quantity of metal layers, the trace position and the trace spacing are adjusted, which improves the tolerance to process fluctuations and particles, reduces the occurrence ratio of line and point defects, and improves the product yield. Through the layout of the pixel driving circuit, the resistance and voltage drop of the power supply trace are significantly reduced, the performance of the circuit is significantly improved, and the uniformity of display brightness is improved. By adding shielding traces, crosstalk on key nodes of the pixel driving circuit is significantly reduced, signal crosstalk is reduced, and display stability is improved. By optimizing the layout space, the occupied area of the pixel driving circuit is effectively reduced. The display substrate according to the present disclosure can satisfy the display with a resolution greater than or equal to 3800 PPI and a refresh frequency of 60 Hz to 120 Hz. The stability and smoothness of the display picture are better, which can effectively reduce the dizziness in VR applications and "screen window effect" in AR applications, effectively increase the immersion feeling, and effectively improve the user experience.

Based on a 0.11 µm integrated circuit manufacturing process, the manufacturing process in the present disclosure may be compatible well with an existing manufacturing process, process implementation is simple and easy to implement, and has a high production efficiency, a low production cost and a high yield rate.

In an exemplary implementation, the display substrate according to the present disclosure may be applied to a display device with a pixel driving circuit, such as a Micro OLED micro display, an OLED display, a quantum dot display (QLED), a light emitting diode micro display (Micro LED or Mini LED), a quantum dot light emitting diode micro display (QDLED), which is not limited here in the present disclosure.

In an exemplary embodiment, the applicable product types of the pixel driving circuit of the display substrate according to the present disclosure include, but are not limited to, substrate materials such as integrated silicon substrates, glass substrates, printed circuit board (PCB) substrates, etc., amorphous silicon (a-Si), low temperature polysilicon (LTPS), low temperature polycrystalline oxide (LTPO), oxide semiconductor materials, a typical example of which is Indium Gallium Zinc Oxide (IGZO), and thin film transistors (TFT), metal oxide semiconductors (MOS), diodes (diode), and other devices with a back channel etching structure (BCE), etching barrier layer structure (ESL), top gate structure (Top Gate), dual gate structure(Dual Gate), etc.

A structure of the display device and the manufacturing process thereof according to exemplary embodiments of the present disclosure are described by way of example only. Corresponding structures may be changed and patterning processes may be added or reduced according to actual needs, the present disclosure is not limited thereto.

An exemplary embodiment of the present disclosure further provides a method for manufacturing a display substrate for manufacturing the aforementioned display substrate. In an exemplary embodiment, the display substrate includes a plurality of sub-pixels forming a plurality of pixel rows and a plurality of pixel columns; the preparation method may include:
forming a pixel driving circuit in at least one sub-pixel, the pixel driving circuit including at least a first transistor, a second transistor, a third transistor, and a fourth transistor, wherein a first electrode of the first transistor is coupled to a data signal line, a second electrode of the first transistor is coupled to a gate electrode of the third transistor, a first electrode of the second transistor is coupled to a first power supply line, a second electrode of the second transistor is coupled to a first electrode of the third transistor, a first electrode of the fourth transistor is coupled to a second power supply line, a second electrode of the fourth transistor is coupled to a second electrode of the third transistor, the first power supply line is configured to provide a first power supply signal to the pixel driving circuit, and the second power supply line is configured to provide a second power supply signal to the pixel driving circuit; the at least one sub-pixel further includes a shielding electrode connected with the first power supply line, an orthographic projection of the shielding electrode on a plane of the display substrate is at least partially overlapped with an orthographic projection of the gate electrode of the third transistor on the plane of the display substrate.

An exemplary embodiment of the present disclosure also provides a display device, which includes the aforementioned display substrate. The display device according to the present disclosure may be used for virtual reality devices, augmented display devices, extended reality devices, mixed reality devices, sights, rangefinders, and the like, and may also be used for products or components including, but not limited to, mobile phones, tablets, televisions, displays, laptops, digital frames, navigators, or any products or components with display functions.

Although embodiments disclosed in the present disclosure are as above, it should be noted that the above embodiments are exemplary only rather than restrictive. Therefore, the present disclosure is not limited to what is specifically shown and described here. Various modifications, substitutions, or omissions may be made in forms and details of implementations without departing from the scope of the present disclosure.

## Claims

1. A display substrate comprising a plurality of sub-pixels forming a plurality of pixel rows and a plurality of pixel columns, at least one sub-pixel comprising a pixel driving circuit and the pixel driving circuit comprising at least a first transistor, a second transistor, a third transistor, and a fourth transistor, wherein
a first electrode of the first transistor is coupled to a data signal line, a second electrode of the first transistor is coupled to a gate electrode of the third transistor, a first electrode of the second transistor is coupled to a first power supply line, a second electrode of the second transistor is coupled to a first electrode of the third transistor, a first electrode of the fourth transistor is coupled to a second power supply line, a second electrode of the fourth transistor is coupled to a second electrode of the third transistor, the first power supply line is configured to provide a first power supply signal to the pixel driving circuit, and the second power supply line is configured to provide a second power supply signal to the pixel driving circuit; and
the at least one sub-pixel further comprises a shielding electrode connected with the first power supply line, an orthographic projection of the shielding electrode on a plane of the display substrate is at least partially overlapped with an orthographic projection of the gate electrode of the third transistor on the plane of the display substrate.

2. The display substrate according to claim 1, wherein
an overlapping area between the orthographic projection of the shielding electrode on the plane of the display substrate and the orthographic projection of the gate electrode of the third transistor on the plane of the display substrate defines a first area,
the orthographic projection of the gate electrode of the third transistor on the plane of the display substrate defines a second area, and
a ratio of the first area to the second area is greater than or equal to 0.8.

3. The display substrate according to claim 1, wherein
in a pixel row direction, there is a shielding spacing between two adjacent shielding electrodes, and
the shielding spacing is less than twice a width of the first power supply line, or the shielding spacing is less than twice a width of the second power supply line.

4. The display substrate according to claim 1, wherein
the first transistor comprises at least a first source region and a first drain region, the second transistor comprises at least a second source region and a second drain region, the third transistor comprises at least a third source region and a third drain region, and the fourth transistor comprises at least a fourth source region and a fourth drain region;
the first drain region is connected with the gate electrode of the third transistor through a first node electrode, the second drain region is connected with the third source region and is connected with a second node electrode through a via, and the third drain region is connected with the fourth drain region through a third node electrode; and
in a direction perpendicular to the display substrate, the display substrate comprises a plurality of conductive layers, and the first node electrode, the second node electrode, the third node electrode, and the shielding electrode are disposed in a same conductive layer.

5. The display substrate according to claim 1, wherein
the at least one sub-pixel further comprises a first power supply connection electrode, and the shielding electrode is connected with the first power supply line through the first power supply connection electrode; and
the first power supply connection electrode is disposed between the first node electrode and the second node electrode in a pixel row direction.

6. The display substrate according to claim 5, wherein
the first power supply connection electrode comprises at least a lateral electrode extending in the pixel row direction, and a first vertical electrode and a second vertical electrode extending in a pixel column direction respectively disposed on two sides of the lateral electrode in the pixel column direction, wherein one terminal of the first vertical electrode is connected with the first power supply line, another terminal of the first vertical electrode is connected with the lateral electrode, one terminal of the second vertical electrode is connected with the shielding electrode, and another terminal of the second vertical electrode is connected with the lateral electrode; and
the second vertical electrode is disposed between the first node electrode and the second node electrode in the pixel row direction.

7. The display substrate according to claim 6, wherein
the at least one sub-pixel further comprises a second power supply connection electrode disposed in a same layer as the data signal line, the first power supply line is connected with the second power supply connection electrode through a via, and the second power supply connection electrode is connected with the first power supply connection electrode through a via; and
in the pixel row direction, a spacing between a second power supply connection electrode in a current sub-pixel and a data signal line in an adjacent sub-pixel is greater than or equal to a width of the data signal line.

8. The display substrate according to claim 7, wherein
the at least one sub-pixel further comprises a data connection strip, a first terminal of the data connection strip is connected with the data signal line, and a second terminal of the data connection strip extends in a direction toward the second power supply connection electrode and then is connected with the first electrode of the second transistor;
in the pixel row direction, a spacing between a second power supply connection electrode in the current sub-pixel and a data connection strip in the current sub-pixel is greater than or equal to a width of the data signal line.

9. The display substrate according to claim 7, wherein
in a direction perpendicular to the display substrate, the display substrate comprises at least a first metal layer disposed on a silicon substrate, a second metal layer disposed on a side of the first metal layer away from the silicon substrate, and a third metal layer disposed on a side of the second metal layer away from the silicon substrate;
the first node electrode, the second node electrode, the third node electrode, and the shielding electrode are disposed in the first metal layer, the first power supply connection electrode is disposed in the second metal layer, and the data signal line and the second power supply connection electrode are disposed in the third metal layer.

10. The display substrate according to claim 9, wherein
the second power supply line is disposed in the first metal layer,
the second metal layer further comprises second connection lines,
the second power supply line is in a shape of a straight line or a polyline extending in the pixel row direction and continuously disposed in the pixel row direction,
the second connection lines are in a shape of a straight line or a polyline extending in a pixel column direction and discontinuously disposed in the pixel column direction, and
the second connection lines are connected with the second power supply line to form a mesh-like interconnect structure for transmitting a second power supply signal.

11. The display substrate according to claim 10, wherein
the gate electrode of the fourth transistor is coupled to a third scan signal line, and the third scan signal line is in a shape of a straight line or a polyline extending in the pixel row direction; and
in the pixel column direction, the second connection lines are spaced apart by the third scan signal line.

12. The display substrate according to claim 10, wherein
the at least one sub-pixel further comprises a power supply connection portion disposed on a same layer as the second power supply line,
the power supply connection portion is in a shape of a strip extending in the pixel row direction,
a first terminal of the power supply connection portion is connected with the second power supply line, and
a second terminal of the power supply connection portion extends in a direction away from the second power supply line and then is connected with the second connection line through a via.

13. The display substrate according to any one of claims 1 to 12, wherein the pixel driving circuit further comprises a first capacitor,
the first capacitor comprises at least a first plate and a second plate,
an orthographic projection of the second plate on the plane of the display substrate is at least partially overlapped with an orthographic projection of the first plate on the plane of the display substrate,
the first plate is connected with the first node electrode, and
the second plate is connected with the second node electrode.

14. The display substrate according to claim 13, wherein
the at least one sub-pixel further comprises a compensation electrode,
the second plate is connected with the second node electrode through the compensation electrode,
an orthographic projection of the compensation electrode on the plane of the display substrate is at least partially overlapped with the orthographic projection of the first plate on the plane of the display substrate,
the compensation electrode and the first plate form a parasitic capacitor, and
the parasitic capacitor is connected in parallel with the first capacitor.

15. The display substrate according to claim 14, wherein
an overlapping area between the orthographic projection of the compensation electrode on the plane of the display substrate and the orthographic projection of the first plate on the plane of the display substrate defines a third area,
the orthographic projection of the first plate on the display substrate plane defines a fourth area, and
a ratio of the third area to the fourth area is greater than or equal to 0.5.

16. The display substrate according to claim 14, wherein
the at least one sub-pixel further comprises a second connection line and a thirteenth connection electrode disposed in a same layer as the compensation electrode, the second connection line is connected with the second power supply line and disposed between two adjacent compensation electrodes in a pixel row direction, and the thirteenth connection electrode is connected with the first node electrode through a via;
there is a first distance between the compensation electrode and the second connection line, there is a second distance between the compensation electrode and the thirteenth connection electrode, the first distance is less than the second distance, the first distance is a dimension in the pixel row direction, and the second distance is a dimension in a pixel column direction.

17. The display substrate according to claim 16, wherein
the at least one sub-pixel further comprises a sixteenth connection electrode disposed in the same layer as the compensation electrode, and the sixteenth connection electrode is connected with the third node electrode through a via; and
there is a third distance between the compensation electrode and the sixteenth connection electrode, the first distance is less than the third distance, and the third distance is a dimension in the pixel column direction.

18. The display substrate according to claim 16, wherein
the at least one sub-pixel further comprises a first power supply connection electrode and a thirteenth connection electrode disposed in the same layer as the compensation electrode, the shielding electrode is connected with the first power supply line through the first power supply connection electrode, and the thirteenth connection electrode is connected with the first node electrode through a via; and
there is a fourth distance between the first power supply connection electrode and the thirteenth connection electrode, the second distance is greater than the fourth distance, and the fourth distance is a dimension in the pixel row direction.

19. The display substrate according to claim 16, wherein
the at least one sub-pixel further comprises a first power supply connection electrode and an eleventh connection electrode disposed in the same layer as the compensation electrode, the shielding electrode is connected with the first power supply line through the first power supply connection electrode, and the eleventh connection electrode is configured to be connected with the data signal line; and
there is a fifth distance between the first power supply connection electrode and the second connection line, there is a sixth distance between the first power supply connection electrode and the eleventh connection electrode, the fifth distance is less than the sixth distance, and the fifth distance and the sixth distance are dimensions in the pixel row direction.

20. The display substrate according to claim 14, wherein
in a direction perpendicular to the display substrate, the display substrate comprises at least a first metal layer disposed on a silicon substrate, a second metal layer disposed on a side of the first metal layer away from the silicon substrate, and a third metal layer disposed on a side of the second metal layer away from the silicon substrate; and
the first node electrode and the second node electrode are disposed in the first metal layer, the compensation electrode is disposed in the second metal layer, and the first plate is disposed in the third metal layer.

21. The display substrate according to any one of claims 1 to 12, wherein the gate electrode of the first transistor is coupled to a first scan signal line, and the first scan signal line and the first power supply line are in a shape of a straight line or a polyline extending in a pixel row direction; and
the first power supply line is disposed between two adjacent first scan signal lines in a pixel column direction.

22. A display device, comprising the display substrate according to any one of claims 1 to 21.

23. A manufacturing method for a display substrate, wherein
the display substrate comprises a plurality of sub-pixels forming a plurality of pixel rows and a plurality of pixel columns;
the manufacturing method comprises: forming a pixel driving circuit in at least one sub-pixel, wherein the pixel driving circuit comprises at least a first transistor, a second transistor, a third transistor, and a fourth transistor, a first electrode of the first transistor is coupled to a data signal line, a second electrode of the first transistor is coupled to a gate electrode of the third transistor, a first electrode of the second transistor is coupled to a first power supply line, a second electrode of the second transistor is coupled to a first electrode of the third transistor, a first electrode of the fourth transistor is coupled to a second power supply line, a second electrode of the fourth transistor is coupled to a second electrode of the third transistor, the first power supply line is configured to provide a first power supply signal to the pixel driving circuit, and the second power supply line is configured to provide a second power supply signal to the pixel driving circuit; and
the at least one sub-pixel further comprises a shielding electrode connected with the first power supply line, and an orthographic projection of the shielding electrode on a plane of the display substrate is at least partially overlapped with an orthographic projection of the gate electrode of the third transistor on the plane of the display substrate.
